# EUROPEAN PATENT SPECIFICATION

(11) **EP 2 435 500 B1**
(45) Date of publication and mention of the grant of the patent: **30.10.2019**
(21) Application number: 10719362.5
(22) Date of filing: 18.05.2010
(51) Int. Cl.: C08G 73/00, C08G 61/00, C08G 61/12, C09K 11/00, C09K 11/06, H01L 51/00, H05B 33/00, H05B 33/14

(54) **DIKETOPYRROLOPYRROLE POLYMERS FOR USE IN ORGANIC SEMICONDUCTOR DEVICES**
DIKETOPYRROLOPYRROL-POLYMERE ZUR VERWENDUNG IN ORGANISCHEN HALBLEITERBAUELEMENTEN
POLYMÈRES DE DICÉTOPYRROLOPYRROLE POUR UNE UTILISATION DANS DES DISPOSITIFS SEMI-CONDUCTEURS ORGANIQUES

(30) Priority: 27.05.2009 EP 09161243; 21.08.2009 EP 09168352
(43) Date of publication of application: 04.04.2012
(73) Proprietor: BASF SE, 67056 Ludwigshafen am Rhein (DE)
(72) Inventor: DÜGGELI, Mathias, CH-4441 Thürnen (CH); AEBISCHER, Olivier, Frédéric, CH-3186 Düdingen (CH); HAYOZ, Pascal, CH-4114 Hofstetten (CH); FONRODONA TURON, Marta, E-17300 Blanes (ES); TURBIEZ, Mathieu, G., R., F-68170 Rixheim (FR); FLORES, Jean-Charles, F-68100 Mulhouse (FR); KIRNER, Hans, Jürg, CH-4056 Basel (CH); MURER, Peter, CH-4104 Oberwil (CH); CHEBOTAREVA, Natalia, F-68220 Hagenthal le Bas (FR); SCHÄFER, Thomas, CH-4410 Liestal (CH)
(74) Representative: BASF IP Association
(86) International application number: PCT/EP2010/056778
(87) International publication number: WO 2010/136353

(56) References cited:
- EP-A- 1 078 970
- WO-A-2005/049695
- WO-A-2008/000664
- WO-A-2009/047104
- US-B1- 6 451 459
- BEYERLEIN T ET AL: "New photoluminescent conjugated polymers with 1,4-dioxo-3,6-diphenylpyrrolo[3,4-c]pyrrol e (DPP) and 1,4-phenylene units in the main chain" MACROMOLECULAR: RAPID COMMUNICATIONS, WILEY VCH VERLAG, WEINHEIM, DE, vol. 21, no. 4, 1 January 2000 (2000-01-01), pages 182-189, XP002430211 ISSN: 1022-1336
- BEYERLEIN T ET AL: "Red electroluminescence from a 1,4-diketopyrrolo[3,4-c]pyrrole (DPP)-based conjugated polymer" SYNTHETIC METALS, ELSEVIER SEQUOIA, LAUSANNE, CH, vol. 130, no. 2, 1 January 2002 (2002-01-01), pages 115-119, XP002430210 ISSN: 0379-6779
- YU ZHU ET AL: "Red Emitting Diphenylpyrrolopyrrole (DPP)-Based Polymers Prepared by Stille and Heck Coupling" MACROMOLECULAR CHEMISTRY AND PHYSICS, WILEY-VCH VERLAG, WEINHEIM, DE, vol. 207, 1 January 2006 (2006-01-01), pages 2206-2214, XP002453223 ISSN: 1022-1352
- MARIO SMET, BERT METTEN, WIM DEHAEN: "Construction of rod-like diketopyrrolopyrrole oligomers with well-defined length" TETRAHEDRON LETTERS, vol. 42, no. 37, 10 September 2001 (2001-09-10), pages 6527-6530, XP002545094
- JUNWU CHEN AND YONG CAO: "Development of Novel Conjugated Donor Polymers for High-Efficiency Bulk-Heterojunction Photovoltaic Devices" ACC. CHEM. RES., vol. xx, 2 July 2009 (2009-07-02), pages 01-10, XP002545095 ASAP internet publication
- KAI ZHANG AND BERND TIEKE: "Highly Luminescent Polymers Containing the 2,3,5,6-Tetraarylated Pyrrolo[3,4-c]pyrrole-1,4-dione (N-Aryl DPP) Chromophore in the Main Chain" MACROMOLECULES, vol. 41, no. 20, 2 October 2008 (2008-10-02), pages 7287-7295, XP002545096
- ALEXANDER J.C. KUEHNE, ALLAN R. MACKINTOSH, R.A. PETHRICK, BERND TIEKE: "Novel vinyl ether functionalized fluorene polymers for active incorporation into common photoresist matrices" TETRAHEDRON LETTERS, vol. 49, no. 32, 2008, pages 4722-4724, XP002545097
- MARTIJN M. WIENK, MATHIEU TURBIEZ, JAN GILOT, RENÉ A. J. JANSSEN: "Narrow-Bandgap Diketo-Pyrrolo-Pyrrole Polymer Solar Cells: The Effect of Processing on the Performance" ADVANCED MATERIALS, vol. 20, no. 13, 2 July 2008 (2008-07-02), pages 2556-2560, XP002544287
- Y. ZHU, A. R. RABINDRANATH, T. BEYERLEIN, AND B. TIEKE: "Highly Luminescent 1,4-Diketo-3,6-diphenylpyrrolo[3,4-c]pyrro le- (DPP-) Based Conjugated Polymers Prepared Upon Suzuki Coupling" MACROMOLECULES, vol. 40, 22 August 2007 (2007-08-22), pages 6981-6989, XP002544288

## Description

The present invention relates to polymers comprising one or more (repeating) unit(s) of the formula 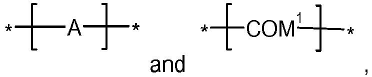 and their use as organic semiconductor in organic devices, especially in organic photovoltaics (solar cells) and photodiodes, or in a device containing a diode and/or an organic field effect transistor. The polymers according to the invention have excellent solubility in organic solvents and excellent film-forming properties. In addition, high efficiency of energy conversion, excellent field-effect mobility, good on/off current ratios and/or excellent stability can be observed, when the polymers according to the invention are used in organic field effect transistors, organic photovoltaics (solar cells) and photodiodes.

US-B-6451459 (EP1078970; cf. B. Tieke et al., Synth. Met. 130 (2002) 115-119; Macromol. Rapid Commun. 21 (4) (2000) 182-189) describes diketopyrrolopyrrole based polymers and copolymers comprising the following units 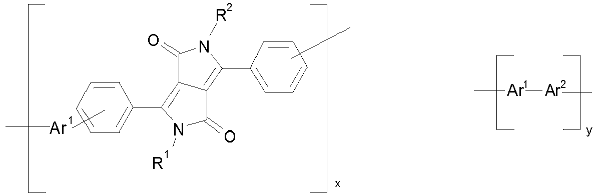 wherein x is chosen in the range of from 0.005 to 1, preferably from 0.01 to 1, and y from 0.995 to 0, preferably 0.99 to 0, and wherein x + y = 1, and
wherein Ar¹ and Ar² independently from each other stand for 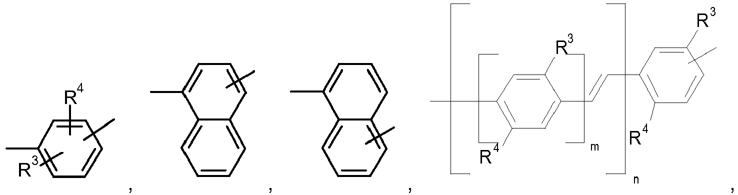 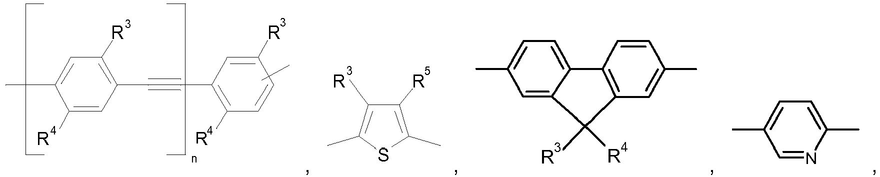 and m, n being numbers from 1 to 10, and
R¹ and R² independently from each other stand for H, C₁-C₁₈alkyl, -C(O)O-C₁-C₁₈alkyl, perfluoro-C₁-C₁₂alkyl, unsubstituted C₆-C₁₂aryl or one to three times with C₁-C₁₂alkyl, C₁-C₁₂alkoxy, or halogen substituted C₆-C₁₂aryl, C₁-C₁₂alkyl-C₆-C₁₂aryl, or C₆-C₁₂aryl-C₁-C₁₂alkyl,
R³ and R⁴ preferably stand for hydrogen, C₁-C₁₂alkyl, C₁-C₁₂alkoxy, unsubstituted C₆-C₁₂aryl or one to three times with C₁-C₁₂alkyl, C₁-C₁₂alkoxy, or halogen substituted C₆-C₁₂aryl or perfluoro-C₁-C₁₂alkyl, and R⁵ preferably stands for C₁-C₁₂alkyl, C₁-C₁₂alkoxy, unsubstituted C₆-C₁₂aryl or one to three times with C₁-C₁₂alkyl, C₁-C₁₂alkoxy, or halogen substituted C₆-C₁₂aryl, or perfluoro-C₁-C₁₂alkyl, and their use in EL devices. The following polymer 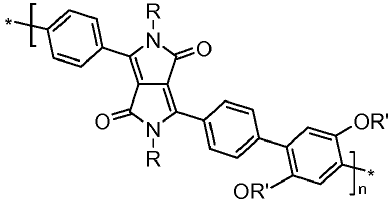 is explicitly disclosed in Tieke et al., Synth. Met. 130 (2002) 115-119. The following polymers 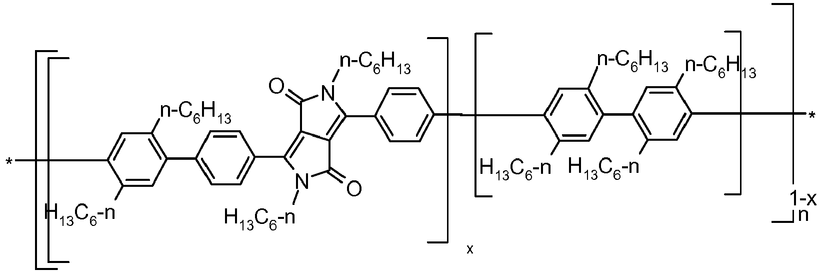 are explicitly disclosed in Macromol. Rapid Commun. 21 (4) (2000) 182-189.

M. Smet et al., Tetrahedron Lett. 42 (2001) 6527-6530 describe the preparation of rod-like diketopyrrolopyrrole oligomers by a stepwise sequence of Suzuki couplings using brominated 1,4-dioxo-3,6-diphenylpyrrolo[3,4-c]pyrrole (DPP) derivatives and 1,4-dibromo-2,5-din-hexylbenzene as the monomers.

Y. Zhu et al. Macromol. Chem. Phys. 2006, 207, 2206-2214 discloses six new soluble conjugated polymers which were prepared by Stille and Heck polycondensation reactions. They alternately consist of dialkylated 1,4-diketo-3,6-diphenyl-pyrrolo[3,4-c]pyrrole (DPP) units and divinylbenzene or thiophene-based units.

Y. Zhu et al., Macromolecules 40 (2007) 6981-6989 describes five new soluble conjugated polymers, which were prepared upon Suzuki polycondensation reactions. The polymers were prepared from 1,4-diketo-2,5-dihexyl-3,6-bis(4-bromophenyl)pyrrolo[3,4-*c*]pyrrole **(1a),** 1,4-diketo-2,5-di-(2-ethylhexyl)-3,6-bis(4-bromophenyl)pyrrolo[3,4-*c*]pyrrole **(1b),** or 1,4-diketo-2,5-dihexyl-3,6-bis(4-(4,4,5,5-tetramethyl-1,3,2-dioxaborolan-2-yl)phenyl)pyrrolo[3,4-*c*]pyrrole **(1c),** and 3,6-bis(4,4,5,5-tetramethyl-1,3,2-dioxaborolan-2-yl)-9-ethylhexylcarbazole **(2),** 4,4'-dibromotriphenylamine **(3),** 4,4'-bis(4,4,5,5-tetramethyl-1,3,2-dioxaborolan-2-yl)triphenylamine **(4),** 2,7-bis(4,4,5,5-tetramethyl-1,3,2-dioxaborolan-2-yl)-9,9-dihexylfluorene **(5),** 9,10-anthracenebispinacolatoboron ester **(6),** and 4,7-dibromo-2,1,3-benzothiadiazole (7). The polymers exhibit brilliant red colors. Polymer solutions are highly fluorescent with photoemission maxima between 552 and 600 nm.

A. Kuehne et al., Tetrahedron Letters 49 (2008) 4722-4724 discloses the synthesis of the following polymer 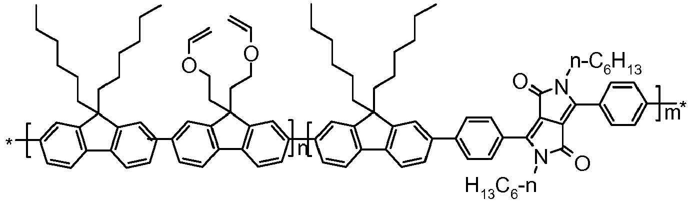 by Suzuki coupling. The vinyl ether functionality allows for active incorporation of the light emitting polymers into standard vinyl ether and glycidyl ether photoresist materials.

K. Zhang et al., Makcromolecules 41 (2008) 7287- 7295 describes the synthesis and characteristic properties of polymers P-1-P-3 containing the 2,3,5,6-tetraarylated pyrrolo[3,4-*c*]pyrrole-1,4-dione unit in the main chain. P-1 is prepared from 2,5-bis(4-*t*-butylphenyl)-3,6-bis(4'-bromophenyl)pyrrolo[3,4-*c*]pyrrole-1,4-dione (DPP1) and 9,9-di-*n*-hexylfluorene-2,7'-bispinacolatoboronester **3,** P-2 from 2,5-bis(4'-bromo-phenyl)-3,6-bis(4-*t*-butylphenyl)-pyrrolo[3,4-*c*]pyrrole-1,4-dione (DPP2) and **3,** and P-3 from DPP1, **3,** and 2,5-bis(*n-*hexyloxybenzene)-1,4-bispinacolatoboronester **4** via Pd-catalyzed Suzuki coupling. Molecularweights of the polymers are about 8000-10 000 Da.

WO05/049695 discloses diketopyrrolopyrrole (DPP) based polymers and their use in PLEDs, organic integrated circuits (O-ICs), organic field effect transistors (OFETs), organic thin film transistors (OTFTs), organic solar cells (O-SCs), or organic laser diodes, but fails to disclose the specific DPP based polymers of formula **I.**

A preferred polymer of WO05/049695 comprises a repeating unit of formula 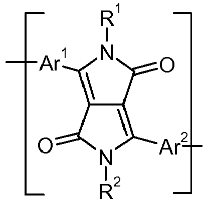 and a repeating unit 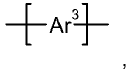 wherein
R¹ and R² are independently of each other a C₁-C₂₅alkyl group, especially a C₄-C₁₂alkyl group, which can be interrupted by one or more oxygen atoms, and Ar¹ and Ar² are independently of each other a group of formula 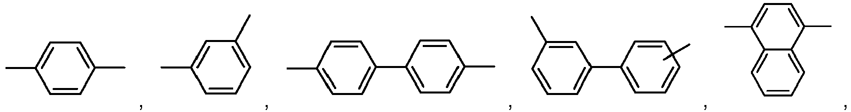 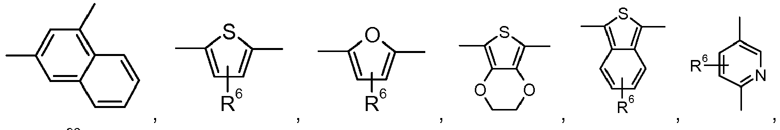 or 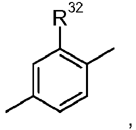 wherein -Ar³- is a group of formula 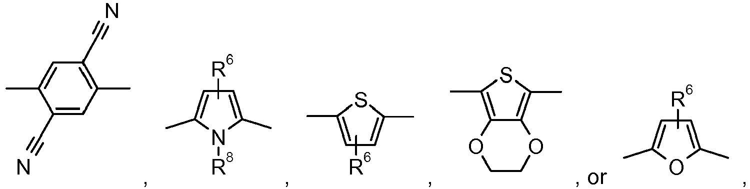 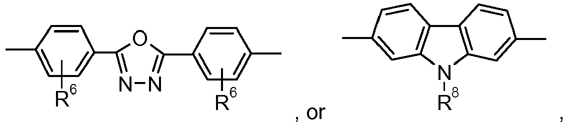 wherein
R⁶ is hydrogen, C₁-C₁₈alkyl, or C₁-C₁₈alkoxy, and R³² is methyl, CI, or OMe, and R⁸ is H, C₁-C₁₈alkyl, or C₁-C₁₈alkyl which is substituted by E and/or interrupted by D, especially C₁-C₁₈alkyl which is interrupted by -O-.

In another preferred embodiment WO05/049695 is directed to polymers comprising a repeating unit of formula 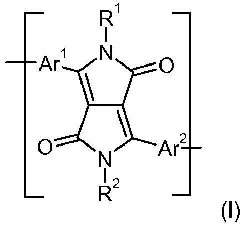 and a repeating unit 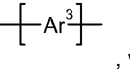 wherein R¹ and R² are independently of each other a C₁-C₂₅alkyl group, especially a C₄-C₁₂alkyl group, which can be interrupted by one or more oxygen atoms, and Ar¹ and Ar² are independently of each other a group of formula 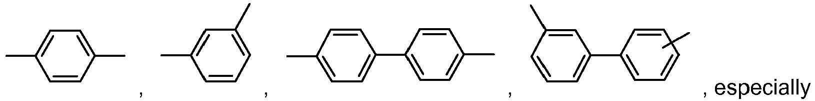 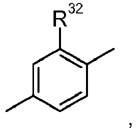 wherein R³² is methyl, Cl, or OMe, 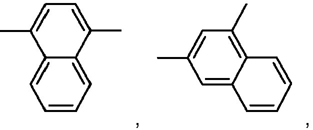 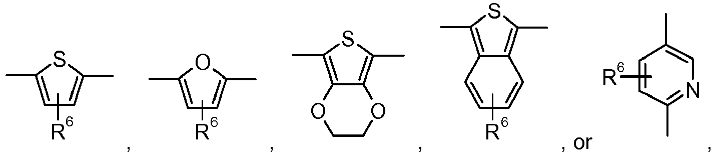 and -Ar³- is a group of formula 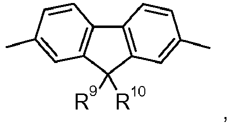 wherein R⁶ is hydrogen, C₁-C₁₈alkyl, or C₁-C₁₈alkoxy, R⁹ and R¹⁰ are independently of each other H, C₁-C₁₈alkyl, which can optionally be interrupted by O, or C₁-C₁₈alkoxy, which can optionally be interrupted by O,
R⁹ and R¹⁰ together form a group of formula =CR¹⁰⁰R¹⁰¹, wherein
R¹⁰⁰ and R¹⁰¹ are independently of each other H, C₁-C₁₈alkyl, or
R⁹ and R¹⁰ together form a five or six membered ring, which optionally can be substituted by C₁-C₁₈alkyl.

WO08/000664 describes polymers comprising (repeating) unit(s) of the formula 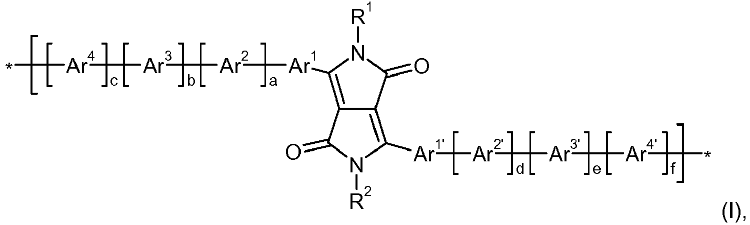 wherein a, b, c, d, e and f are 0 to 200, especially 0, 1, 2, or 3;
Ar¹ and Ar^{1'} are independently of each other a group of formula 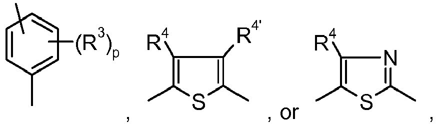 Ar², Ar^{2'}, Ar³, Ar^{3'}, Ar⁴ and Ar^{4'} are independently of each other a group of formula 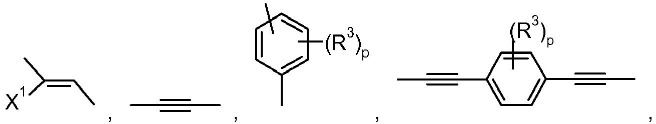 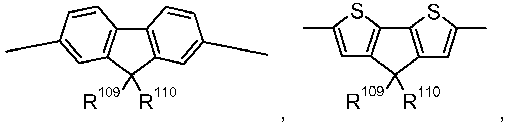 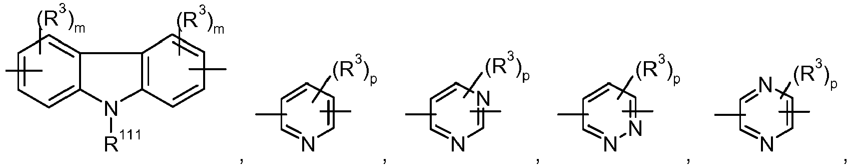 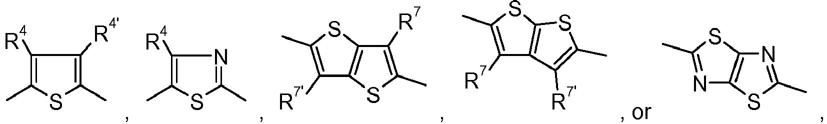 ...

In a preferred embodiment WO08/000664 is directed to polymers of formula 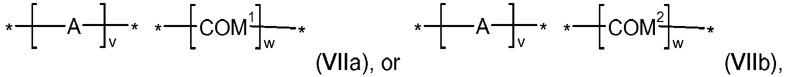 wherein A is as defined above and -COM¹- is selected from repeating units of formula: 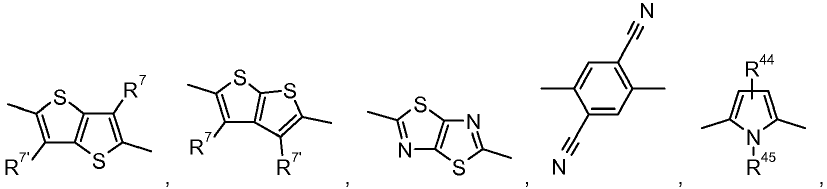 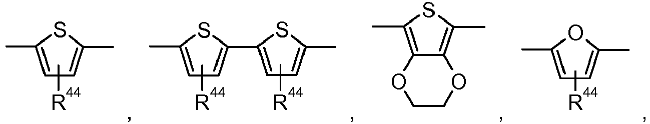 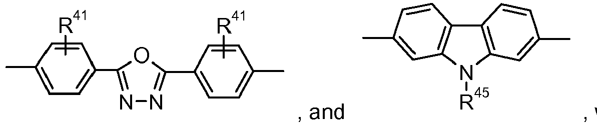 wherein R⁷ and R^{7'} are ...,
R⁴⁴ and R⁴¹ are hydrogen, C₁-C₁₈alkyl, or C₁-C₁₈alkoxy, and
R⁴⁵ is H, C₁-C₁₈alkyl, or C₁-C₁₈alkyl which is substituted by E and/or interrupted by D, especially C₁-C₁₈alkyl which is interrupted by -O-, wherein D and E are as defined above, and -COM²- is a group of formula 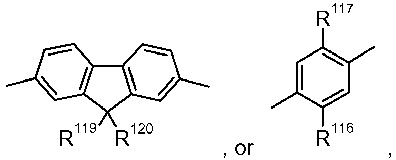 wherein
R¹¹⁶ and R¹¹⁷ are independently of each other H, C₁-C₁₈alkyl, which can optionally be interrupted by O, or C₁-C₁₈alkoxy, which can optionally be interrupted by O,
R¹¹⁹ and R¹²⁰ are independently of each other H, C₁-C₁₈alkyl, which can optionally be interrupted by O, or
R¹¹⁹ and R¹²⁰ together form a group of formula =CR¹⁰⁰R¹⁰¹, wherein
R¹⁰⁰ and R¹⁰¹ are independently of each other H, C₁-C₁₈alkyl, or
R¹¹⁹ and R¹²⁰ together form a five or six membered ring, which optionally can be substituted by C₁-C₁₈alkyl.

Martijn M. Wienk et al., Advanced Materials 20 (2008) 2556-2560 relates to narrow-bandgap diketo-pyrrolo-pyrrole polymer solar cells. Photovoltaic devices were made by coating the appropriate pBBTDPP2 : fullerene film on patterned indium-oxide-coated glass substrates covered with 60nm of poly(3,4-ethylenedioxythiophene) : poly(styrenesulfonate)(PEDOT: PSS). Lithium fluoride (1nm) and aluminum (100 nm) were used as metal electrode. 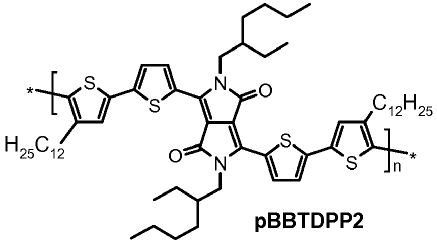 pBBTDPP2 is also mentioned in J. Chen et al., Accounts of Chemical Research xx (2009) 1-10 (doi: 10.21/ar90006lz; publication date: 2.07.2009).

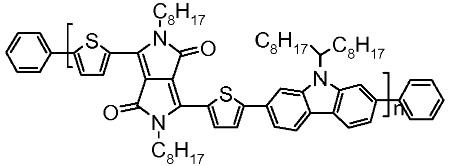

Mario Leclerc et al., Macromolecules, 42 (2009) 2891-2894 (online publication date: 26.03.2009; DOI: 10.1021/ma8027003) disclose a poly(2,7-carbazole) derivative (PCBTDPP), namely poly[*N*-9'-heptadecanyl-2,7-carbazole-alt-3,6-bis(thiophen-5-yl)-2,5-dioctyl-2,5-dihydropyrrolo[3,4-]pyrrole-1,4-dione]. The conjugated polymer exhibits a high hole mobility, optimized HOMO-LUMO energy levels together with good thermal and air stability.

E. Zhou et al., Macromolecules 43 (2010) 821-826 (Online publication date: 28.12.2009; DOI: 10.1021/ma902398q) discloses the synthesis of a highly effective photovoltaic polymer with near-infrared response, poly{N-[1-(2-ethylhexyl)-3-ethylheptanyl]-dithieno[3,2-b:2',3'-d]pyrrole-3,6-dithien-2-yl-2,5-dibutylpyrrolo[3,4-c]pyrrole-1,4-dione-5',5"-diyl} {PDTP-DTDPP(Bu)}. The polymer has high molecular weight, good solubility, and a broad absorption spectrum in the range of 500-1100 nm. Field effect transistor charge mobility of PDTP-DTDPP(Bu) arrived 0.05 cm² V⁻¹ s⁻¹. Bulk heterojunction type polymer solar cells based on PDTPDTDPP(Bu) and PC70BMhave broad photocurrent response wavelength range from 300 nm to 1.1 µm.

WO09/047104 relates to small molecule DPP compounds of the formula 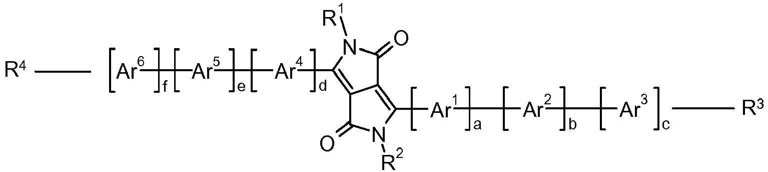 wherein ... Ar¹ and Ar⁴ are independently of each other a bivalent group of the formula 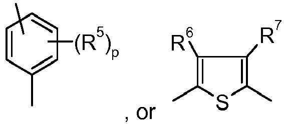 ... Ar², Ar³, Ar⁵, and Ar⁶ are independently of each other a bivalent group of one of the formulae IV to X and L,

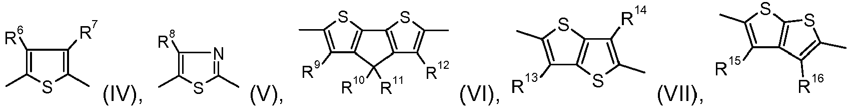

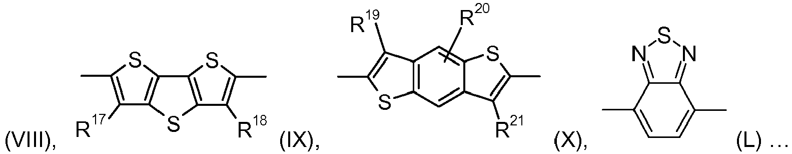

EP2034537A2 discloses polymers of formula 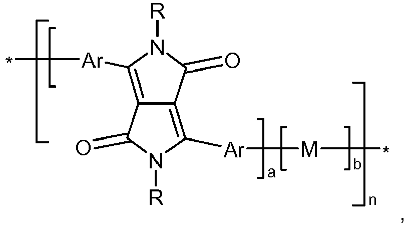 wherein each R is independently selected from hydrogen, an optionally substituted hydrocarbon, and a hetero-containing group; each Ar is independently selected from optionally substituted aryl and heteroaryl groups; each M is an optional, conjugated moiety; a represents a number that is at least 1; b represents a number from 0 to 20; and n represents a number that is at least 1. Among others M can be selected from 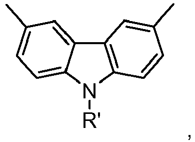 and 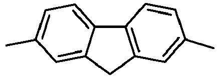 and substituted derivatives thereof.

PCT/EP2009/063767 discloses polymers comprising one or more (repeating) unit(s) of the formula 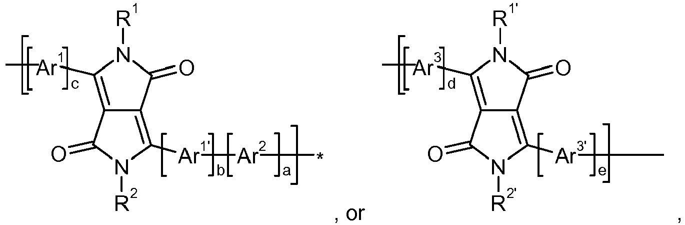 wherein
Ar¹, Ar^{1'}, Ar³ and Ar^{3'} are independently of each other a group of formula 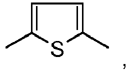 or 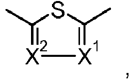 Ar² is a group of formula 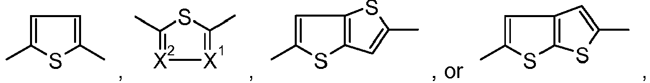 one of X¹ and X² is N and the other is CH,and their use as organic semiconductor in organic devices.

PCT/EP2009/063769 relates to polymers comprising one or more (repeating) unit(s) of the formula ⁅A-D⁆, and at least one (repeating) unit(s) which is selected from repeating units of the formula ⁅B-D⁆, ⁅A-E⁆, and ⁅B-E⁆,
a polymer comprising one or more (repeating) unit(s) of the formula 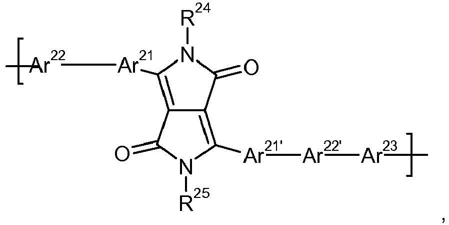 or a polymer comprising one or more (repeating) unit(s) of the formula 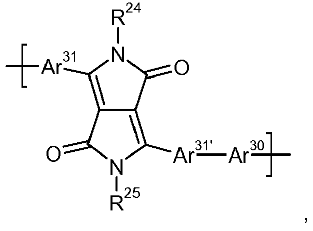 wherein
A is a group of formula 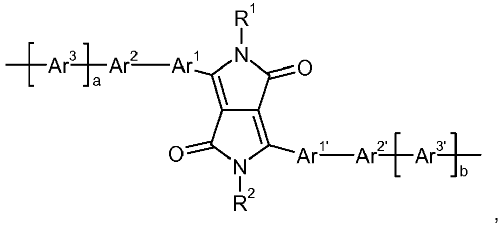 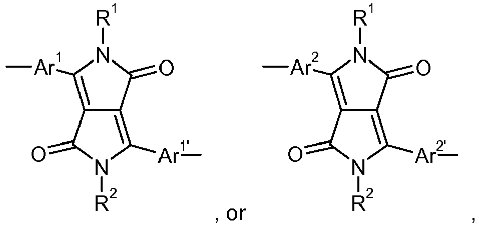 Ar²¹, Ar^{21'}, Ar³¹, Ar^{31'}, Ar¹ and Ar^{1'} are independently of each other a group of formula 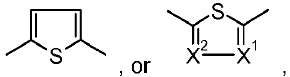 Ar², and Ar^{2'} are independently of each other a group of formula 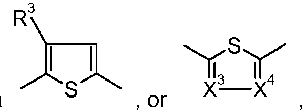 B, D and E are independently of each other a group of formula 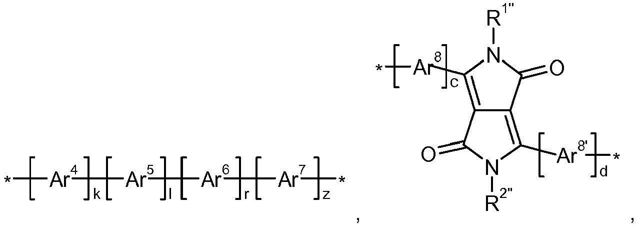 or formula 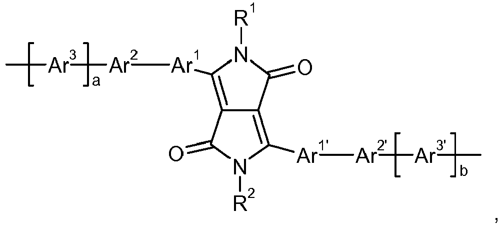 Ar⁸ and Ar^{8'} are independently of each other a group of formula 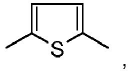 or

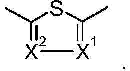

JP2007266285 relates to a field effect transistor comprising a compound represented by a formula 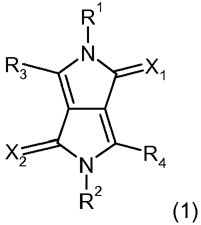 as a semiconductor material, wherein X¹ and X² each independently denote an oxygen atom, a sulfur atom, or a selenium atom, and R₁; R₂, R₃ and R₄ each independently denote a hydrogen atom, a substitutable aliphatic hydrocarbon group, or a substitutable aromatic group. The following DPP compound is explicitly disclosed:

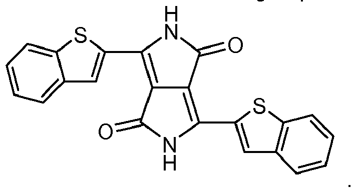

PCT/EP2010/053655 relates to polymers comprising one or more (repeating) unit(s) of the formula 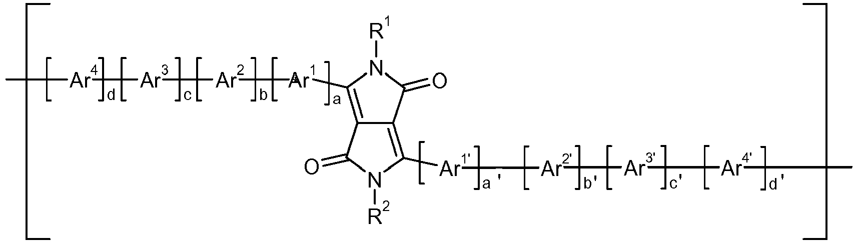 (I), wherein Ar¹ and Ar^{1'} are independently of each other are an annulated (aromatic) heterocyclic ring system, containing at least one thiophene ring, which may be optionally substituted by one, or more groups.

PCT/EP2010/054152 comprising a repeating unit of formula 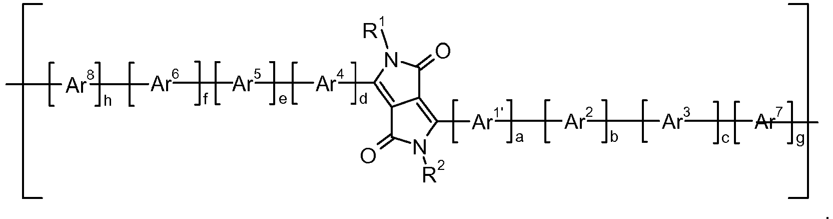 wherein Ar^{1'} is an annulated (aromatic) heterocyclic ring system, containing at least one thiazole ring, which may be optionally substituted by one, or more groups,

E. Zhou et al., Chem. Mater. 21 (2009) 4055-4061 (Online publication date: 05.08.2009; DOI:10.1021/cm901487f) discloses three kinds of diketopyrrolopyrrole-based donor-acceptor (D-A) type copolymers, poly{9,9-di(2-ethylhexyl)fluorene-2,7-diyl-*alt*-3,6-dithien-2-yl-2,5-di(2-ethylhexyl)-pyrrolo[3,4-c]pyrrole-1,4-dione-50,500-diyl} (PF-DTDPP), poly{N-(1-decylundecyl)carbazole-2,7-diyl-alt-3,6-dithien-2-yl-2,5-di(2-ethylhexyl)-pyrrolo[3,4-c]pyrrole-1,4-dione-5',5"-diyl} (PC-DTDPP), and poly{N-[1-(2-ethylhexyl)-3-ethylheptanyl]-dithieno[3,2-b:2',3'-d]pyrrole-3,6-dithien-2-yl-2,5-di(2-ethylhexyl)-pyrrolo[3,4-c]pyrrole-1,4-dione-5',5"-diyl} (PDTP-DTDPP). By changing the donor segments, the absorption ranges of DTDPP-containing copolymers can be tuned. PF-DTDPP and PC-DTDPP showed absorption bands in the range of 500-700 nm, while PDTP-DTDPP showed broad absorption in the range of 500-1000 nm in the solutions. The power conversion efficiencies (PCE) of the polymer solar cells (PSCs) based on these copolymers and [6,6]-phenyl C₆₁ butyric acid methyl ester (PCBM) were 0.88% (PF-DTDPP), 2.26% (PC-DTDPP), and 1.12% (PDTP-DTDPP), respectively, under the illumination of AM 1.5 (100 mW/cm²).

L. Huo et al., Macromolecules 2009, 42, 6564-6571 (Online publication date: 06.08.2009; DOI: 10.1021/ma9012972) discloses a series of low-bandgap polymers based on a soluble chromophore of 3,6-dithiophen-2-yl-2, 5-dihydropyrrolo[3,4-c]pyrrole-1,4-dione (DPP) unit and different electron-rich building blocks copolymerized with DPP unit. Four new DPP-based polymers, 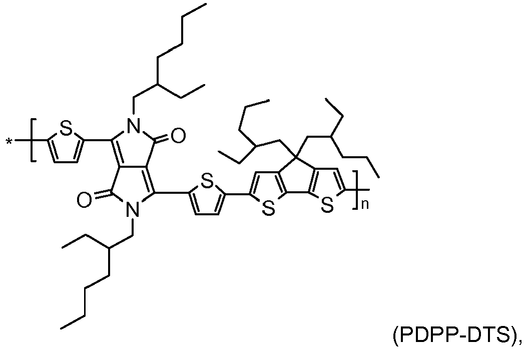 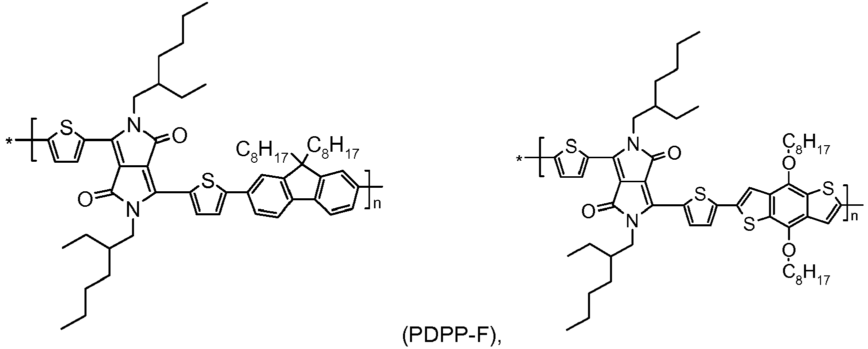 (PDPPBDT), and 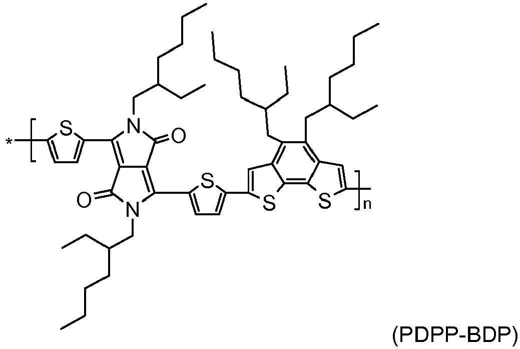 were synthesized.

In order to investigate their photovoltaic properties, polymer solar cell (PSC) devices based on PDPP-DTS, PDPP-F, PDPP-BDT, and PDPP-BDP were fabricated with a structure of ITO/PEDOT:PSS/ polymers:PC70BM(1:2,w/w)/Ca/Al under the illumination of AM 1.5G, 100 mW/cm².

N. Allard et al., Macromolecules 2010, 43, 2328-2333 (Online publication date: 28.01.2010; DOI: 10.1021/ma9025866) discloses the synthesis of poly[2,7-(9,9-di-n-octylgermafluorene)-alt-3,6-bis(thiophen-5-yl)-2,5-dioctylpyrrolo[3,4-]pyrrole-1,4-dione] and poly[2,7-(9,9-di-n-butylgerma-fluorene)-alt-3,6-bis(thiophen-5-yl)-2,5-dioctylpyrrolo[3,4-]pyrrole-1,4-dione], which shows a hole mobility up to 0.04 cm² (V 3 s)⁻¹ with an Iₒₙ/I_{off} ratio of 1.0x10⁶. G. Chen et al., Polymer Chemistry 48 (2010) 1669-1675 [DOI: 10.1002/pola.23931] discloses the synthesis of a narrow-bandgap conjugated polymer (PCTDPP) containing alternating cyclopentadithiophene (CT) and diketo-pyrrolo-pyrrole (DPP) units by Suzuki coupling.

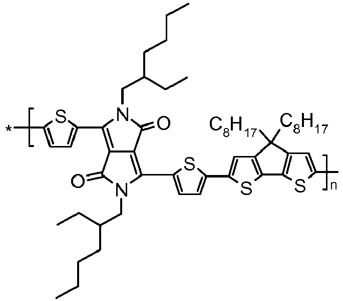

This PCTDPP exhibits a low band gap of 1.31 eV and a broad absorption band from 350 to 1000 nm. A bulk heterojunction polymer solar cell incorporating PCTDPP and C70 at a blend ratio of 1:3 exhibited a high short-circuit current of 10.87 mA/cm² and a power conversion efficiency of 2.27%.

It is the object of the present invention to provide polymers, which show high efficiency of energy conversion, excellent field-effect mobility, good on/off current ratios and/or excellent stability, when used in organic field effect transistors, organic photovoltaics (solar cells) and photodiodes.

Said object has been solved by polymers, comprising (repeating) unit(s) of the formula *-[-A-]-* 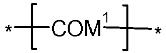 and optionally 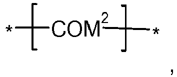 wherein A is a repeating unit of the formula 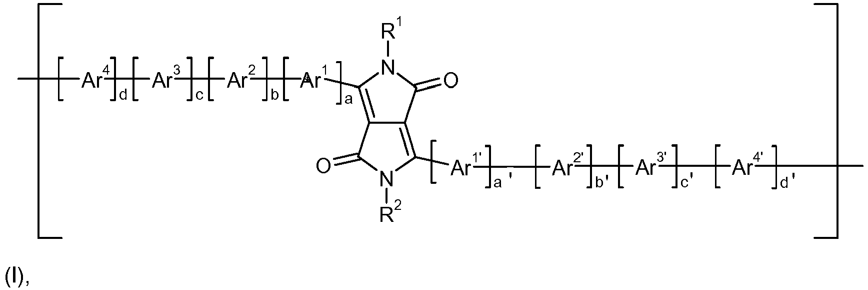 wherein a is 1, 2, or 3, a' is 0, 1, 2, or 3; b is 0, 1, 2, or 3; b' is 0, 1, 2, or 3; c is 0, 1, 2, or 3; c' is 0, 1, 2, or 3; d is 0, 1, 2, or 3; d' is 0, 1, 2, or 3; with the proviso that b' is not 0, if a' is 0; R¹ and R² may be the same or different and are selected from hydrogen, a C₁-C₁₀₀alkyl group, -COOR¹⁰³, a C₁-C₁₀₀alkyl group which is substituted by one or more halogen atoms, hydroxyl groups, nitro groups, -CN, or C₆-C₁₈aryl groups and/or interrupted by -O-, -COO-, -OCO-, or -S-; a C₇-C₁₀₀arylalkyl group, a carbamoyl group,C₅-C₁₂cycloalkyl, which can be substituted one to three times with C₁-C₈alkyl and/or C₁-C₈alkoxy, a C₆-C₂₄aryl group, in particular phenyl or 1- or 2-naphthyl which can be substituted one to three times with C₁-C₈alkyl, C₁-C₈thioalkoxy, and/or C₁-C₈alkoxy, or pentafluorophenyl,
Ar¹ and Ar^{1'} are independently of each other 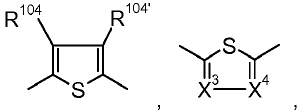 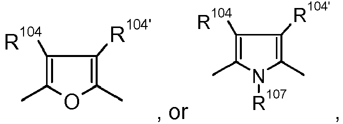 Ar², Ar^{2'}, Ar³, Ar^{3'}, Ar⁴ and Ar^{4'} have the meaning of Ar¹, or are independently of each other 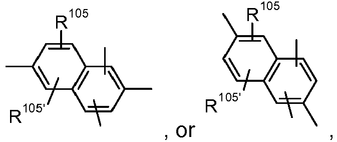 wherein
one of X³ and X⁴ is N and the other is CR⁹⁹,
R⁹⁹, R¹⁰⁴ and R^{104'} are independently of each other hydrogen, halogen, especially F, or a C₁-C₂₅alkyl group, especially a C₄-C₂₅alkyl, which may optionally be interrupted by one or more oxygen or sulphur atoms, C₇-C₂₅arylalkyl, or a C₁-C₂₅alkoxy group,
R¹⁰⁵ and R^{105'} independently of each other hydrogen, halogen, C₁-C₂₅alkyl, which may optionally be interrupted by one or more oxygen or sulphur atoms; C₇-C₂₅arylalkyl, or C₁-C₁₈alkoxy,
R¹⁰⁷ is H; C₆-C₁₈aryl; C₆-C₁₈aryl which is substituted by C₁-C₁₈alkyl, or C₁-C₁₃alkoxy; C₁-C₁₈alkyl; or C₁-C₁₈alkyl which is interrupted by -O-; and -COM¹- is a repeating unit of formula 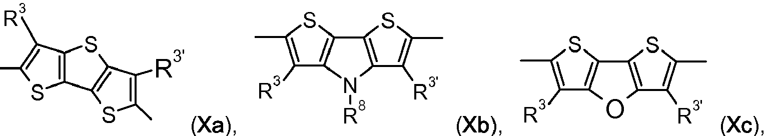 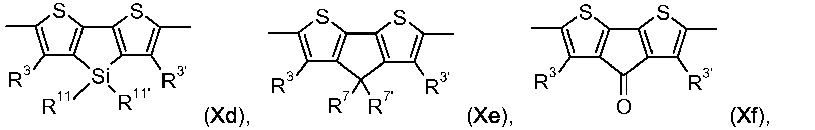 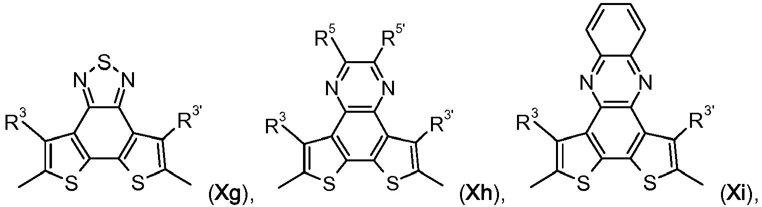 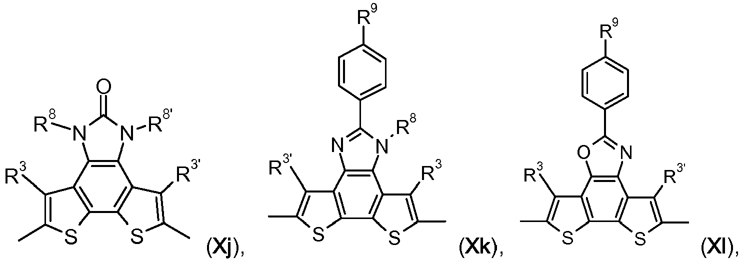 or 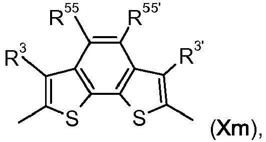 R⁹ is C₁-C₂₅alkyl, which may optionally be interrupted by one or more oxygen or sulphur atoms, C₁-C₂₅perfluoroalkyl, C₁-C₂₅alkoxy, or CN;
-COM²- is a second repeating unit -COM¹-, which is different from the first repeating unit - COM¹-, a second repeating unit -A-, which is different from the first repeating unit -A-, or a repeating unit of formula 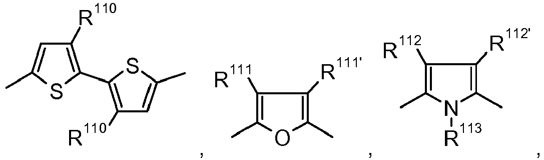 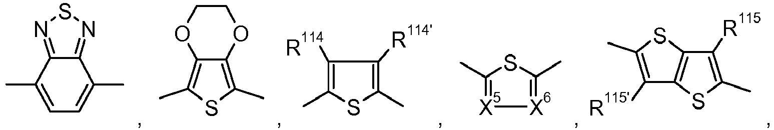 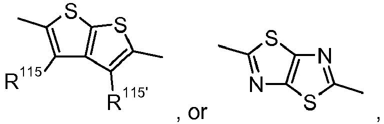 wherein one of X⁵ and X⁶ is N and the other is CR¹¹⁴,
R¹¹⁰ is a C₁-C₂₅alkyl group, especially a C₄-C₂₅alkyl, which may optionally be interrupted by one or more oxygen or sulphur atoms, C₇-C₂₅arylalkyl, or a C₁-C₂₅alkoxy group
R¹¹¹, R^{111'}, R¹¹² and R^{112'} are independently of each other hydrogen, halogen, especially F, or a C₁-C₂₅alkyl group, especially a C₄-C₂₅alkyl, which may optionally be interrupted by one or more oxygen or sulphur atoms, C₇-C₂₅arylalkyl, or a C₁-C₂₅alkoxy group,
R¹¹³ is C₆-C₁₈aryl; C₆-C₁₈aryl which is substituted by C₁-C₁₈alkyl, or C₁-C₁₈alkoxy; C₁-C₁₈alkyl; or C₁-C₁₈alkyl which is interrupted by -O-;
R¹¹⁴, R^{114'}, R¹¹⁵ and R^{115'} are independently of each other H, or a C₁-C₂₅alkyl group, especially a C₆-C₂₅alkyl, which may optionally be interrupted by one or more oxygen atoms;
R³ and R^{3'} are independently of each other hydrogen, halogen, C₁-C₂₅alkyl, which may optionally be interrupted by one or more oxygen or sulphur atoms; C₇-C₂₅arylalkyl, or C₁-C25alkoxy;
R⁵ and R^{5'} are independently of each other hydrogen, halogen, C₁-C₂₅alkyl, which may optionally be interrupted by one or more oxygen or sulphur atoms; C₆-C₂₄aryl, which may optionally be substituted one to three times with C₁-C₈alkyl and/or C₁-C₈alkoxy; C₇-C₂₅arylalkyl, CN, or C₁-C₂₅alkoxy; or
R⁵ and R^{5'} together form a ring,
R⁵⁵ and R^{55'} are independently of each other H, F, C₁-C₁₈alkyl, C₁-C₁₈alkyl which is interrupted by O, C₁-C₁₈alkoxy, C₁-C₁₈alkoxy which is interrupted by O, C₁-C₁₈perfluoroalkyl, C₆-C₂₄aryl, which may optionally be substituted one to three times with C₁-C₈alkyl and/or C₁-C₈alkoxy, C₂-C₂₀heteroaryl, which may optionally be substituted one to three times with C₁-C₈alkyl and/or C₁-C₈alkoxy;
R⁷ and R^{7'} are C₁-C₂₅alkyl,
R⁸ and R^{8'} are independently of each other hydrogen, C₆-C₁₈aryl; C₆-C₁₈aryl which is substituted by C₁-C₁₈alkyl, or C₁-C₁₃alkoxy; C₁-C₂₅alkyl, especially C₄-C₂₅alkyl, which may optionally be interrupted by one or more oxygen or sulphur atoms; or C₇-C₂₅arylalkyl,
R¹¹ and R^{11'} are independently of each other C₁-C₃₅alkyl group, C₇-C₂₅arylalkyl, or a phenyl group, which optionally can be substituted one to three times with C₁-C₈alkyl and/or C₁-C₈alkoxy, with the proviso that the following polymer 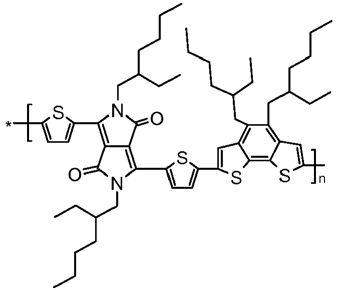 (Mₙ = 22.7 K; polydispersity = 2.1) is excluded.

Advantageously, the polymer of the present invention, or an organic semiconductor material, layer or component, comprising the polymer of the present invention can be used in organic photovoltaics (solar cells) and photodiodes, or in an organic field effect transistor (OFET).

The polymers of the present invention are copolymers. A copolymer is a polymer derived from more than one species of monomer, e.g. bipolymer, terpolymer, quaterpolymer, etc.

The term polymer comprises oligomers as well as polymers. The oligomers of this invention have a weight average molecular weight of < 4,000 Daltons. The polymers of this invention preferably have a weight average molecular weight of 4,000 Daltons or greater, especially 4,000 to 2,000,000 Daltons, more preferably 10,000 to 1,000,000 and most preferably 10,000 to 100,000 Daltons. Molecular weights are determined according to high-temperature gel permeation chromatography (HT-GPC) using polystyrene standards. The polymers of this invention preferably have a polydispersibility of 1.01 to 10, more preferably 1.1 to 3.0, most preferred 1.5 to 2.5.

R¹ and R² can be hydrogen, but are preferably different from hydrogen.
R¹ and R² can be different, but are preferably the same. Preferably, R¹ and R² independently from each other stand for C₁-C₁₀₀alkyl, C₅-C₁₂cycloalkyl, which can be substituted one to three times with C₁-C₈alkyl and/or C₁-C₈alkoxy, phenyl or 1- or 2-naphthyl which can be substituted one to three times with C₁-C₈alkyl and/or C₁-C₈alkoxy, or -CR¹⁰¹R¹⁰²-(CH₂)ᵤ-A³, wherein R¹⁰¹ and R¹⁰² stand for hydrogen, or C₁-C₄alkyl, A³ stands for phenyl or 1- or 2-naphthyl, which can be substituted one to three times with C₁-C₈alkyl and/or C₁-C₈alkoxy, and u stands for 0, 1, 2 or 3. R¹ and R² are more preferably a C₁-C₃₆alkyl group, such as methyl, ethyl, n-propyl, isopropyl, n-butyl, sec.-butyl, isobutyl, tert.-butyl, n-pentyl, 2-pentyl, 3-pentyl, 2,2-dimethylpropyl, 1,1,3,3-tetramethylpentyl, n-hexyl, 1-methylhexyl, 1,1,3,3,5,5-hexamethylhexyl, n-heptyl, isoheptyl, 1,1,3,3-tetramethylbutyl, 1-methylheptyl, 3-methylheptyl, n-octyl, 1,1,3,3-tetramethylbutyl and 2-ethylhexyl, n-nonyl, decyl, undecyl, especially n-dodecyl, tridecyl, tetradecyl, pentadecyl, hexadecyl, 2-ethyl-hexyl, 2-butyl-hexyl, 2-butyl-octyl, 2-hexyldecyl, 2-decyl-tetradecyl, heptadecyl, octadecyl, eicosyl, heneicosyl, docosyl, or tetracosyl. In a particularly preferred embodiment of the present invention R¹ and R² are a 2-hexyldecyl, or 2-decyl-tetradecyl group.

Advantageously, the groups R^{1'} and R^{2'} can be represented by formula 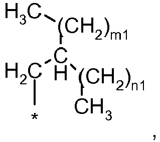 wherein m1 = n1 + 2 and m1 + n1 ≤ 24. Chiral side chains, such as R^{1'} and R^{2'}, can either be homochiral, or racemic, which can influence the morphology of the polymers.

As indicated by the formula 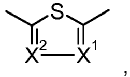 the group 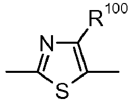 can be arranged in the polymer chain in two ways 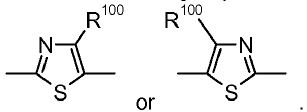 The notation 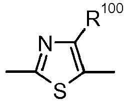 should comprise both possibilities. The same applies for other groups, which can be arranged in different ways in the monomer and/or polymers.

Ar¹ and Ar^{1'} are a group of formula

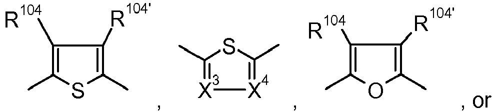

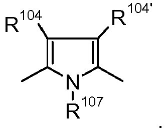

If -COM¹- is derived from a group of formula 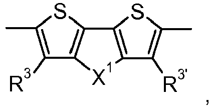 it is preferably a repeating unit of formula 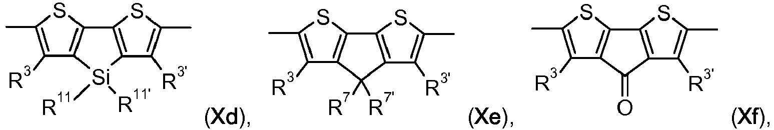 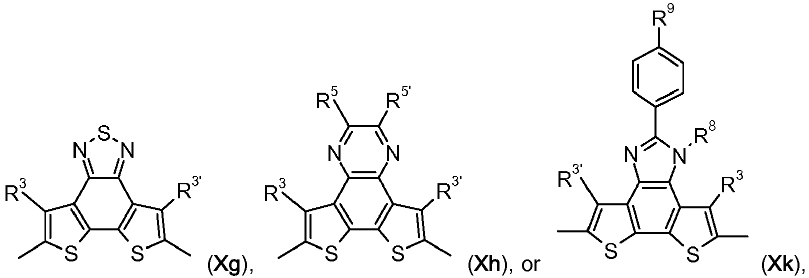 wherein R³, R^{3'}, R⁵, R^{5'}, R⁵⁵, R^{55'}, R⁷, R^{7'}, R⁸, R^{8'}, R¹¹ and R^{11'} are as defined above and R⁹ is C₁-C₂₅alkyl, which may optionally be interrupted by one or more oxygen or sulphur atoms, C₁-C₂₅perfluoroalkyl, C₁-C₂₅alkoxy, or CN. Groups of formula **Xd, Xe, Xh** and **Xk** are most preferred.

In a preferrred embodiment of the present invention -COM¹- is a group of formula **Xm,** wherein R³ and R^{3'} are hydrogen, and R⁵⁵ and R^{55'} are hydrogen, C₁-C₁₈alkoxy, or C₁-C₁₈alkoxy, which is interrupted by O; R³ and R^{3'} are different from hydrogen, and R⁵⁵ and R^{55'} are as defined above. -COM²- is preferably a repeating unit of formula 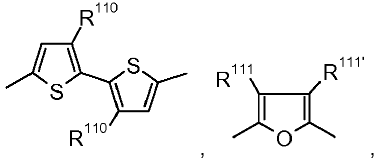 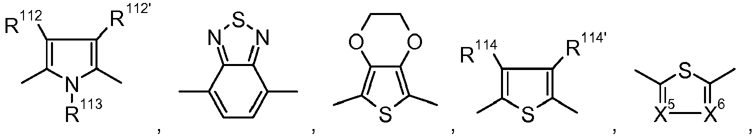 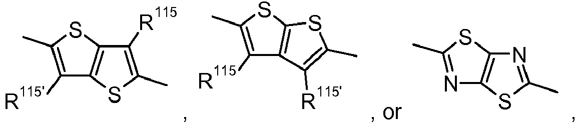 wherein one of X⁵ and X⁶ is N
and the other is CR¹¹⁴,
R¹¹⁰ is a C₁-C₂₅alkyl group, especially a C₄-C₂₅alkyl,
R¹¹¹, R^{111'}, R¹¹² and R^{112'} are independently of each other hydrogen, or a C₁-C₂₅alkyl group, especially a C₄-C₂₅alkyl,
R¹¹³ is C₆-C₁₈aryl; C₆-C₁₈aryl which is substituted by C₁-C₁₈alkyl, or C₁-C₁₈alkoxy; or C₁-C₁₈alkyl;
R¹¹⁴, R^{114'}, R¹¹⁵ and R^{115'} are independently of each other H, or a C₁-C₂₅alkyl group, especially a C₆-C₂₅alkyl.

In a preferred embodiment of the present invention A is a group of formula 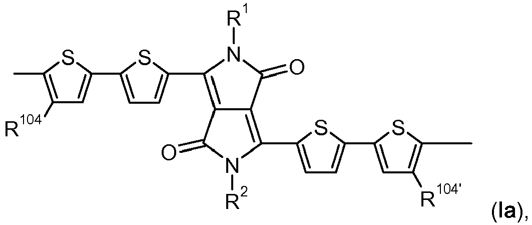 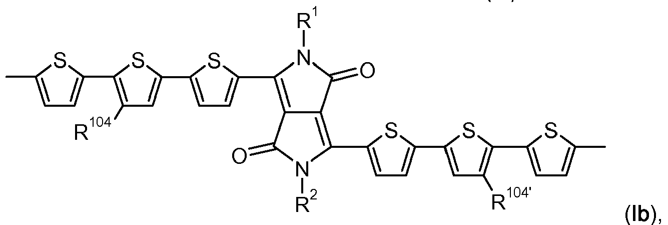 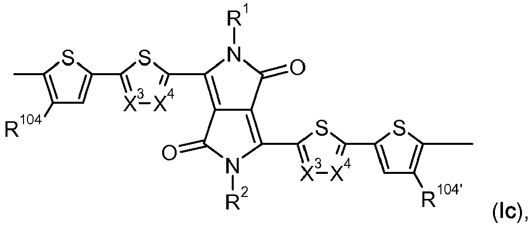 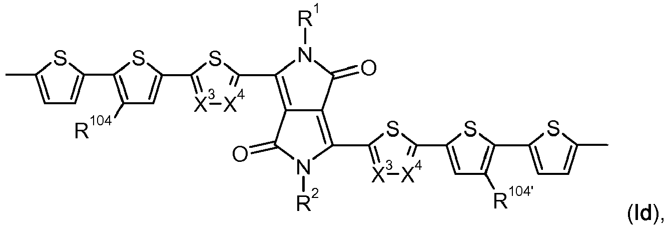 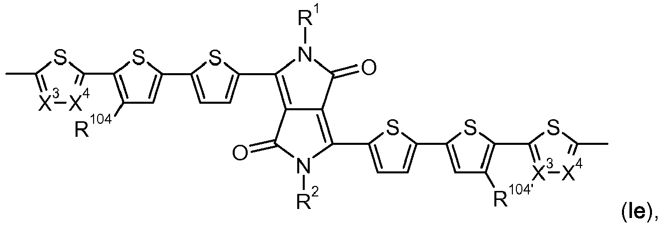 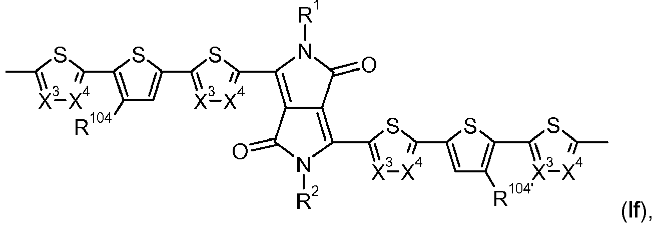 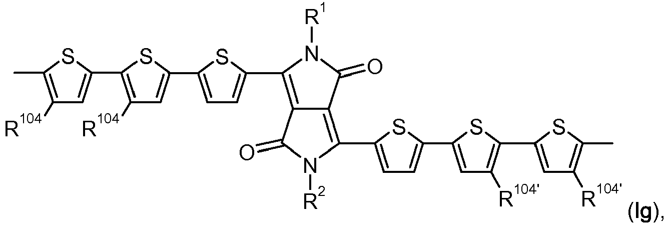 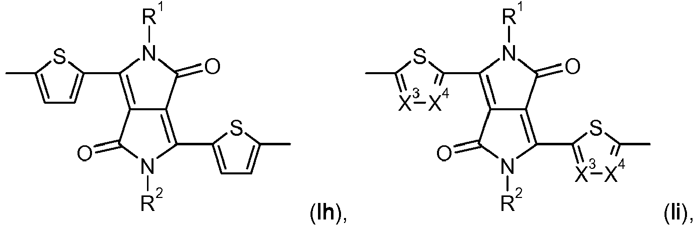 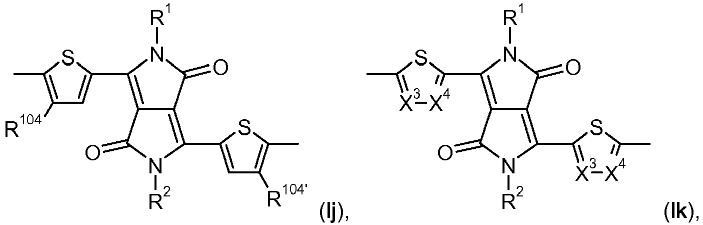 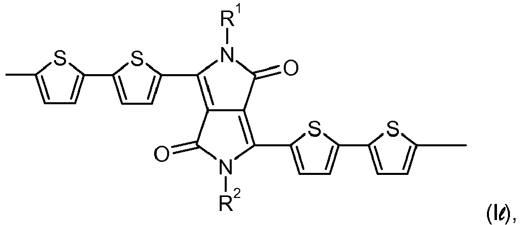 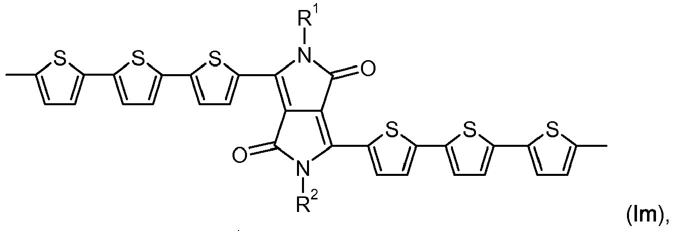 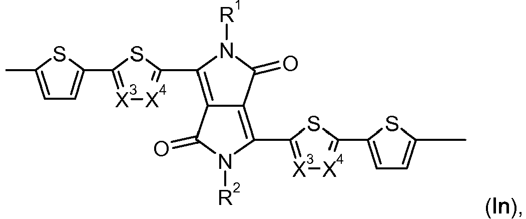 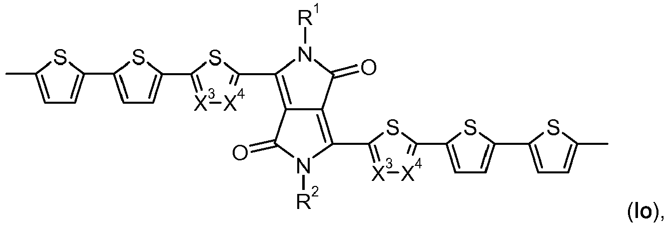 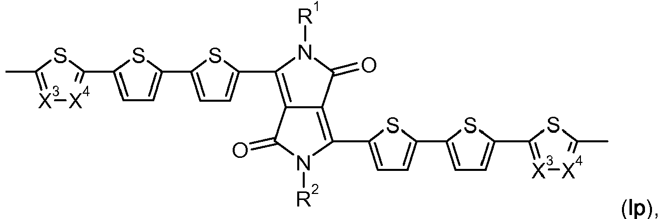 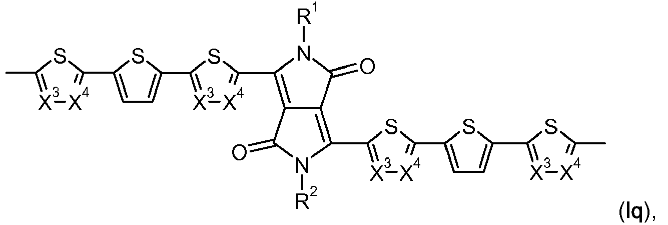 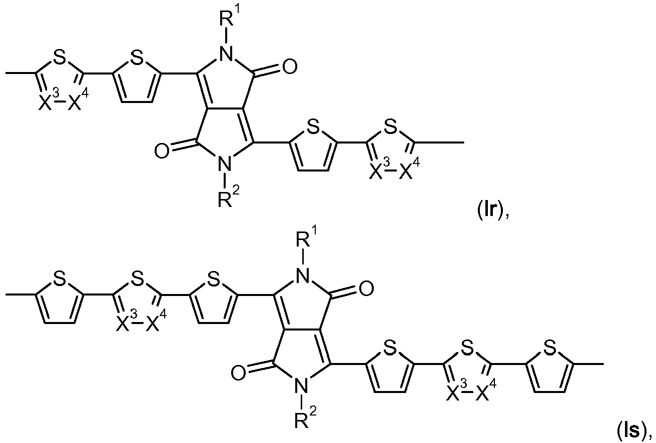 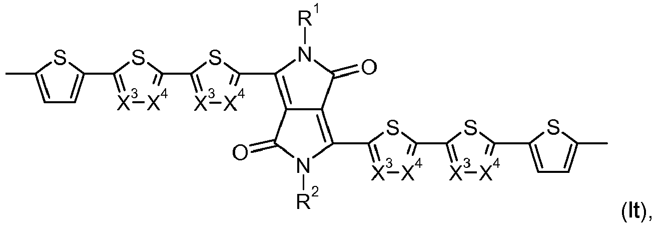 or 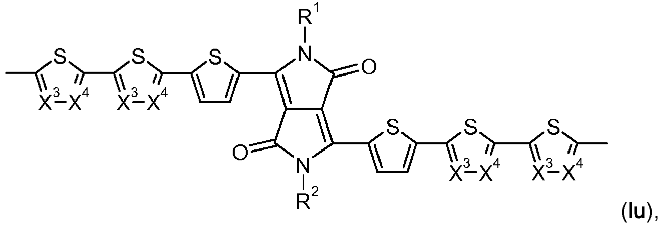 wherein X³, X⁴, R¹ and R² are as defined above, and
R¹⁰⁴ and R^{104'} are independently of each other hydrogen, or a C₁-C₂₅alkyl group, especially a C₄-C₂₅alkyl, which may optionally be interrupted by one or more oxygen or sulphur atoms, C₇-C₂₅arylalkyl, or a C₁-C₂₅alkoxy group.

A is preferably a group of formula **Ia, Ih,** or **Iℓ,** wherein R¹ and R² can be different, but are preferably the same and are a C₁-C₃₅alkyl group, and R¹⁰⁴ and R^{104'} are H, or a C₁-C₂₅alkyl group.

In a preferred embodiment of the present invention the polymer is a copolymer of the for*-[-A-]-* mula and 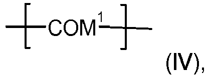 especially 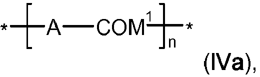 wherein n is 4 to 1000, especially 4 to 200, very especially 5 to 100,
A is a group of formula **Ia** to **Iu** as defined above, and
COM¹ is a group of formula **Xa** to **Xm** as defined above.

A, COM¹ and COM² are different from each other. If the polymers comprise repeating units -[-A-COM¹-]- -[-A-COM²-]-of the formula and , they are preferably (random) copolymers of formula 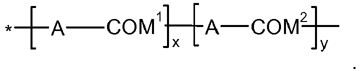 If the polymers comprise repeating units of the formula 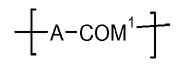 and 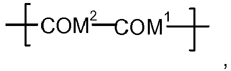 they are preferably (random) copolymers of formula 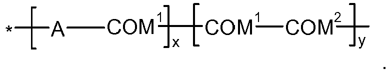 x = 0.995 to 0.005, y = 0.005 to 0.995, especially x = 0.2 to 0.8, y = 0.8 to 0.2, and wherein x + y = 1.

In a preferred embodiment of the present invention the polymer is a copolymer of the formula 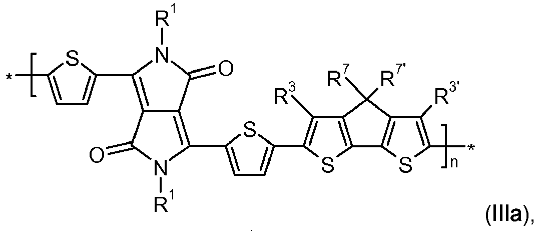 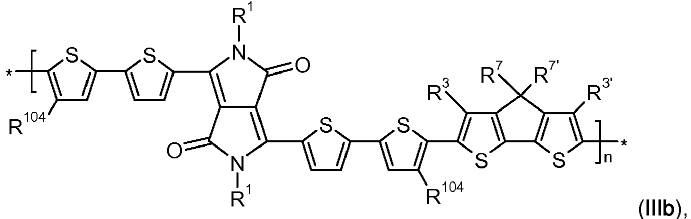 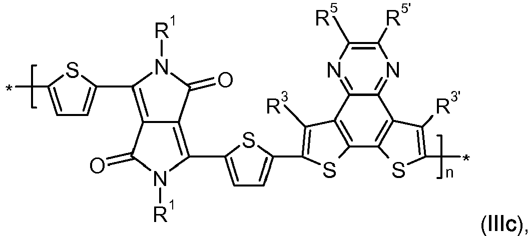 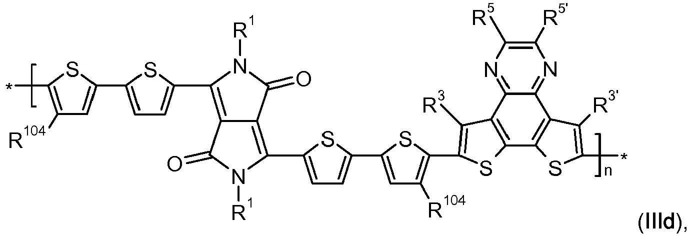 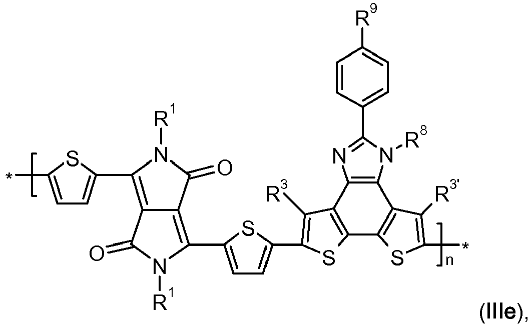 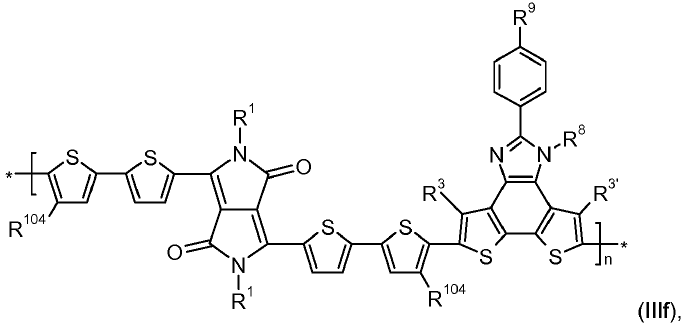 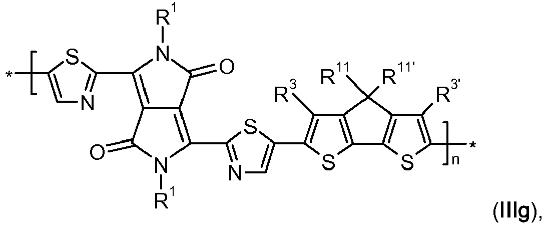 or 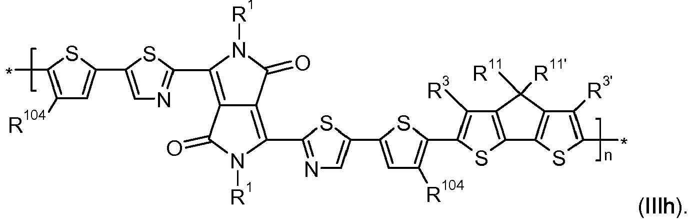 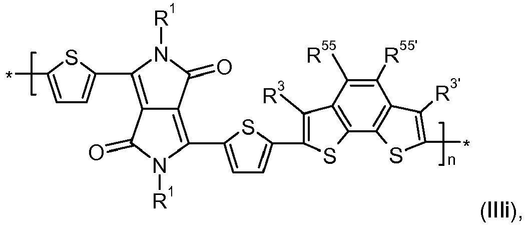 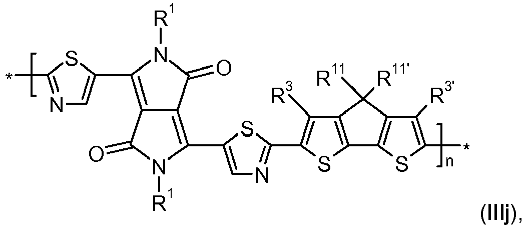 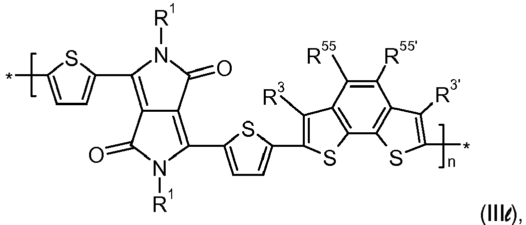 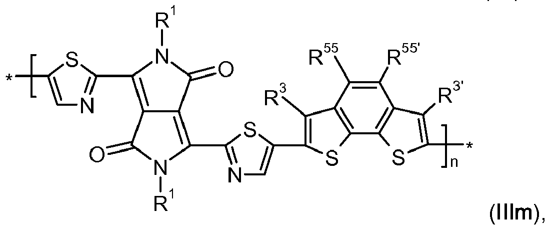 or 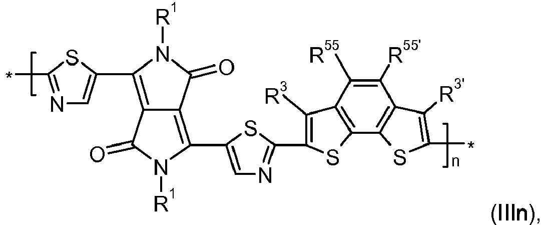 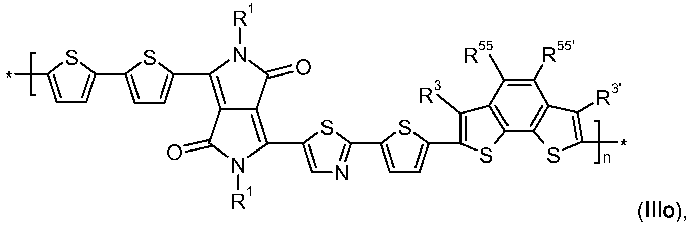 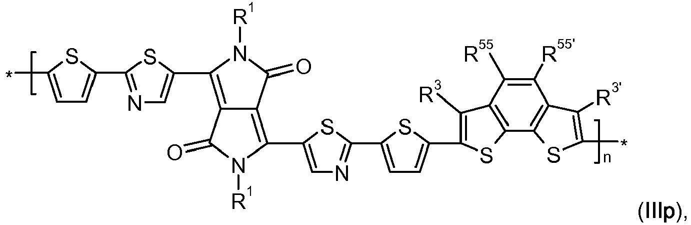 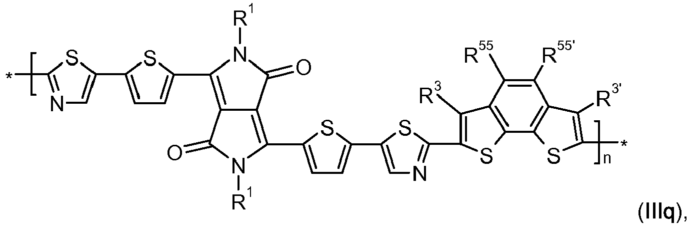 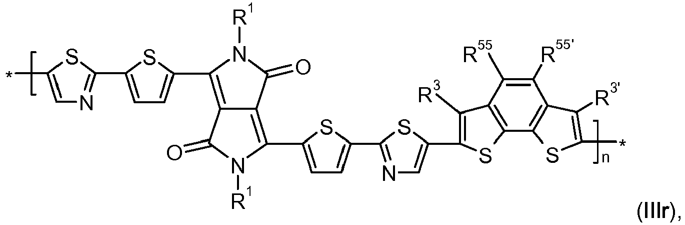 wherein v is 0.995 to 0.005, w is 0.005 to 0.995,
n is 4 to 1000, especially 4 to 200, very especially 5 to 100,
m is 4 to 1000, especially 4 to 200, very especially 5 to 100,
R¹ is a C₁-C₃₅alkyl group, especially a C₈-C₃₅alkyl group,
R³ and R^{3'} are H, or a C₁-C₂₅alkyl group,
R⁵ and R^{5'} are a C₁-C₂₅alkyl group, or a C₁-C₂₅alkoxy group,
R⁵⁵ and R^{55'} are H,
R⁵⁶ and R^{56'} are H, a C₁-C₂₅alkyl group, or a C₁-C₂₅alkoxy group,
R⁷, R^{7'}, R¹¹ and R^{11'} are a C₁-C₃₅alkyl group,
R⁸ is a C₁-C₂₅alkyl group,
R⁹ is a C₁-C₂₅alkyl group, or a C₁-C₂₅alkoxy group,
R¹⁰⁴ is H, or a C₁-C₂₅alkyl group,
R¹⁰⁴ is H, or a C₁-C₂₅alkyl group,
R^{104'} is H, or a C₁-C₂₅alkyl group,
R¹¹⁰ is a C₁-C₂₅alkyl group, and
R¹⁰⁸ and R¹⁰⁶ is H; or R¹⁰⁸ is CN and R¹⁰⁶ is H; or R¹⁰⁶ is CN and R¹⁰⁸ is H.

If the polymer is a copolymer of the formula **IIb,** or **IId,** R¹⁰⁴ is preferably H.

Polymers of formula **lie** to **IIℓ,** and **IIIa, IIIc, IIIe** and **IIIg** are preferred, polymers of formula **IIe, IIg, IIi, IIIa, IIIc, IIIe** and **IIIg** are most preferred.

Examples of preferred polymers are shown below: 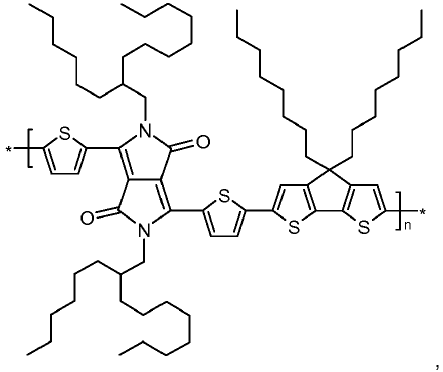 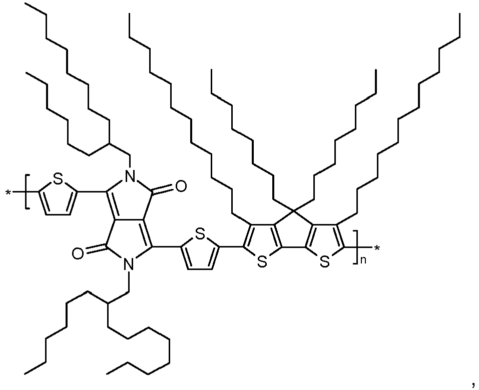 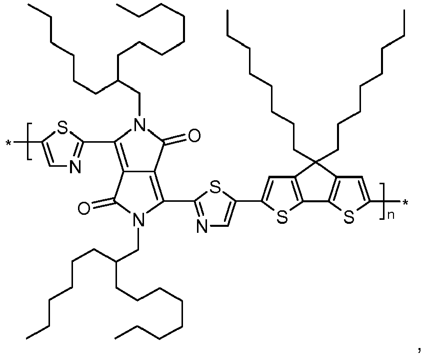 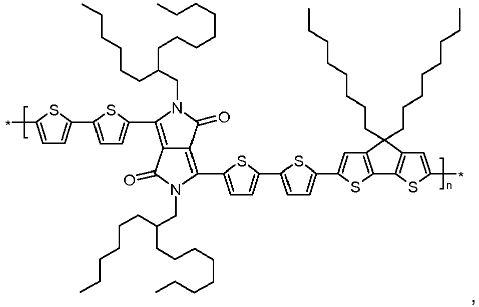 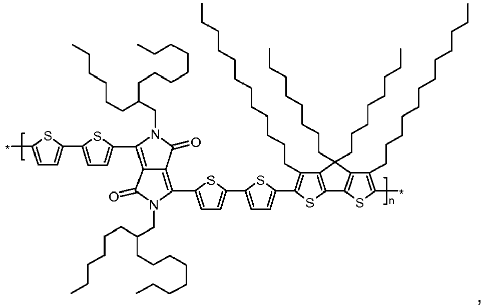 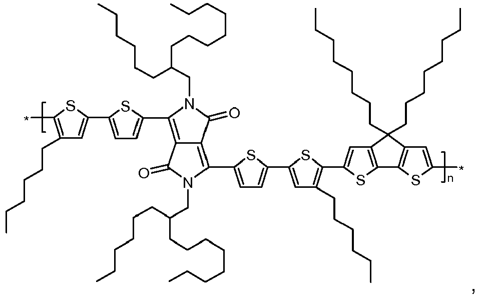 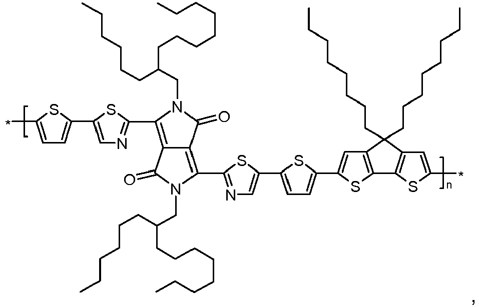 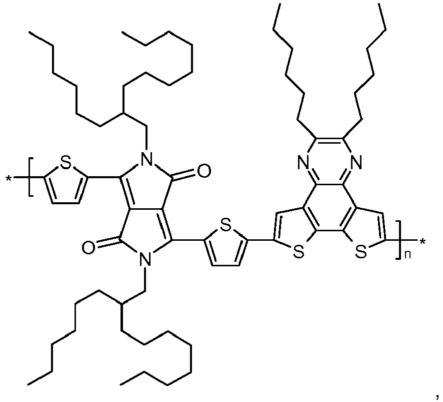 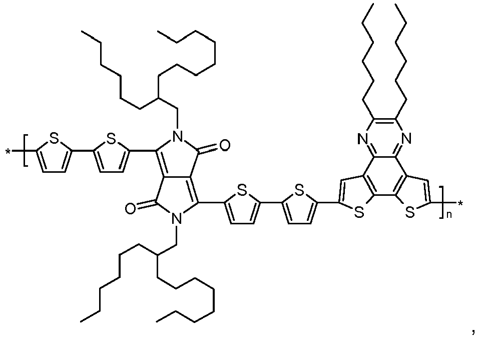 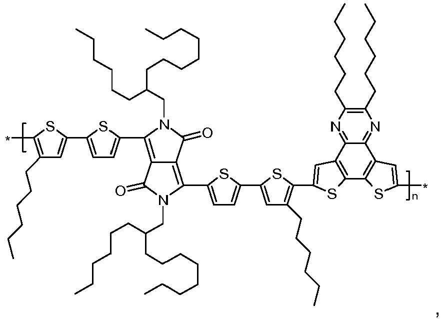 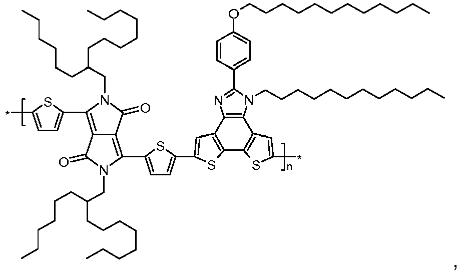 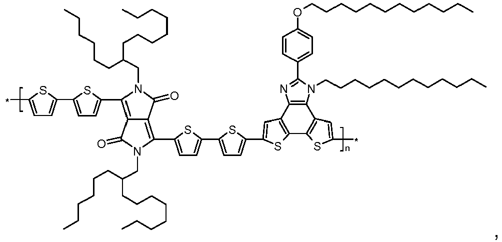 and

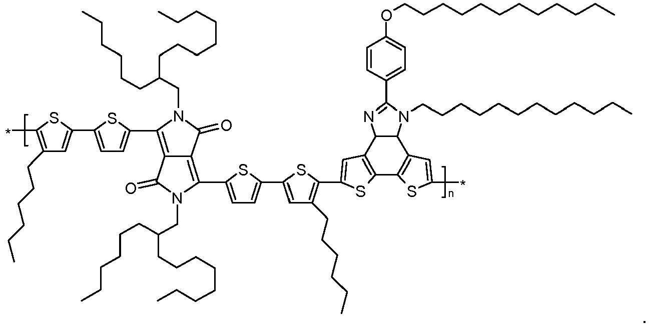

C₁-C₂₅alkyl (C₁-C₁₈alkyl) is typically linear or branched, where possible. Examples are methyl, ethyl, n-propyl, isopropyl, n-butyl, sec.-butyl, isobutyl, tert.-butyl, n-pentyl, 2-pentyl, 3-pentyl, 2,2-dimethylpropyl, 1,1,3,3-tetramethylpentyl, n-hexyl, 1-methylhexyl, 1,1,3,3,5,5-hexamethylhexyl, n-heptyl, isoheptyl, 1,1,3,3-tetramethylbutyl, 1-methylheptyl, 3-methylheptyl, n-octyl, 1,1,3,3-tetramethylbutyl and 2-ethylhexyl, n-nonyl, decyl, undecyl, dodecyl, tridecyl, tetradecyl, pentadecyl, hexadecyl, heptadecyl, octadecyl, eicosyl, heneicosyl, docosyl, tetracosyl or pentacosyl. C₁-C₈alkyl is typically methyl, ethyl, n-propyl, isopropyl, n-butyl, sec.-butyl, isobutyl, tert.-butyl, n-pentyl, 2-pentyl, 3-pentyl, 2,2-dimethyl-propyl, n-hexyl, n-heptyl, n-octyl, 1,1,3,3-tetramethylbutyl and 2-ethylhexyl. C₁-C₄alkyl is typically methyl, ethyl, n-propyl, isopropyl, n-butyl, sec.-butyl, isobutyl, tert.-butyl.

C₁-C₂₅alkoxy groups (C₁-C₁₈alkoxy groups) are straight-chain or branched alkoxy groups, e.g. methoxy, ethoxy, n-propoxy, isopropoxy, n-butoxy, sec-butoxy, tert-butoxy, amyloxy, isoamyloxy or tert-amyloxy, heptyloxy, octyloxy, isooctyloxy, nonyloxy, decyloxy, un-decyloxy, dodecyloxy, tetradecyloxy, pentadecyloxy, hexadecyloxy, heptadecyloxy and octadecyloxy. Examples of C₁-C₈alkoxy are methoxy, ethoxy, n-propoxy, isopropoxy, n-butoxy, sec.-butoxy, isobutoxy, tert.-butoxy, n-pentoxy, 2-pentoxy, 3-pentoxy, 2,2-dimethylpropoxy, n-hexoxy, n-heptoxy, n-octoxy, 1,1,3,3-tetramethylbutoxy and 2-ethylhexoxy, preferably C₁-C₄alkoxy such as typically methoxy, ethoxy, n-propoxy, isopropoxy, n-butoxy, sec.-butoxy, isobutoxy, tert.-butoxy. The term "alkylthio group" means the same groups as the alkoxy groups, except that the oxygen atom of the ether linkage is replaced by a sulfur atom.

C₅-C₁₂cycloalkyl is typically cyclopentyl, cyclohexyl, cycloheptyl, cyclooctyl, cyclononyl, cyclodecyl, cycloundecyl, cyclododecyl, preferably cyclopentyl, cyclohexyl, cycloheptyl, or cyclooctyl, which may be unsubstituted or substituted. The cycloalkyl group, in particular a cyclohexyl group, can be condensed one or two times by phenyl which can be substituted one to three times with C₁-C₄-alkyl, halogen and cyano. Examples of such condensed cyclohexyl groups are: 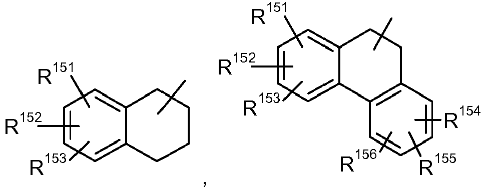 or 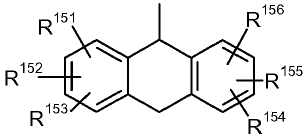 in particular 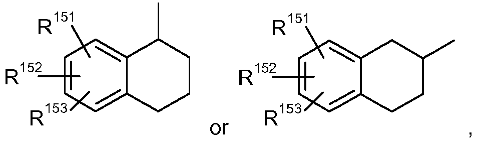 wherein R¹⁵¹, R¹⁵², R¹⁵³, R¹⁵⁴, R¹⁵⁵ and R¹⁵⁶ are independently of each other C₁-C₈-alkyl, C₁-C₈-alkoxy, halogen and cyano, in particular hydrogen.

C₆-C₂₄aryl is typically phenyl, indenyl, azulenyl, naphthyl, biphenyl, as-indacenyl, s-indacenyl, acenaphthylenyl, fluorenyl, phenanthryl, fluoranthenyl, triphenlenyl, chrysenyl, naphthacen, picenyl, perylenyl, pentaphenyl, hexacenyl, pyrenyl, or anthracenyl, preferably phenyl, 1-naphthyl, 2-naphthyl, 4-biphenyl, 9-phenanthryl, 2- or 9-fluorenyl, 3- or 4-biphenyl, which may be unsubstituted or substituted. Examples of C₆-C₁₂aryl are phenyl, 1-naphthyl, 2-naphthyl, 3- or 4-biphenyl, 2- or 9-fluorenyl or 9-phenanthryl, which may be unsubstituted or substituted.

C₇-C₂₅aralkyl is typically benzyl, 2-benzyl-2-propyl, β-phenyl-ethyl, α,α-dimethylbenzyl, ω-phenyl-butyl, ω,ω-dimethyl-ω-phenyl-butyl, ω-phenyl-dodecyl, ω-phenyl-octadecyl, ω-phenyl-eicosyl or ω-phenyl-docosyl, preferably C₇-C₁₈aralkyl such as benzyl, 2-benzyl-2-propyl, β-phenyl-ethyl, α,α-dimethylbenzyl, ω-phenyl-butyl, ω,ω-dimethyl-ω-phenyl-butyl, ω-phenyl-dodecyl or ω-phenyl-octadecyl, and particularly preferred C₇-C₁₂aralkyl such as benzyl, 2-benzyl-2-propyl, β-phenyl-ethyl, α,α-dimethylbenzyl, ω-phenyl-butyl, or ω,ω-dimethyl-ω-phenyl-butyl, in which both the aliphatic hydrocarbon group and aromatic hydrocarbon group may be unsubstituted or substituted. Preferred examples are benzyl, 2-phenylethyl, 3-phenylpropyl, naphthylethyl, naphthylmethyl, and cumyl.

The term "carbamoyl group" is typically a C₁₋₁₈carbamoyl radical, preferably C₁₋₈carbamoyl radical, which may be unsubstituted or substituted, such as, for example, carbamoyl, methylcarbamoyl, ethylcarbamoyl, n-butylcarbamoyl, tert-butylcarbamoyl, dimethylcarbamoyloxy, morpholinocarbamoyl or pyrrolidinocarbamoyl.

Heteroaryl is typically C₂-C₂₀heteroaryl, i.e. a ring with five to seven ring atoms or a condensed ring system, wherein nitrogen, oxygen or sulfur are the possible hetero atoms, and is typically an unsaturated heterocyclic group with five to 30 atoms having at least six conjugated π-electrons such as thienyl, benzo[b]thienyl, dibenzo[b,d]thienyl, thianthrenyl, furyl, furfuryl, 2H-pyranyl, benzofuranyl, isobenzofuranyl, dibenzofuranyl, phenoxythienyl, pyrrolyl, imidazolyl, pyrazolyl, pyridyl, bipyridyl, triazinyl, pyrimidinyl, pyrazinyl, pyridazinyl, indolizinyl, isoindolyl, indolyl, indazolyl, purinyl, quinolizinyl, chinolyl, isochinolyl, phthalazinyl, naphthyridinyl, chinoxalinyl, chinazolinyl, cinnolinyl, pteridinyl, carbazolyl, carbolinyl, benzotriazolyl, benzoxazolyl, phenanthridinyl, acridinyl, pyrimidinyl, phenanthrolinyl, phenazinyl, isothiazolyl, phenothiazinyl, isoxazolyl, furazanyl or phenoxazinyl, which can be unsubstituted or substituted.

Possible substituents of the above-mentioned groups are C₁-C₈alkyl, a hydroxyl group, a mercapto group, C₁-C₈alkoxy, C₁-C₈alkylthio, halogen, halo-C₁-C₈alkyl, a cyano group, a carbamoyl group, a nitro group or a silyl group, especially C₁-C₈alkyl, C₁-C₈alkoxy, C₁-C₈alkylthio, halogen, halo-C₁-C₈alkyl, or a cyano group.

C₁-C₁₈alkyl interrupted by one or more O is, for example, (CH₂CH₂O)₁₋₉-R^{x}, where R^{x} is H or C₁-C₁₀alkyl, CH₂-CH(OR^{y'})-CH₂-O-R^{y}, where R^{y} is C₁-C₁₈alkyl, and R^{y'} embraces the same definitions as R^{y} or is H.

If a substituent, such as, for example R¹, or R¹⁰⁴, occurs more than one time in a group, it can be different in each occurrence.

Copolymers of formula **IV** can be obtained, for example, by the Suzuki reaction. The condensation reaction of an aromatic boronate and a halogenide, especially a bromide, commonly referred to as the "Suzuki reaction", is tolerant of the presence of a variety of organic functional groups as reported by N. Miyaura and A. Suzuki in Chemical Reviews, Vol. 95, pp. 457-2483 (1995). Preferred catalysts are 2-dicyclohexylphosphino-2',6'-di-alkoxybiphenyl/palladium(II)acetates, tri-alykl-phosphonium salts/palladium (0) derivatives and tri-alkylphosphine/palladium (0) derivatives. Especially preferred catalysts are 2-dicyclohexylphosphino-2',6'-di-methoxybiphenyl (sPhos)/palladium(II)acetate and, tri-tert-butylphosphonium tetrafluoroborate ((t-Bu)₃P^{∗}HBF₄)/tris(dibenzylideneacetone) dipalladium (0) (Pd₂(dba)₃) and tri-tert-butylphosphine (t-Bu)₃P/tris(dibenzylideneacetone) dipalladium (0) (Pd₂(dba)₃). This reaction can be applied to preparing high molecular weight polymers and copolymers.

To prepare polymers corresponding to formula **III** a dihalogenide of formula X¹⁰-A-X¹⁰ is reacted with an equimolar amount of a diboronic acid or diboronate corresponding to formula 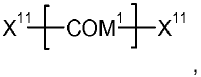 or a dihalogenide of formula 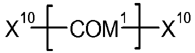 is reacted with an equimolar amount of a diboronic acid or diboronate corresponding to formula X¹¹-A-X¹¹, wherein X¹⁰ is halogen, especially Br, and X¹¹ is independently in each occurrence -B(OH)₂, -B(OY¹)₂, 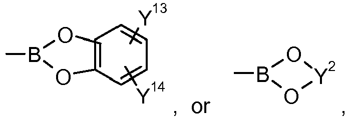 wherein Y¹ is independently in each occurrence a C₁-C₁₀alkyl group and Y² is independently in each occurrence a C₂-C₁₀alkylene group, such as -CY³Y⁴-CY⁵Y⁶-, or -CY⁷Y⁸-CY⁹Y¹⁰-CY¹¹Y¹²-, wherein Y³, Y⁴, Y⁵, Y⁶, Y⁷, Y⁸, Y⁹, Y¹⁰, Y¹¹ and Y¹² are independently of each other hydrogen, or a C₁-C₁₀alkyl group, especially -C(CH₃)₂C(CH₃)₂-, -C(CH₃)₂CH₂C(CH₃)₂-, or -CH₂C(CH₃)₂CH₂-, and Y¹³ and Y¹⁴ are independently of each other hydrogen, or a C₁-C₁₀alkyl group, in a solvent and in the presence of a catalyst. The reaction is typically conducted at about 0 °C to 180 °C in an aromatic hydrocarbon solvent such as toluene, xylene. Other solvents such as dimethylformamide, dioxane, dimethoxyethan and tetrahydrofuran can also be used alone, or in mixtures with an aromatic hydrocarbon. An aqueous base, preferably sodium carbonate or bicarbonate, potassium phosphate, potassium carbonate or bicarbonate is used as activation agent for the boronic acid, boronate and as the HBr scavenger. A polymerization reaction may take 0.2 to 100 hours. Organic bases, such as, for example, tetraalkylammonium hydroxide, and phase transfer catalysts, such as, for example TBAB, can promote the activity of the boron (see, for example, Leadbeater & Marco; Angew. Chem. Int. Ed. Eng. 42 (2003) 1407 and references cited therein). Other variations of reaction conditions are given by T. I. Wallow and B. M. Novak in J. Org. Chem. 59 (1994) 5034-5037; and M. Remmers, M. Schulze, and G. Wegner in Macromol. Rapid Commun. 17 (1996) 239-252. Controll of molecular weight is possible by using either an excess of dibromide, diboronic acid, or diboronate, or a chain terminator.

According to the process described in European patent application no. 09176497.7 [PCT/EP2010/056776] the polymerisation is carried out in presence of
a) a catalyst/ligand system comprising a palladium catalyst and an organic phosphine or phosphonium compound,
b) a base,
c) a solvent or a mixture of solvents, characterized in that
   the organic phosphine is a trisubstituted phosphine of formula 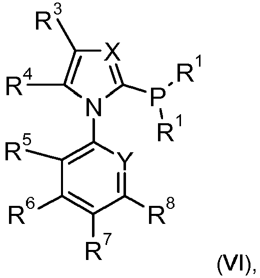 or phosphonium salt thereof, wherein X independently of Y represents a nitrogen atom or a C-R² group and Y independently of X represents a nitrogen atom or a C-R⁹ group, R¹ for each of the two R¹ groups independently of the other represents a radical selected from the group C₁-C₂₄-alkyl, C₃-C₂₀-cycloalkyl, which includes especially both monocyclic and also bi-and tri-cyclic cycloalkyl radicals, C₅-C₁₄-aryl, which includes especially the phenyl, naphthyl, fluorenyl radical, C₂-C₁₃-heteroaryl, wherein the number of hetero atoms, selected from the group N, O, S, may be from 1 to 2, wherein the two radicals R¹ may also be linked to one another,
   and wherein the above-mentioned radicals R¹ may themselves each be mono-or poly-substituted independently of one another by substituents selected from the group hydrogen, C₁-C₂₀-alkyl, C₂-C₂₀-alkenyl, C₃-C₈-cycloalkyl, C₂-C₉-hetero-alkyl, C₅-C₁₀-aryl, C₂-C₉-heteroaryl, wherein the number of hetero atoms from the group N, O, S may be from 1 to 4, C₁-C₂₀-alkoxy, C₁-C₁₀-haloalkyl, hydroxy, amino of the forms NH-(C₁-C₂₀-alkyl), NH-(C₅-C₁₀-aryl), N(C₁-C₂₀-alkyl)₂, N(C₁-C₂₀-alkyl) (C₅-C₁₀-aryl), N(C₅-C₁₀-aryl)₂, N(C₁-C₂₀-alkyl/C₅-C₁₀-aryl₃)₃⁺, NH-CO-C₁-C₂₀-alkyl, NH-CO- C₅-C₁₀-aryl, carboxylato of the forms COOH and COOQ (wherein Q represents either a monovalent cation or C₁-C₃-alkyl), C₁-C₆-acyloxy, sulfinato, sulfonato of the forms SO₃H and SO₃Q' (wherein Q' represents either a monovalent cation, C₁-C₂₀-alkyl, or C₅-C₁₀-aryl), tri-C₁-C₆-alkylsilyl, wherein two of the mentioned substituents may also be bridged with one another, R²-R⁹ represent a hydrogen, alkyl, alkenyl, cycloalkyl, aromatic or heteroaromatic aryl, O-alkyl, NH- alkyl, N-(alkyl)₂, O-(aryl), NH-(aryl), N-(alkyl)(aryl), O-CO-alkyl, O-CO-aryl, F, Si(alkyl)₃, CF₃, CN, CO₂H, COH, SO₃H, CONH₂, CONH(alkyl), CON(alkyl)₂, SO₂(alkyl), SO(alkyl), SO(aryl), SO₂(aryl), SO₃(alkyl), SO₃(aryl), S-alkyl, S-aryl, NH-CO(alkyl), CO₂(alkyl), CONH₂, CO(alkyl), NHCOH, NHCO₂(alkyl), CO(aryl), CO₂(aryl) radical, wherein two or more adjacent radicals, each independently of the other (s), may also be linked to one another so that a condensed ring system is present and wherein in R² to R⁹ alkyl represents a hydrocarbon radical having from 1 to 20 carbon atoms which may in each case be linear or branched, alkenyl represents a mono-or poly- unsaturated hydrocarbon radical having from 2 to 20 carbon atoms which may in each case be linear or branched, cycloalkyl represents a hydrocarbon having from 3 to 20 carbon atoms, aryl represents a 5- to 14-membered aromatic radical, wherein from one to four carbon atoms in the aryl radical may also be replaced by hetero atoms from the group nitrogen, oxygen and sulfur so that a 5- to 14-membered heteroaromatic radical is present, wherein the radicals R² to R⁹ may also carry further substituents as defined for R¹.

The organic phosphines and their synthesis are described in WO2004101581.

Preferred organic phosphines are selected from trisubstituted phosphines of formula

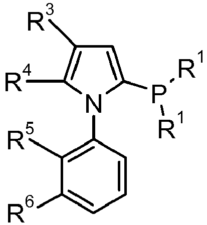

| **Cpd.** | **R¹** | **R⁵** | **R⁶** | **R³** | **R⁴** |
|---|---|---|---|---|---|
| **A-1** | 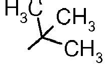 | H | H | H | H |
| **A-2** | cyclohexyl | H | H | H | H |
| **A-3** | phenyl | H | H | H | H |
| **A-4** | adamantyl | H | H | H | H |
| **A-5** | cyclohexyl | -OCH₃ | H | H | H |
| **A-6** | cyclohexyl | ¹⁾ | ¹⁾ | H | H |
| **A-7** | 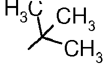 | ¹⁾ | ¹⁾ | H | H |
| **A-8** | phenyl | ¹⁾ | ¹⁾ | H | H |
| **A-9** | adamantyl | ¹⁾ | ¹⁾ | H | H |
| **A-10** | cyclohexyl | H | H | ²⁾ | ²⁾ |
| **A-11** | 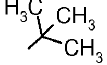 | H | H | ²⁾ | ²⁾ |
| **A-12** | phenyl | H | H | ²⁾ | ²⁾ |
| **A-13** | adamantyl | H | H | ²⁾ | ²⁾ |

| | | | | | |
|---|---|---|---|---|---|
| ¹⁾ R⁵ and R⁶ together form a ring 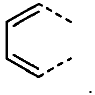 ²⁾ R³ and R⁴ together form a ring 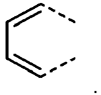 | | | | | |

Examples of preferred catalysts include the following compounds:
palladium(II) acetylacetonate, palladium(0) dibenzylidene-acetone complexes, palladium(II) propionate,
Pd₂(dba)₃: [tris(dibenzylideneacetone) dipalladium(0)],
Pd(dba)₂: [bis(dibenzylideneacetone) palladium(0)],
Pd(PR₃)₂, wherein PR₃ is a trisubstituted phosphine of formula VI,
Pd(OAc)₂: [palladium(II) acetate], palladium(II) chloride, palladium(II) bromide, lithium tetrachloropalladate(II),
PdCl₂(PR₃)₂; wherein PR₃ is a trisubstituted phosphine of formula VI; palladium(0) diallyl ether complexes, palladium(II) nitrate,
PdCl₂(PhCN)₂: [dichlorobis(benzonitrile) palladium(II)],
PdCl₂(CH₃CN): [dichlorobis(acetonitrile) palladium(II)], and
PdCl₂(COD): [dichloro(1,5-cyclooctadiene) palladium(II)].

Especially preferred are PdCl₂, Pd₂(dba)₃, Pd(dba)₂, Pd(OAc)₂, or Pd(PR₃)₂. Most preferred are Pd₂(dba)₃ and Pd(OAc)₂.

The palladium catalyst is present in the reaction mixture in catalytic amounts. The term "catalytic amount" refers to an amount that is clearly below one equivalent of the (hetero)aromatic compound(s), preferably 0.001 to 5 mol-%, most preferably 0.001 to 1 mol-%, based on the equivalents of the (hetero)aromatic compound(s) used.

The amount of phosphines or phosphonium salts in the reaction mixture is preferably from 0.001 to 10 mol-%, most preferably 0.01 to 5 mol-%, based on the equivalents of the (hetero)aromatic compound(s) used. The preferred ratio of Pd:phosphine is 1:4.

The base can be selected from all aqueous and nonaqueous bases and can be inorganic, or organic. It is preferable that at least 1.5 equivalents of said base per functional boron group is present in the reaction mixture. Suitable bases are, for example, alkali and alkaline earth metal hydroxides, carboxylates, carbonates, fluorides and phosphates such as sodium and potassium hydroxide, acetate, carbonate, fluoride and phosphate or also metal alcoholates. It is also possible to use a mixture of bases. The base is preferably a lithium salt, such as, for example, lithium alkoxides (such as, for example, lithium methoxide and lithium ethoxide), lithium hydroxide, carboxylate, carbonate, fluoride and/or phosphate.

The at present most preferred base is aqueous LiOHxH₂O (monohydrate of LiOH) and (waterfree) LiOH.

The reaction is typically conducted at about 0 °C to 180 °C, preferably from 20 to 160°C, more preferably from 40 to 140°C and most preferably from 40 to 120°C. A polymerization reaction may take 0.1, especially 0.2 to 100 hours.

In a preferred embodiment of the present invention the solvent is THF, the base is Li-OH^{∗}H₂O and the reaction is conducted at reflux temperature of THF (about 65 °C).

The solvent is for example selected from toluene, xylenes, anisole, THF, 2-methyltetrahydrofuran, dioxane, chlorobenzene, fluorobenzene or solvent mixtures comprising one or more solvents like e.g. THF/toluene and optionally water. Most preferred is THF, or THF/water.

Advantageously, the polymerisation is carried out in presence of
a) palladium(II) acetate, or Pd₂(dba)₃, (tris(dibenzylideneacetone)dipalladium(0)) and an organic phosphine **A-1** to **A-13**,
b) LiOH, or LiOHxH₂O; and
c) THF, and optionally water. If the monohydrate of LiOH is used, no water needs to be added.

Most preferred the polymerisation is carried out in presence of
a) palladium(II) acetate, or Pd₂(dba)₃ (tris(dibenzylideneacetone)dipalladium(0)) and 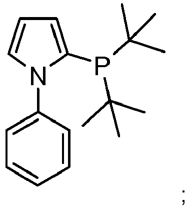
b) LiOHxH₂O; and
c) THF. The palladium catalyst is present in an amount of preferably about 0.5 mol-%, based on the equivalents of the (hetero)aromatic compound(s) used. The amount of phosphines or phosphonium salts in the reaction mixture is preferably about 2 mol-%, based on the equivalents of the (hetero)aromatic compound(s) used. The preferred ratio of Pd:phosphine is about 1:4.

Preferably the polymerization reaction is conducted under inert conditions in the absence of oxygen. Nitrogen and more preferably argon are used as inert gases.

The process described in European patent application no. 09176497.7 is suitable for large-scale applications, is readily accessible and convert starting materials to the respective polymers in high yield, with high purity and high selectivity. The process can provide polymers having weight average molecular weights of at least 10,000, more preferably at least 20,000, most preferably at least 30,000. The at present most preferred polymers have a weight average molecular weight of 30,000 to 80,000 Daltons. Molecular weights are determined according to high-temperature gel permeation chromatography (HT-GPC) using polystyrene standards. The polymers preferably have a polydispersibility of 1.01 to 10, more preferably 1.1 to 3.0, most preferred 1.5 to 2.5.

If desired, a monofunctional halide, boronate, such as, for example, a monofunctional aryl halide, or aryl boronate, may be used as a chain-terminator in such reactions, which will result in the formation of a terminal aryl group:

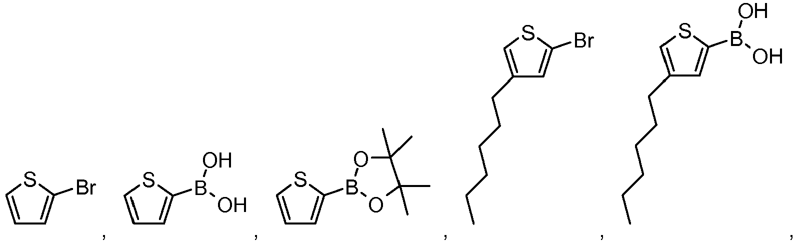

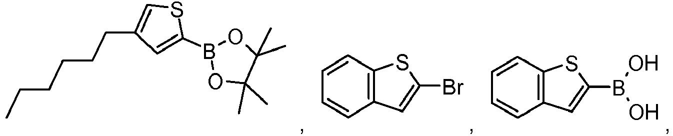

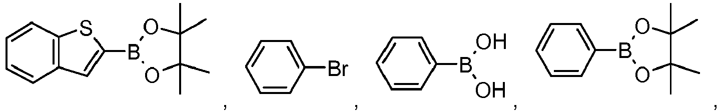

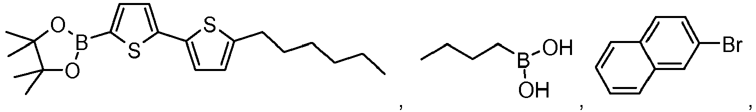

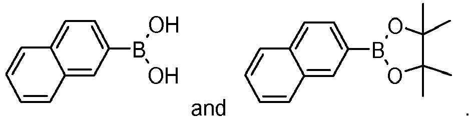

It is possible to control the sequencing of the monomeric units in the resulting copolymer by controlling the order and composition of monomer feeds in the Suzuki reaction.

The polymers of the present invention can also be synthesized by the Stille coupling (see, for example, Babudri et al, J. Mater. Chem., 2004, 14, 11-34; J. K. Stille, Angew. Chemie Int. Ed. Engl. 1986, 25, 508). To prepare polymers corresponding to formula II a dihalogenide of formula X¹⁰-A-X¹⁰ is reacted with an equimolar amount of an organo tin compound corresponding to formula 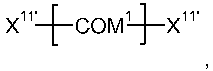 or a dihalogenide of formula 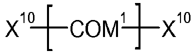 is reacted with an equimolar amount of an organo tin compound corresponding to formula X^{11'}-A-X^{11'}, wherein
X¹¹ is independently in each occurrence -SnR²⁰⁷R²⁰⁸R²⁰⁹, wherein R²⁰⁷, R²⁰⁸ and R²⁰⁹ are identical or different and are H or C₁-C₆alkyl, or two of the groups R²⁰⁷, R²⁰⁸ and R²⁰⁹ form a ring and these groups are optionally branched, in an inert solvent at a temperature in range from 0°C to 200°C in the presence of a palladium-containing catalyst. It must be ensured here that the totality of all monomers used has a highly balanced ratio of organotin functions to halogen functions. In addition, it may prove advantageous to remove any excess reactive groups at the end of the reaction by end-capping with monofunctional reagents. In order to carry out the process, the tin compounds and the halogen compounds are preferably introduced into one or more inert organic solvents and stirred at a temperature of from 0 to 200°C, preferably from 30 to 170°C for a period of from 1 hour to 200 hours, preferably from 5 hours to 150 hours. The crude product can be purified by methods known to the person skilled in the art and appropriate for the respective polymer, for example repeated re-precipitation or even by dialysis.

Suitable organic solvents for the process described are, for example, ethers, for example diethyl ether, dimethoxyethane, diethylene glycol dimethyl ether, tetrahydrofuran, dioxane, dioxolane, diisopropyl ether and tert-butyl methyl ether, hydrocarbons, for example hexane, isohexane, heptane, cyclohexane, benzene, toluene and xylene, alcohols, for example methanol, ethanol, 1-propanol, 2-propanol, ethylene glycol, 1-butanol, 2-butanol and tert-butanol, ketones, for example acetone, ethyl methyl ketone and isobutyl methyl ketone, amides, for example dimethylformamide (DMF), dimethylacetamide and N-methylpyrrolidone, nitriles, for example acetonitrile, propionitrile and butyronitrile, and mixtures thereof.

The palladium and phosphine components should be selected analogously to the description for the Suzuki variant.

Alternatively, the polymers of the present invention can also be synthesized by the Negishi reaction using zinc reagents A-(ZnX²²)₂, wherein X²² is halogen and halides, and COM¹-(X²³)₂, wherein X²³ is halogen or triflate, or using A-(X²³)₂ and COM¹-(ZnX²²)₂. Reference is, for example, made to E. Negishi et al., Heterocycles 18 (1982) 117-22.

Alternatively, the polymers of the present invention can also be synthesized by the Hiyama reaction using organosilicon reagents A-(SiR²¹⁰R²¹¹R²¹²)₂, wherein R²¹⁰, R²¹¹ and R²¹² are identical or different and are halogen, C₁-C₆alkyl and COM¹-(X²³)₂, wherein X²³ is halogen or triflate, or using A-(X²³)₂ and COM¹-(SiR²¹⁰R²¹¹R²¹²)₂. Reference is, for example, made to T. Hiyama et al., Pure Appl. Chem. 66 (1994) 1471-1478 and T. Hiyama et al., Synlett (1991) 845-853.

Homopolymers of the type (A)ₙ can be obtained via Yamamoto coupling of dihalides X¹⁰-A-X¹⁰, where X¹⁰ is halogen, preferably bromide. Alternatively homopolymers of the type (A)ₙ can be obtained via oxidative polymerization of units X¹⁰-A-X¹⁰, where X¹⁰ is hydrogen, e.g. with FeCl₃ as oxidizing agent.

The polymers, wherein R¹ and/or R² are hydrogen can be obtained by using a protecting group which can be removed after polymerization (see, for example, EP-A-0 648 770, EP-A-0 648 817, EP-A-0 742 255, EP-A-0 761 772, WO98/32802, WO98/45757, WO98/58027, WO99/01511, WO00/17275, WO00/39221, WO00/63297 and EP-A-1 086 984). Conversion of the pigment precursor into its pigmentary form is carried out by means of fragmentation under known conditions, for example thermally, optionally in the presence of an additional catalyst, for example the catalysts described in WO00/36210.

An example of such a protecting group is group of formula 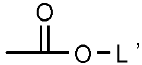 wherein L is any desired group suitable for imparting solubility.

L is preferably a group of formula 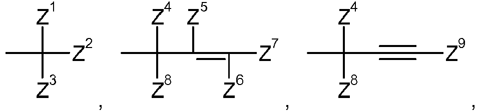 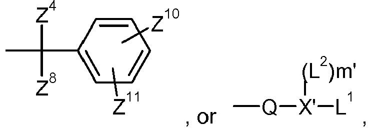 wherein Z¹, Z² and Z³ are independently of each other C₁-C₆alkyl,
Z⁴ and Z⁸ are independently of each other C₁-C₆alkyl, C₁-C₆alkyl interrupted by oxygen, sulfur or N(Z¹²)₂, or unsubstituted or C₁-C₆alkyl-, C₁-C₆alkoxy-, halo-, cyano- or nitro-substituted phenyl or biphenyl,
Z⁵, Z⁶ and Z⁷ are independently of each other hydrogen or C₁-C₆alkyl,
Z⁹ is hydrogen, C₁-C₆alkyl or a group of formula 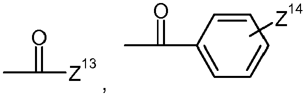 or 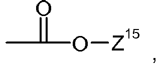 Z¹⁰ and Z¹¹ are each independently of the other hydrogen, C₁-C₆alkyl, C₁-C₆alkoxy, halogen, cyano, nitro, N(Z¹²)₂, or unsubstituted or halo-, cyano-, nitro-, C₁-C₆alkyl- or C₁-C₆alkoxy-substituted phenyl,
Z¹² and Z¹³ are C₁-C₆alkyl, Z¹⁴ is hydrogen or C₁-C₆alkyl, and Z¹⁵ is hydrogen, C₁-C₆alkyl, or unsubstituted or C₁-C₆alkyl-substituted phenyl,
Q is p,q-C₂-C₆alkylene unsubstituted or mono- or poly-substituted by C₁-C₆alkoxy, C₁-C₆alkylthio or C₂-C₁₂dialkylamino, wherein p and q are different position numbers,
X' is a hetero atom selected from the group consisting of nitrogen, oxygen and sulfur, m' being the number 0 when X' is oxygen or sulfur and m being the number 1 when X' is nitrogen, and
L¹ and L² are independently of each other unsubstituted or mono- or poly-C₁-C₁₂alkoxy-, -C₁-C₁₂alkylthio-, -C₂-C₂₄dialkylamino-, -C₆-C₁₂aryloxy-, -C₆-C₁₂arylthio-, -C₇-C₂₄alkylarylamino- or -C₁₂-C₂₄diarylamino-substituted C₁-C₆alkyl or [-(p',q'-C₂-C₆alkylene)-Z-]_{n'}-C₁-C₆alkyl , n' being a number from 1 to 1000, p' and q' being different position numbers, each Z independently of any others being a hetero atom oxygen, sulfur or C₁-C₁₂alkyl-substituted nitrogen, and it being possible for C₂-C₆alkylene in the repeating [-C₂-C₆alkylene-Z-] units to be the same or different,
and L₁ and L₂ may be saturated or unsaturated from one to ten times, may be uninterrupted or interrupted at any location by from 1 to 10 groups selected from the group consisting of -(C=O)- and -C₆H₄-, and may carry no further substituents or from 1 to 10 further substituents selected from the group consisting of halogen, cyano and nitro. Most preferred L is a group of formula

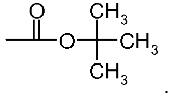

The synthesis of the compounds of formula Br-A-Br is described in WO08/000664, and PCT/EP2008/062586, or can be done in analogy to the methods described therein. The synthesis of N-aryl substituted compounds of formula Br-A-Br can be done in analogy to the methods described in US-A-5,354,869 and WO03/022848.

A mixture containing a polymer of the present invention results in a semi-conducting layer comprising a polymer of the present invention (typically 5% to 99.9999% by weight, especially 20 to 85 % by weight) and at least another material. The other material can be, but is not restricted to a fraction of the same polymer of the present invention with different molecular weight, another polymer of the present invention, a semi-conducting polymer, organic small molecules, such as, for example, carbon nanotubes, a fullerene derivative, inorganic particles (quantum dots, quantum rods, quantum tripods, TiO₂, ZnO etc.), conductive particles (Au, Ag etc.), insulator materials like the ones described for the gate dielectric (PET, PS etc.).

Accordingly, the present invention also relates to an organic semiconductor material, layer or component, comprising a polymer according to the present invention.

The polymers of the present invention can be blended with small molecules described, for example, in PCT/EP2010/053655, WO09/047104, US6,690,029, WO2007082584, and WO2008107089:
WO2007082584: 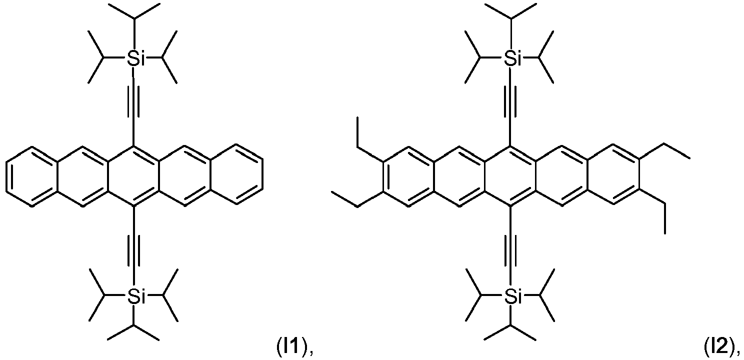 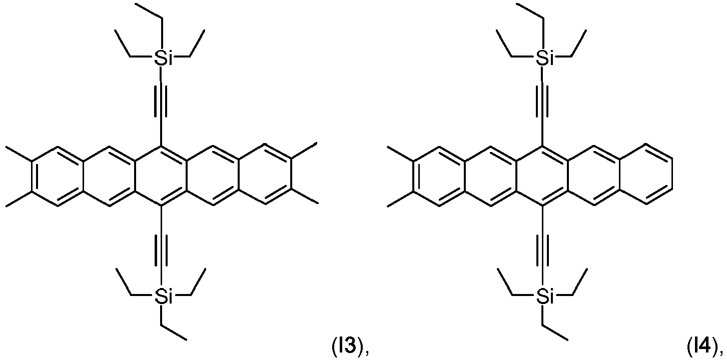 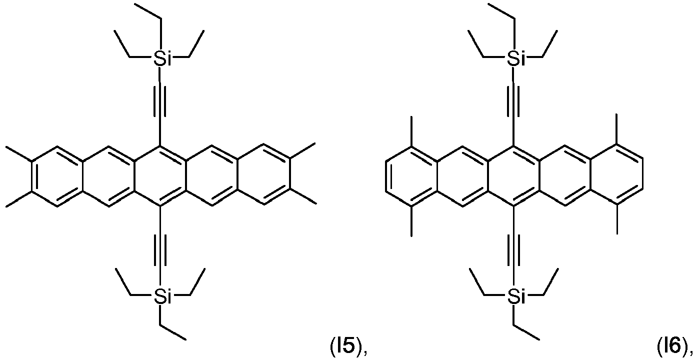 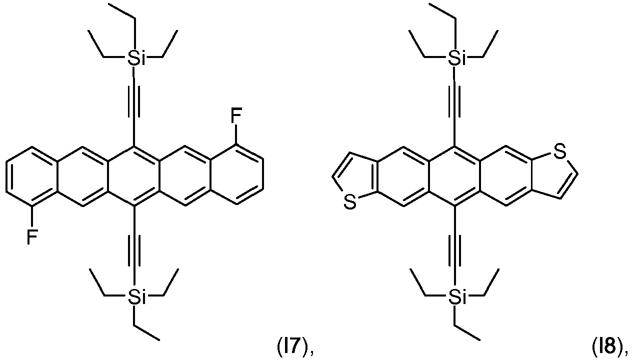 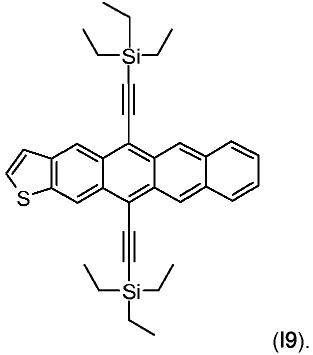
WO2008107089: 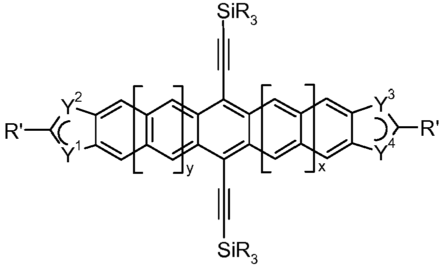 wherein one of Y¹ and Y² denotes -CH= or =CH- and the other denotes -X-,
   one of Y³ and Y⁴ denotes -CH= or =CH- and the other denotes -X-,
   X is -O-, -S-, -Se- or -NR'''-,
   R is cyclic, straight-chain or branched alkyl or alkoxy having 1 to 20 C-atoms, or aryl having 2-30 C-atoms, all of which are optionally fluorinated or perfluorinated,
   R' is H, F, Cl, Br, I, CN, straight-chain or branched alkyl or alkoxy having 1 to 20 C-atoms and optionally being fluorinated or perfluorinated, optionally fluorinated or perfluorinated aryl having 6 to 30 C-atoms, or CO₂R", with R" being H, optionally fluorinated alkyl having 1 to 20 C-atoms, or optionally fluorinated aryl having 2 to 30 C-atoms,
   R''' is H or cyclic, straight-chain or branched alkyl with 1 to 10 C-atoms, y is 0, or 1, x is 0, or 1.

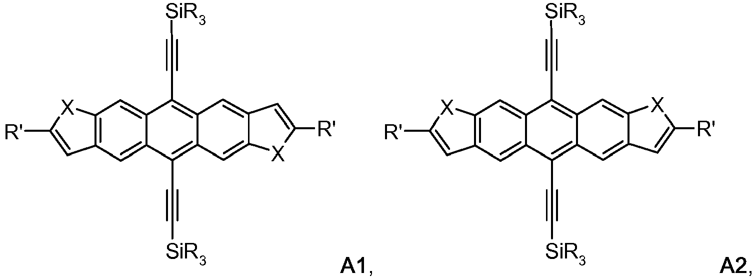

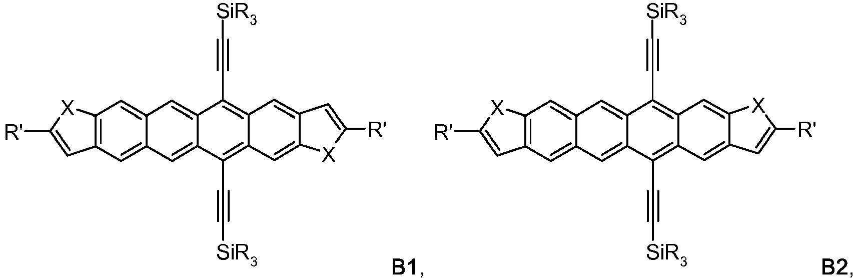

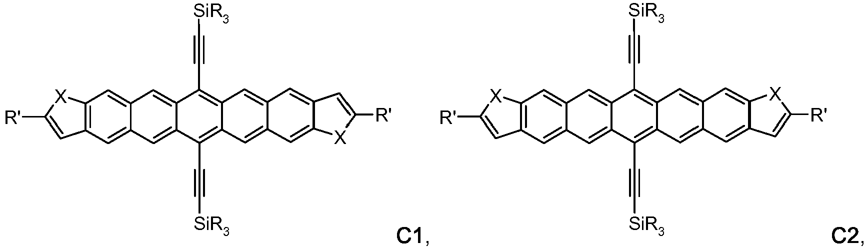

The polymer can contain a small molecule, or a mixture of two, or more small molecule compounds.

The polymers of the invention according to the present invention can be used as the semiconductor layer in semiconductor devices. Accordingly, the present invention also relates to semiconductor devices, comprising a polymer of the present invention, or an organic semiconductor material, layer or component. The semiconductor device is especially an organic photovoltaic (PV) device (solar cell), a photodiode, or an organic field effect transistor.

There are numerous types of semiconductor devices. Common to all is the presence of one or more semiconductor materials. Semiconductor devices have been described, for example, by S. M. Sze in Physics of Semiconductor Devices, 2nd edition, John Wiley and Sons, New York (1981). Such devices include rectifiers, transistors (of which there are many types, including p-n-p, n-p-n, and thin-film transistors), light emitting semiconductor devices (for example, organic light emitting diodes in display applications or backlight in e.g. liquid crystal displays), photoconductors, current limiters, solar cells, thermistors, p-n junctions, field-effect diodes, Schottky diodes, and so forth. In each semiconductor device, the semiconductor material is combined with one or more metals, metal oxides, such as, for example, indium tin oxide (ITO), and/or insulators to form the device. Semiconductor devices can be prepared or manufactured by known methods such as, for example, those described by Peter Van Zant in Microchip Fabrication, Fourth Edition, McGraw-Hill, New York (2000). In particular, organic electronic components can be manufactured as described by D.R. Gamota et al. in Printed Organic and Molecular Electronics, Kluver Academic Publ., Boston, 2004.

A particularly useful type of transistor device, the thin-film transistor (TFT), generally includes a gate electrode, a gate dielectric on the gate electrode, a source electrode and a drain electrode adjacent to the gate dielectric, and a semiconductor layer adjacent to the gate dielectric and adjacent to the source and drain electrodes (see, for example, S. M. Sze, Physics of Semiconductor Devices, 2nd edition, John Wiley and Sons, page 492, New York (1981)). These components can be assembled in a variety of configurations. More specifically, an OFET has an organic semiconductor layer.

Typically, a substrate supports the OFET during manufacturing, testing, and/or use. Optionally, the substrate can provide an electrical function for the OFET. Useful substrate materials include organic and inorganic materials. For example, the substrate can comprise silicon materials inclusive of various appropriate forms of silicon, inorganic glasses, ceramic foils, polymeric materials (for example, acrylics, polyester, epoxies, polyamides, polycarbonates, polyimides, polyketones, poly(oxy-1,4-phenyleneoxy-1,4-phenylenecarbonyl-1,4-phenylene) (sometimes referred to as poly(ether ether ketone) or PEEK), polynorbornenes, polyphenyleneoxides, poly(ethylene naphthalenedicarboxylate) (PEN), poly(ethylene terephthalate) (PET), poly(phenylene sulfide) (PPS)), filled polymeric materials (for example, fiber-reinforced plastics (FRP)), and coated metallic foils.

The gate electrode can be any useful conductive material. For example, the gate electrode can comprise doped silicon, or a metal, such as aluminum, chromium, gold, silver, nickel, palladium, platinum, tantalum, and titanium. Conductive oxides, such as indium tin oxide, or conducting inks/pastes comprised of carbon black/graphite or colloidal silver dispersions, optionally containing polymer binders can also be used. Conductive polymers also can be used, for example polyaniline or poly(3,4-ethylenedioxythiophene)/poly(styrene sulfonate) (PEDOT:PSS). In addition, alloys, combinations, and multilayers of these materials can be useful. In some OFETs, the same material can provide the gate electrode function and also provide the support function of the substrate. For example, doped silicon can function as the gate electrode and support the OFET.

The gate dielectric is generally provided on the gate electrode. This gate dielectric electrically insulates the gate electrode from the balance of the OFET device. Useful materials for the gate dielectric can comprise, for example, an inorganic electrically insulating material.

The gate dielectric (insulator) can be a material, such as, an oxide, nitride, or it can be a material selected from the family of ferroelectric insulators (e.g. organic materials such as poly(vinylidene fluoride/trifluoroethylene or poly(m-xylylene adipamide)), or it can be an organic polymeric insulator (e.g. poly(methacrylate)s, poly(acrylate)s, polyimides, benzocyclobutenes (BCBs), parylenes, polyvinylalcohol, polyvinylphenol (PVP), polystyrenes, polyester, polycarbonates) as for example described in J. Veres et al. Chem. Mat. 2004, 16, 4543 or A. Facchetti et al. Adv. Mat. 2005, 17, 1705. Specific examples of materials useful for the gate dielectric include strontiates, tantalates, titanates, zirconates, aluminum oxides, silicon oxides, tantalum oxides, titanium oxides, silicon nitrides, barium titanate, barium strontium titanate, barium zirconate titanate, zinc selenide, and zinc sulphide, including but not limited to PbZrₓTi₁₋ₓO₃ (PZT), Bi₄Ti₃O₁₂, BaMgF₄, Ba(Zr₁₋ₓTiₓ)O₃ (BZT). In addition, alloys, hybride materials (e.g. polysiloxanes or nanoparticle-filled polymers) combinations, and multilayers of these materials can be used for the gate dielectric. The thickness of the dielectric layer is, for example, from about 10 to 1000 nm, with a more specific thickness being about 100 to 500 nm, providing a capacitance in the range of 0.1 - 100 nanofarads (nF).

The source electrode and drain electrode are separated from the gate electrode by the gate dielectric, while the organic semiconductor layer can be over or under the source electrode and drain electrode. The source and drain electrodes can be any useful conductive material favourably providing a low resistance ohmic contact to the semiconductor layer. Useful materials include most of those materials described above for the gate electrode, for example, aluminum, barium, calcium, chromium, gold, silver, nickel, palladium, platinum, titanium, polyaniline, PEDOT:PSS, other conducting polymers, alloys thereof, combinations thereof, and multilayers thereof. Some of these materials are appropriate for use with n-type semiconductor materials and others are appropriate for use with p-type semiconductor materials, as is known in the art.

The thin film electrodes (that is, the gate electrode, the source electrode, and the drain electrode) can be provided by any useful means such as physical vapor deposition (for example, thermal evaporation or sputtering) or (ink jet) printing methods. The patterning of these electrodes can be accomplished by known methods such as shadow masking, additive photolithography, subtractive photolithography, printing, microcontact printing, and pattern coating.

The present invention further provides an organic field effect transistor device comprising
a plurality of electrically conducting gate electrodes disposed on a substrate;
a gate insulator layer disposed on said electrically conducting gate electrodes;
a plurality of sets of electrically conductive source and drain electrodes disposed on said insulator layer such that each of said sets is in alignment with each of said gate electrodes; an organic semiconductor layer disposed in the channel between source and drain electrodes on said insulator layer substantially overlapping said gate electrodes; wherein said organic semiconductor layer comprises a polymer of the present invention, or an organic semiconductor material, layer or component.

The present invention further provides a process for preparing a thin film transistor device comprising the steps of:
depositing a plurality of electrically conducting gate electrodes on a substrate;
depositing a gate insulator layer on said electrically conducting gate electrodes;
depositing a plurality of sets of electrically conductive source and drain electrodes on said layer such that each of said sets is in alignment with each of said gate electrodes;
depositing a layer of a polymer of the present invention on said insulator layer such that said layer of the compound of the present invention, or a mixture containing a polymer of the present invention, substantially overlaps said gate electrodes; thereby producing the thin film transistor device.

Alternatively, an OFET is fabricated by, for example, by solution deposition of a polymer on a highly doped silicon substrate covered with a thermally grown oxide layer followed by vacuum deposition and patterning of source and drain electrodes.

In yet another approach, an OFET is fabricated by deposition of source and drain electrodes on a highly doped silicon substrate covered with a thermally grown oxide and then solution deposition of the polymer to form a thin film.

The gate electrode could also be a patterned metal gate electrode on a substrate or a conducting material such as, a conducting polymer, which is then coated with an insulator applied either by solution coating or by vacuum deposition on the patterned gate electrodes.

Any suitable solvent can be used to dissolve, and/or disperse the polymers of the present application, provided it is inert and can be removed partly, or completely from the substrate by conventional drying means (e.g. application of heat, reduced pressure, airflow etc.). Suitable organic solvents for processing the semiconductors of the invention include, but are not limited to, aromatic or aliphatic hydrocarbons, halogenated such as chlorinated or fluorinated hydrocarbons, esters, ethers amides, such as chloroform, tetrachloroethane, tetrahydrofuran, toluene, tetraline, decaline, anisole, xylene, ethyl acetate, methyl ethyl ketone, dimethyl formamide, chloroform, chlorobenzene, dichlorobenzene, trichlorobenzene, propylene glycol monomethyl ether acetate (PGMEA) and mixtures thereof. Preferred solvents are xylene, toluene, tetraline, decaline, chlorinated ones such as chloroform, chlorobenzene, ortho-dichlorobenzene, trichlorobenzene and mixtures thereof. The solution, and/or dispersion is then applied by a method, such as, spin-coating, dip-coating, screen printing, microcontact printing, doctor blading or other solution application techniques known in the art on the substrate to obtain thin films of the semiconducting material.

The term "dispersion" covers any composition comprising the semiconductor material of the present invention, which is not fully dissolved in a solvent. The dispersion can be done selecting a composition including at least a polymer of the present invention, or a mixture containing a polymer of the present invention, and a solvent, wherein the polymer exhibits lower solubility in the solvent at room temperature but exhibits greater solubility in the solvent at an elevated temperature, wherein the composition gels when the elevated temperature is lowered to a first lower temperature without agitation;
- dissolving at the elevated temperature at least a portion of the polymer in the solvent; lowering the temperature of the composition from the elevated temperature to the first lower temperature; agitating the composition to disrupt any gelling, wherein the agitating commences at any time prior to, simultaneous with, or subsequent to the lowering the elevated temperature of the composition to the first lower temperature; depositing a layer of the composition wherein the composition is at a second lower temperature lower than the elevated temperature; and drying at least partially the layer.

The dispersion can also be constituted of (a) a continuous phase comprising a solvent, a binder resin, and optionally a dispersing agent, and (b) a disperse phase comprising a polymer of the present invention, or a mixture containing a polymer of the present invention. The degree of solubility of the polymer of the present invention in the solvent may vary for example from 0% to about 20% solubility, particularly from 0% to about 5% solubility.

Preferably, the thickness of the organic semiconductor layer is in the range of from about 5 to about 1000 nm, especially the thickness is in the range of from about 10 to about 100 nm.

The polymers of the invention can be used alone or in combination as the organic semiconductor layer of the semiconductor device. The layer can be provided by any useful means, such as, for example, vapor deposition (for materials with relatively low molecular weight) and printing techniques. The compounds of the invention may be sufficiently soluble in organic solvents and can be solution deposited and patterned (for example, by spin coating, dip coating, ink jet printing, gravure printing, flexo printing, offset printing, screen printing, microcontact (wave)-printing, drop or zone casting, or other known techniques).

The polymers of the invention can be used in integrated circuits comprising a plurality of OTFTs, as well as in various electronic articles. Such articles include, for example, radiofrequency identification (RFID) tags, backplanes for flexible displays (for use in, for example, personal computers, cell phones, or handheld devices), smart cards, memory devices, sensors (e.g. light-, image-, bio-, chemo-, mechanical- or temperature sensors), especially photodiodes, or security devices and the like. Due to its ambi-polarity the material can also be used in Organic Light Emitting Transistors (OLET).

A further aspect of the present invention is an organic semiconductor material, layer or component comprising one or more polymers of the present invention. A further aspect is the use of the polymers or materials of the present invention in an organic photovoltaic (PV) device (solar cell), a photodiode, or an organic field effect transistor (OFET). A further aspect is an organic photovoltaic (PV) device (solar cell), a photodiode, or an organic field effect transistor (OFET) comprising a polymer or material of the present invention.

The polymers of the present invention are typically used as organic semiconductors in form of thin organic layers or films, preferably less than 30 microns thick. Typically the semiconducting layer of the present invention is at most 1 micron (=1 µm) thick, although it may be thicker if required. For various electronic device applications, the thickness may also be less than about 1 micron thick. For example, for use in an OFET the layer thickness may typically be 100 nm or less. The exact thickness of the layer will depend, for example, upon the requirements of the electronic device in which the layer is used.

For example, the active semiconductor channel between the drain and source in an OFET may comprise a layer of the present invention.

An OFET device according to the present invention preferably comprises:
- a source electrode,
- a drain electrode,
- a gate electrode,
- a semiconducting layer,
- one or more gate insulator layers, and
- optionally a substrate, wherein the semiconductor layer comprises one or more polymers of the present invention.

The gate, source and drain electrodes and the insulating and semiconducting layer in the OFET device may be arranged in any sequence, provided that the source and drain electrode are separated from the gate electrode by the insulating layer, the gate electrode and the semiconductor layer both contact the insulating layer, and the source electrode and the drain electrode both contact the semiconducting layer.

Preferably the OFET comprises an insulator having a first side and a second side, a gate electrode located on the first side of the insulator, a layer comprising a polymer of the present invention located on the second side of the insulator, and a drain electrode and a source electrode located on the polymer layer.

The OFET device can be a top gate device or a bottom gate device.

Suitable structures and manufacturing methods of an OFET device are known to the skilled in the art and are described in the literature, for example in WO03/052841.

The gate insulator layer may comprise for example a fluoropolymer, like e.g. the commercially available Cytop 809M®, or Cytop 107M® (from Asahi Glass). Preferably the gate insulator layer is deposited, e.g. by spin-coating, doctor blading, wire bar coating, spray or dip coating or other known methods, from a formulation comprising an insulator material and one or more solvents with one or more fluoro atoms (fluorosolvents), preferably a perfluorosolvent. A suitable perfluorosolvent is e.g. FC75® (available from Acros, catalogue number 12380). Other suitable fluoropolymers and fluorosolvents are known in prior art, like for example the perfluoropolymers Teflon AF® 1600 or 2400 (from DuPont), or Fluoropel® (from Cytonix) or the perfluorosolvent FC 43® (Acros, No. 12377).

The semiconducting layer comprising a polymer of the present invention may additionally comprise at least another material. The other material can be, but is not restricted to another polymer of the present invention, a semi-conducting polymer, a polymeric binder, organic small molecules different from a polymer of the present invention, carbon nanotubes, a fullerene derivative, inorganic particles (quantum dots, quantum rods, quantum tripods, TiO₂, ZnO etc.), conductive particles (Au, Ag etc.), and insulator materials like the ones described for the gate dielectric (PET, PS etc.). As stated above, the semiconductive layer can also be composed of a mixture of one or more polymers of the present invention and a polymeric binder. The ratio of the polymers of the present invention to the polymeric binder can vary from 5 to 95 percent. Preferably, the polymeric binder is a semicristalline polymer such as polystyrene (PS), high-density polyethylene (HDPE), polypropylene (PP) and polymethylmethacrylate (PMMA). With this technique, a degradation of the electrical performance can be avoided (cf. WO2008/001123A1).

The polymers of the present invention are advantageously used in organic photovoltaic (PV) devices (solar cells). Accordingly, the invention provides PV devices comprising a polymer according to the present invention. A device of this construction will also have rectifying properties so may also be termed a photodiode. Photoresponsive devices have application as solar cells which generate electricity from light and as photodetectors which measure or detect light.

The PV device comprise in this order:
(a) a cathode (electrode),
(b) optionally a transition layer, such as an alkali halogenide, especially lithium fluoride,
(c) a photoactive layer,
(d) optionally a smoothing layer,
(e) an anode (electrode),
(f) a substrate.

The photoactive layer comprises the polymers of the present invention. Preferably, the photoactive layer is made of a conjugated polymer of the present invention, as an electron donor and an acceptor material, like a fullerene, particularly a functionalized fullerene PCBM, as an electron acceptor. For heterojunction solar cells the active layer comprises preferably a mixture of a polymer of the present invention and a fullerene, such as [60]PCBM (= 6,6-phenyl-C₆₁-butyric acid methyl ester), or [70]PCBM, in a weight ratio of 1:1 to 1:3.

The fullerenes useful in this invention may have a broad range of sizes (number of carbon atoms per molecule). The term fullerene as used herein includes various cage-like molecules of pure carbon, including Buckminsterfullerene (C₆₀) and the related "spherical" fullerenes as well as carbon nanotubes. Fullerenes may be selected from those known in the art ranging from, for example, C₂₀-C₁₀₀₀. Preferably, the fullerene is selected from the range of C₆₀ to C₉₆. Most preferably the fullerene is C₆₀ or C₇₀, such as [60]PCBM, or [70]PCBM. It is also permissible to utilize chemically modified fullerenes, provided that the modified fullerene retains acceptor-type and electron mobility characteristics. The acceptor material can also be a material selected from the group consisting of any semi-conducting polymer, such as, for example, a polymer of the present invention, provided that the polymers retain acceptor-type and electron mobility characteristics, organic small molecules, carbon nanotubes, inorganic particles (quantum dots, quantum rods, quantum tripods, TiO₂, ZnO etc.).

The photoactive layer is made of a polymer of the present invention as an electron donor and a fullerene, particularly functionalized fullerene PCBM, as an electron acceptor. These two components are mixed with a solvent and applied as a solution onto the smoothing layer by, for example, the spin-coating method, the drop casting method, the Langmuir-Blodgett ("LB") method, the ink jet printing method and the dripping method. A squeegee or printing method could also be used to coat larger surfaces with such a photoactive layer. Instead of toluene, which is typical, a dispersion agent such as chlorobenzene is preferably used as a solvent. Among these methods, the vacuum deposition method, the spin-coating method, the ink jet printing method and the casting method are particularly preferred in view of ease of operation and cost.

In the case of forming the layer by using the spin-coating method, the casting method and ink jet printing method, the coating can be carried out using a solution and/or dispersion prepared by dissolving, or dispersing the composition in a concentration of from 0.01 to 90% by weight in an appropriate organic solvent such as benzene, toluene, xylene, tetrahydrofurane, methyltetrahydrofurane, N,N-dimethylformamide, acetone, acetonitrile, anisole, dichloromethane, dimethylsulfoxide, chlorobenzene, 1,2-dichlorobenzene and mixtures thereof.

The photovoltaic (PV) device can also consist of multiple junction solar cells that are processed on top of each other in order to absorb more of the solar spectrum. Such structures are, for example, described in App. Phys. Let. 90, 143512 (2007), Adv. Funct. Mater. 16, 1897-1903 (2006) and WO2004/112161.

A so called 'tandem solar cell' comprise in this order:
(a) a cathode (electrode),
(b) optionally a transition layer, such as an alkali halogenide, especially lithium fluoride,
(c) a photoactive layer,
(d) optionally a smoothing layer,
(e) a middle electrode (such as Au, Al, ZnO, TiO₂ etc.)
(f) optionally an extra electrode to match the energy level,
(g) optionally a transition layer, such as an alkali halogenide, especially lithium fluoride,
(h) a photoactive layer,
(i) optionally a smoothing layer,
(j) an anode (electrode),
(k) a substrate.

The PV device can also be processed on a fiber as described, for example, in US20070079867 and US 20060013549.

Due to their excellent self-organising properties the materials or films comprising the polymers of the present invention can also be used alone or together with other materials in or as alignment layers in LCD or OLED devices, as described for example in US2003/0021913.

The following examples are included for illustrative purposes only and do not limit the scope of the claims. Unless otherwise stated, all parts and percentages are by weight. Weight-average molecular weight (Mw) and polydispersity (Mw/Mn = PD) are determined by High Temperature Gel Permeation Chromatography (HT-GPC) [Apparatus: GPC PL 220 from Polymer laboratories (Church Stretton, UK; now Varian) yielding the responses from refractive index (RI), Chromatographic conditions: Column: 3 "PLgel Olexis" column from Polymer Laboratories (Church Stretton, UK); with an average particle size of 13 µm (dimensions 300 x 8 mm I.D.) Mobile phase: 1,2,4-trichlorobenzene purified by vacuum distillation and stabilised by butylhydroxytoluene (BHT, 200 mg/l), Chromatographic temperature: 150°C; Mobile phase flow: 1 ml/min; Solute concentration: about 1 mg/ml; Injection volume: 200 µl; Detection: RI, Procedure of molecular weight calibration: Relative calibration is done by use of a set of 10 polystyrene calibration standards obtained from Polymer Laboratories (Church Stretton, UK) spanning the molecular weight range from 1'930'000 Da - 5'050 Da, i. e., PS 1'930'000, PS 1'460'000, PS 1'075'000, PS 560'000, PS 330'000, PS 96'000, PS 52'000, PS 30'300, PS 10'100, PS 5'050 Da. A polynomic calibration is used to calculate the molecular weight.
All polymer structures given in the examples below are idealized representations of the polymer products obtained via the polymerization procedures described. If more than two components are copolymerized with each other sequences in the polymers can be either alternating or random depending on the polymerisation conditions.

### Examples

### Reference Example 1: Synthesis of polymer 2

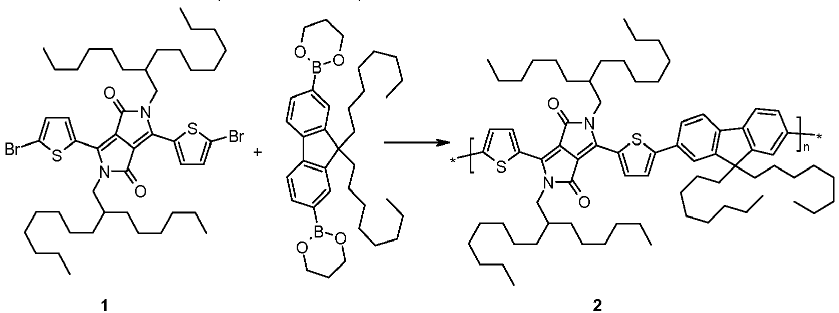

The starting material 1 is prepared according to Example 2a of WO2008000664. In a three neck-flask, 0.71 g of potassium phosphate (K₃PO₄) dissolved in 2.1 ml of water (previously degassed with argon) is added to a degassed solution of 1.00 g of 1, 0.63 g of 9,9-dioctylfluorene-2,7-diboronic acid bis(1,3-propanediol)ester 16.0 mg of tri-tert-butylphosphonium tetrafluoroborate ((t-Bu)₃P ^{∗} HBF₄) and 26.0 mg of tris(dibenzylideneacetone) dipalladium (0) (Pd₂(dba)₃) in 10 ml of tetrahydrofuran. The reaction mixture is heated to 50°C for 13 hours. Subsequently, 18 mg bromo-thiophene and 20 minutes later 23 mg thiophene-boronic acid pinacol ester are added to stop the polymerisation reaction. The reaction mixture is cooled to room temperature and precipitated in methanol. The residue is purified by soxhlet extraction using pentane and the polymer is then extracted with cyclohexane to give 0.96 g of a dark powder. Mw = 27'500, Polydispersity = 2.0 (measured by HT-GPC).

### Reference Example 2: Synthesis of polymer 4

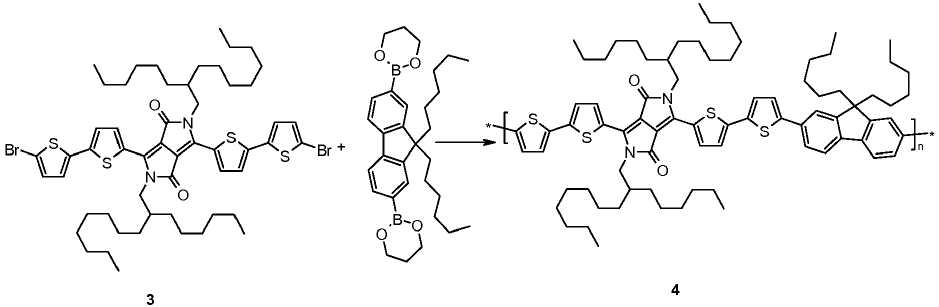

The starting material **3** is prepared according to Example 40b of WO2009047104. According to the procedure for the synthesis of polymer **2,** 9,9-dihexylfluorene-2,7-diboronic acid bis(1,3-propanediol) ester and **3** have been reacted to give polymer **4.** The purification is achieved by soxhlet extraction using diethylether and the polymer is then extracted with THF to give **4** as a dark powder. Mw = 57600, Polydispersity = 2.4 (measured by HT-GPC).

### Reference Example 3: Synthesis of polymer 6

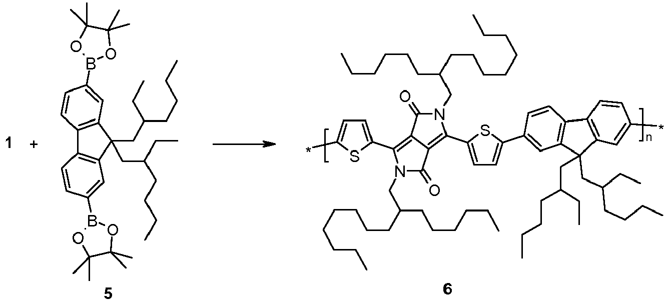

According to the procedure for the synthesis of polymer 2, 9,9-di(2'-ethylhexyl)fluorene-2,7-diboronic acid bispinacol ester (prepared out of 9,9-di(2'-ethylhexyl)fluorene-2,7-diboronic acid by azeotropic refluxing with pinacol in toluene according to Tetrahedron Lett., 2003, 44, 19, 3863-3866) and **1** have been reacted to give polymer 6. The purification is achieved by soxhlet extraction using pentane and the polymer is then extracted with cyclohexane to give **6** as a dark powder. Mw = 71'100, Polydispersity = 1.9 (measured by HT-GPC).

### Reference Example 4: Synthesis of polymer 7

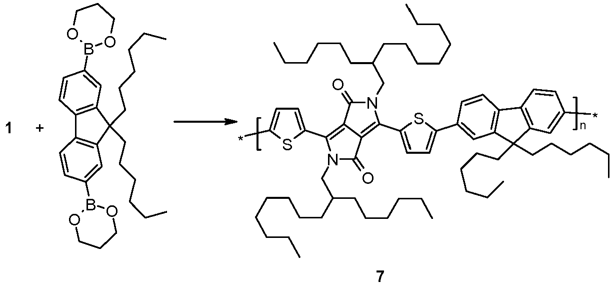

According to the procedure for the synthesis of polymer **2,** 9,9-dihexylfluorene-2,7-diboronic acid bis(1,3-propanediol) ester and **1** have been reacted to give polymer **7.** The purification is achieved by soxhlet extraction using pentane and the polymer is then extracted with cyclohexane to give **7** as a dark powder. Mw = 27'700, Polydispersity = 2.1 (measured by HT-GPC).

### Reference Example 5: Synthesis of polymer 9

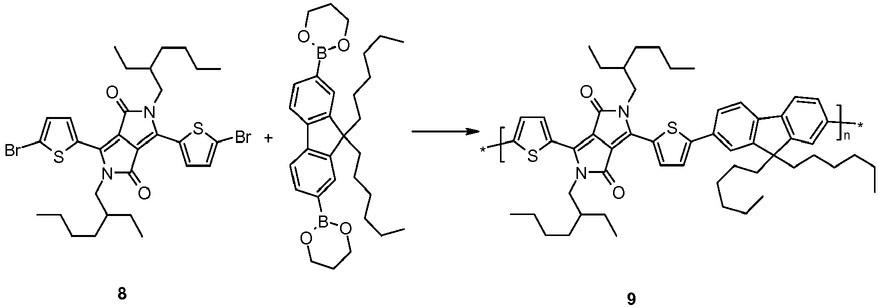

The starting material **8** is prepared according to Example 1a of WO2008000664. According to the procedure for the synthesis of polymer **2,** 9,9-dihexylfluorene-2,7-diboronic acid bis(1,3-propanediol) ester and **8** have been reacted to give polymer **9.** The purification is achieved by soxhlet extraction using diethylether and cyclohexane and the polymer is then extracted with chloroform to give **9** as a dark powder. Mw = 38000, Polydispersity = 2.4 (measured by HT-GPC).

### Reference Example 6: Synthesis of polymer 11

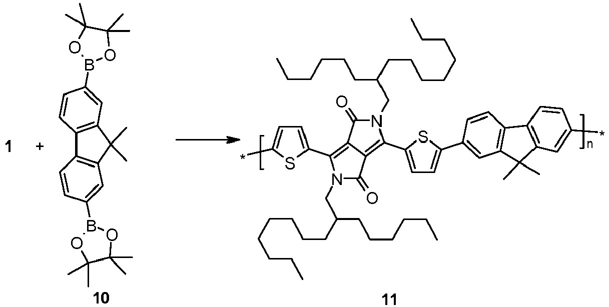

According to the procedure for the synthesis of polymer **2,** 9,9-dimethylfluorene-2,7-diboronic acid bispinacol ester (10, prepared according to J. Mat. Chem., 2004, 14, 17, 2622-2626) and **1** have been reacted to give polymer 11. The purification is achieved by soxhlet extraction using pentane, cyclohexane and THF the polymer is then extracted with chloroform to give **11** as a dark powder. Mw = 98200, Polydispersity = 2.4 (measured by HT-GPC).

### Reference Example 7: Synthesis of polymer 13

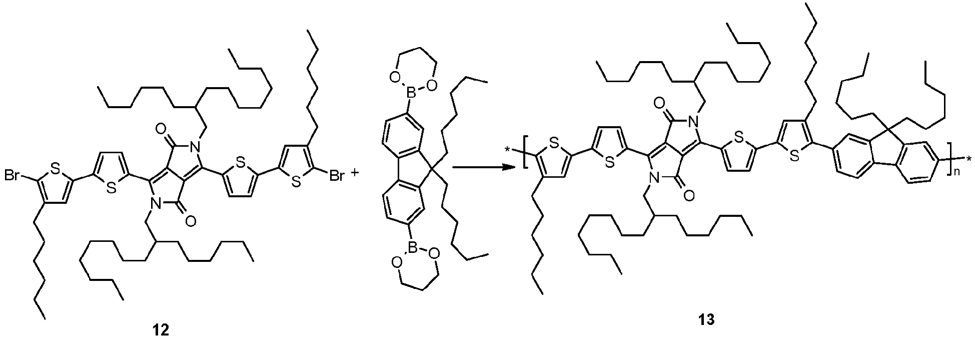

The starting material **12** is prepared according to Example 1a of WO2008000664. According to the procedure for the synthesis of polymer 2, 9,9-dihexylfluorene-2,7-diboronic acid bis(1,3-propanediol) ester and **12** have been reacted to give polymer **13.** The purification is achieved by soxhlet extraction using methanol and the polymer is then extracted with pentane to give **13** as a dark powder. Mw = 19800, Polydispersity = 2.6 (measured by HT-GPC).

### Reference Example 8: Synthesis of polymer 16

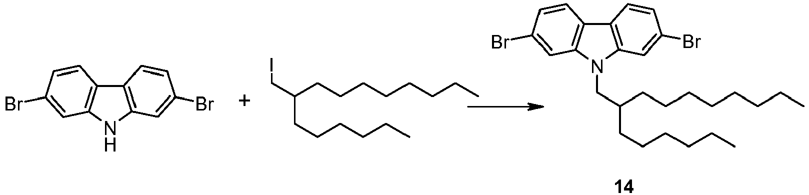

a) 7.02g of 2,7-dibromocarbazole and 1.04g sodium hydride were added to 70ml of dimethylformamide at room temperature and then heated to 50°C for 1h. Then the reaction mixture was cooled to room temperature and 11.41g 2-hexyl-1-decyl iodide were added. The reaction mixture was stirred for 5 hours and then diluted with water and the product was extracted with methylene chloride. The organic phase was dried and evaporated and the product was purified by column chromatography over silica gel.
   ¹H-NMR data (ppm, CDCl₃): 7.91 2H d, 7.52 2H s, 7.35 2H d, 4.06 2H d, 2.10 1H m, 1.31-1.24 24H m, 0.90 3H t, 0.88 3H t; 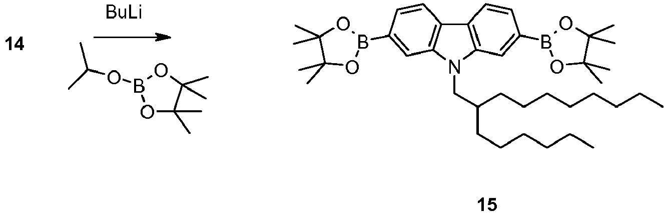
b) 7.36g of **14** was dissolved in 250ml tetrahydrofuran and the solution was cooled to - 78°C. Then 10.17ml of 2.7M buthyllithium in hexane was added and the solution stirred for 1 hour. Then 5.5g of 2-Isopropoxy-4,4,5,5-tetramethyl-1,3,2-dioxaborolane were added dropwise and the mixture was stirred another 1 hour before the temperature was rised to room temperature. The reaction mixture was poured on ice and then extracted with tert-butyl-methylether. The organic phase was dried and evaporated and the product was purified by column chromatography over silica gel.
   ¹H-NMR data (ppm, CDCl₃): 8.16 2H d, 7.94 2H s, 7.72 2H d, 4.30 2H d, 2.25 1H m, 1.44 24H s, 1.31-1.24 24H m, 0.92 3H t, 0.90 3H t;

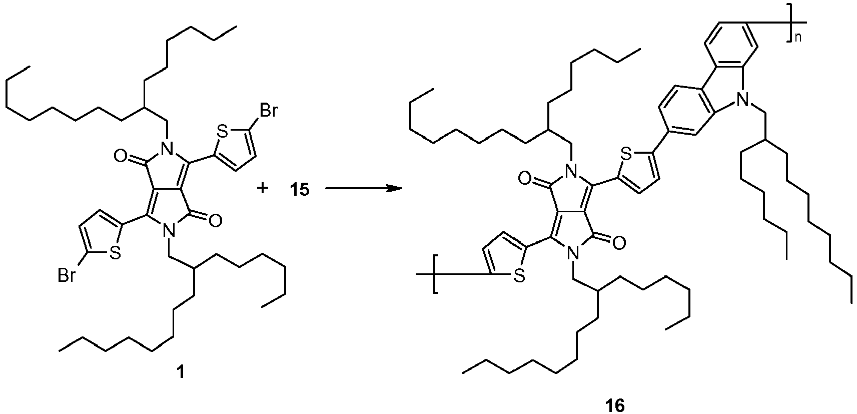

Under Argon 1.41g of **1,** 1.00g of compound **15,** 26mg of Pd(acetate)₂, 22mg of 2-(di-tert-butyl-phosphino)-1-phenyl-pyrrole were mixed with 60ml of tetrahydrofuran and warmed to 40°C. Then a solution of 0.644g potassium carbonate in 14ml of degassed water was added to the reaction mixture. The reaction mixture was then brought to reflux for 4 hours and cooled to room temperature. The green-blue mixture was precipitated with methanol and filtered. The filtrate was dissolved in chloroform and refluxed with a 1% NaCN water solution for 3 hours. The organic phase was washed with water and then dried and evaporated. The polymer was precipitated with methanol and the precipitate was fractionated in a Soxhlet with hexane, then toluene. The toluene fraction contained the desired polymer. Mw = 86'500, Polydispersity = 2.15 (measured by HT-GPC).

### Reference Example 9: Synthesis of polymer 19

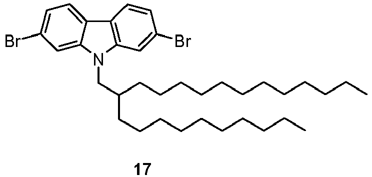

a) Compound **17** was synthesized according to compound **14** starting from 2,7-dibromocarbazole and 2-decyl-1-tetradecyliodide.
   ¹H-NMR data (ppm, CDCl₃): 7.81 2H d, 7.44 2H s, 7.29 2H d, 3.96 2H d, 2.03 1H m, 1.25-1.20 40H m, 0.88 6H t; 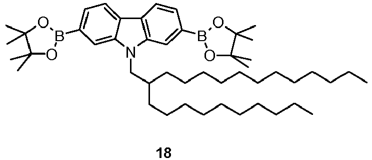
b) Compound **18** was synthesized according to compound **15** starting from compound **17.** ¹H-NMR data (ppm, CDCl₃): 8.15 2H d, 7.93 2H s, 7.71 2H d, 4.29 2H d, 2.25 1H m, 1.44 24H s, 1.31-1.20 40H m, 0.92 6H t;

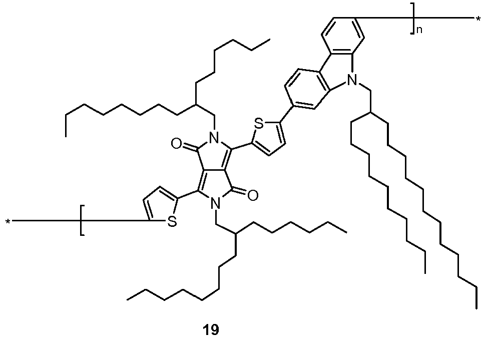

Compound **19** was synthesized according to compound **16** starting from compound **18** and the thiophene-diketopyrrolopyrrol **1.** Mw = 64'500, Polydispersity = 2.22 (measured by HT-GPC).

### Example 10: Synthesis of building block 21

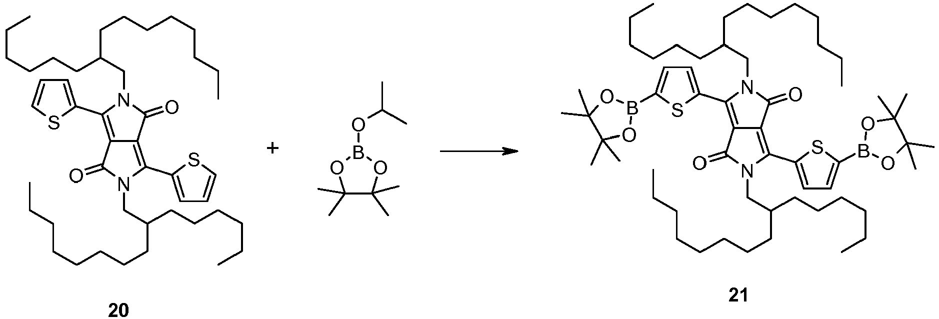

To a solution of 5.0 g Dithienyl-DPP **(20)** and 3.73 g 2-Isopropoxy-4,4,5,5-tetramethyl-1,3,2-dioxoborolane in 30 ml THF under nitrogen at -25 °C is added drop-wise a freshly prepared LDA solution (from 5.4 ml butyllithium 2.7 M and 2.2 ml diisopropylamin in 20 ml THF,) over 15 minutes. The resulting reaction mixture is stirred for 1 hour at 0 °C and then quenched with 100 ml 1 M HCI. The product is extracted with 2 x 50 ml TBME and the combined organic layers are washed twice with brine and dried with sodium sulfate. After evaporation of the solvent the residue is dissolved in 20 ml methylenchloride and then slowly added to 200 ml of heavily stirred acetone. The precipitate is collected by filtration, washed several times with acetone and dried at 40 °C in a vacuum-oven, affording 6.3 g of pinkish-violet powder.

### Example 11: Synthesis of building block 26

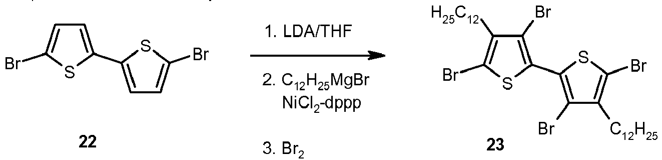

a) A solution of 40 g of **22** in 200 ml of dry tetrahydrofuran (THF) is added rapidly to a solution of lithium diisopropylamide (LDA, prepared from 100 ml of 2.7 M solution of butyllithium in hexane and 28.8 g diisopropylamine in 200 ml of dry THF) at -70 °C under nitrogen atmosphere. After the colour of the mixture has become orange-brown, the mixture is allowed to warm to -20 °C and then 100 ml of water are added. The organic phase is separated, washed with brine, dried and evaporated. The residue is recrystallized from methanol to obtain 36.5 g of 4,4'-dibromo-2,2'-dithiophene as an off-white powder (yield: 91.2%).
   A solution of n-dodecyl magnesium bromide in ether (prepared from 9 g of magnesium turnings and 87.0 g n-dodecylbromide in 200 ml of diethylether) is slowly added to a solution of 40 g of 4,4'-dibromo-2,2'-dithiophene. 1 mol% NiCl₂(dppp) (dppp = Ph₂PCH₂Ch₂CH₂PPh₂) in 200 ml of diethylether is added in such a way, that the internal temperature does not exceed 20 °C. Then the mixture is stirred at room temperature for 2 hours and 200 ml of water are added thereto. The organic phase is separated, washed with diluted hydrochloric acid and brine, dried and evaporated. The residue is suspended in methanol and 55.8 g of 4,4'-n-didodecyl-2,2-dithiophene is obtained as a beige powder by filtation (yield: 70%).
   12.8 g of bromine are added dropwise to a solution of 10.1 g 4,4'-n-didodecyl-2,2-dithiophene in 100 ml chloroform and 40 ml acetic acid at 0 °C under nitrogen atmosphere. The mixture is heated at 60 °C for 16 hours. After cooling to room temperature the mixture is treated with 50 ml of a saturated solution of sodium sulfite. The organic phase is separated, washed with a saturated aqueous solution of sodium hydrogen carbonate and brine, dried and evaporated. The residue is suspended in methanol and 14.5 g of 23 is obtained as a beige powder by filtration. ¹H-NMR: δ (ppm) 0.89 (t, 6H), 1.27 (m, 36 H (18xCH₂)), 1.56 (m, 4H), 2.67 (dd, 4H); ¹³C-NMR: δ (ppm) 14.51 (CH₃), 23.08 (CH₂), 28.93-32.31 (9xCH₂), 111.28 (C5), 114.82 (C3), 128.80 (C4), 141.68 (C2) 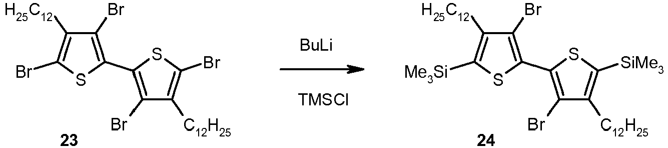
b) 10 g of **23** are dissolved in 150 ml dry THF and 70 ml heptane under nitrogen atmosphere and the solution is cooled to -20 °C. After adding of 9.5 ml of a 2.7 M solution of butyllithium in heptane the obtained solution is stirred at -20°C for 1 hour, 3 ml of trimethylsilyl chloride (TMSCI) is added thereto, the resulting mixture is stirred at -20 ° for 15 minutes and then allowed to warm to room temperature. After stirring for an additional hour 50 ml of water are added. The organic phase is separated, washed with brine, dried and evaporated to obtain 9.9 g of **24** as an orange-brown semisolid residue (yield: 100%). 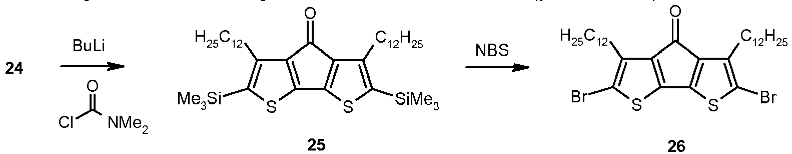
c) Intermediate **24** is dissolved in 500 ml of dry THF under nitrogen atmosphere and the solution is cooled to -60 °C. A 2.7 M solution of BuLi in heptane are added at once and the mixture is allowed to warm to -30 °C followed by addition of 11.5 ml dimethylcarbamyl chloride. After stirring at -20 °C for 15 minutes the mixture is allowed to warm to 0 °C and 100 ml of water are added thereto. The organic phase is separated, washed with brine, dried and evaporated to obtain **25** as a red residue (yield: 58%). ¹H-NMR: δ (ppm) 0.35 (s, 18 H), 0.90 (t, 6H), 1.28 (m, 36 H (18xCH2)), 1.61 (m, 4H), 2.69 (dd, 4H); ¹³C-NMR: δ (ppm) 0.00 (TMS), 13.72 (CH₃), 22.23 (CH2), 28.95-31.52 (9xCH₂), 136.45, 142.98, 146.82, 152.40, 183.66
d) For the further reaction to **26**, it is not necessary to isolate **25.** The organic phase of c) is separated and washed with brine. 37.4 g of N-bromosuccinimide (NBS) are added thereto at 0 °C, the mixture is stirred at 0 °C for 30 minutes and at room temperature for an additional hour. After evaporation the residue is washed with water and suspended in 200 ml of methanol. The mixture is heated under reflux for 1 hour and after cooling to room temperature. The product **26** is obtained as dark-violett flakes by filtation (yield: 55%).
   ¹H-NMR: δ (ppm) 0.88 (t, 6H), 1.26 (m, 36 H (18xCH₂)), 1.59 (m, 4H), 2.57 (dd, 4H) ¹³C-NMR: δ (ppm) 14.50 (CH₃), 23.09 (CH₂), 29.40-32.31 (9xCH₂), 111.10 (C-Br), 137.31, 139.78, 147.35, 182.13.

### Example 12: Synthesis of building block 27

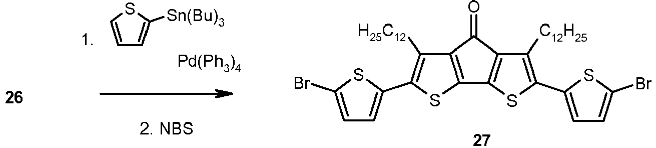

0.94 g of tetrakistriphenylphosphino palladium are added to a degassed solution of 11.13 g of **26** and 15.1 g of 2-(tributyltin)-thiophene in 100 ml of toluene and the mixture is heated under reflux for 16 h, cooled to room temperature and filtered through silica gel. The filtrate is evaporated, the residue is suspended in 100 ml of methanol, stirred for 1 hour and 10.5 g of the 3,5-didodecyl-2,6-di(thien-2-yl)-cyclopenta[2,1-b;3,4-b']dithiophen-4-one are obtained as dark-bluish solid by filtration (yield: 95%). ¹H-NMR: δ (ppm) 0.93 (t, 6H), 1.32 (m, 36 H (18xCH₂)), 1.65 (m, 4H), 2.83 (dd, 4H), 7.06 (m, 2H), 7.10 (m. 2H), 7.32 (dd, 2H). ¹³C-NMR: δ (ppm) 14.51 (CH₃), 23.08 (CH2), 28.60-32.31 (9xCH₂), 126.02, 126.32, 127.68, 134.15, 135.32, 141.04, 146.84, 184.20 (C=O)

11.15 g of the preceding product are dissolved in 100 ml of THF and the solution is cooled to 0 °C. 5.7 g NBS are added thereto, and the resulting mixture is stirred at 0 °C for 30 minutes and at room temperature for an additional hour. The solvent is evaporated, the residue is suspended in methanol and 13.0 g of **27** are obtained as dark-bluish solid by filtration (yield: 95%).

### Example 13: Synthesis of building block 28

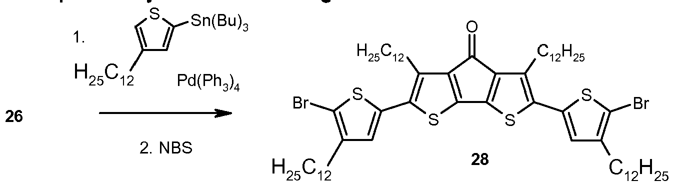

Using 4-dodecyl-2-(tributyltin)-thiophene, the corresponding dialkylated variants **28** are obtained in an analogous procedure. ¹H-NMR: δ (ppm) 0.85 (2xt, 12H), 1.1-1.4 (m, 40 H), 1.59 (m, 8H), 2.48 (dd, 8H), 7.77 (s, 2H)

### Example 14: Synthesis of building block 30

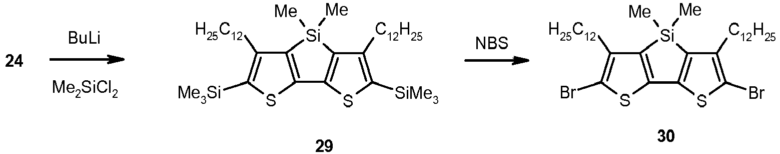

a) A solution of **24** in 150 ml of dry THF is cooled to -40 °C. 16 ml of a 2.7 M solution of BuLi in heptane are added and the resulting solution is stirred at -20 °C for 15 minutes. 2.58 g of dimethyl dichloro silane are added thereto and the mixture is stirred at 0 °C for 30 minutes and at room temperature for an additional hour followed by adding of 50 ml of 1 N hydrochloric acid. The organic phase is separated, washed with brine, dried and evaporated to obtain **29** as colourless liquid (yield: 95%).
b) Bromination using NBS in analogy to the method shown in example 11d yields **30.**

### Example 15: Synthesis of building block 31

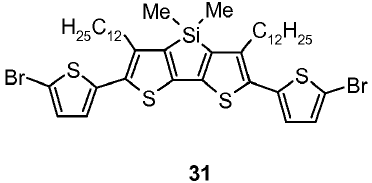

The same reaction sequence shown in example 12, but using the starting material **30** yielding in **31:**
⁴¹H-NMR: δ (ppm) 0.40 (s, 6H), 0.78 (t, 6H), 1.1 - 1.3 (m, 36H), 1.45 (m, 4H), 2.61 (dd, 4H), 6.73 (d, 2H), 6.87 (d, 2H) ¹³C-NMR: δ (ppm) 0.00, 17.20, 25.77, 31-38 (tot. 20 C), 114.40, 127.95, 133.05, 133.50, 140.71, 147.83, 148.19, 149.58

### Example 16: Synthesis of building block 32

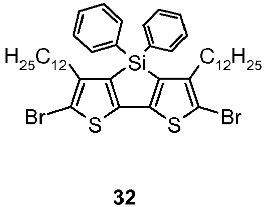

The same reaction sequence shown in example 14, but replacing dimethyl dichloro silane with the equivalent amount of diphenyl dichloro silane, gives **32** in 90 % overall yield. ¹³C-NMR: δ (ppm) 0.02, 17.30, 25.89, 31-38 (tot. 20 C), 111.186, 144.48, 147.95, 150.01

### Example 17: Synthesis of building block 33

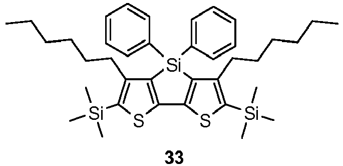

In an analogous process (example 14 and 16), compound **33** can be synthesized.
¹H-NMR: δ (ppm) 0.34 (s, 18 H), 0.87 (t, 6H), 1.1-1.4 (m, 16H), 2.41 (dd, 4H), 7.3-7.4 (m, 8H), 7.65 (m, 2H). ¹³C-NMR: δ (ppm) 0.00, 14.72, 23.15, 28.72, 29.31, 29.89, 31.56, 129.84, 135.02, 136.01, 141.08, 141.41, 155.18

### Example 18: Synthesis of building block 35

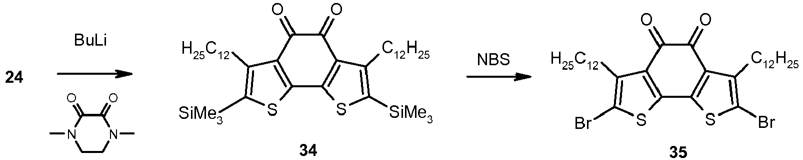

a) **34** is obtained as red powder (yield: 40%) according to example 12 with the exception that 3.20 g of 1,4-dimethylpiperazine-2,3-dione are used instead of dichlorodimethylsilane. ¹H-NMR: δ (ppm) 0.00 (s, 18H), 0.87 (t, 6H), 1.24 (m, 36 H (18xCH₂)), 1.62 (m, 4H), 2.57 (dd, 4H). ¹³C-NMR: δ (ppm) 0.00 (TMS), 13.79 (CH₃), 21.97 (CH2), 28.63-31.72 (10xCH₂), 136.45, 142.98, 146.82, 152.40, 174.83
b) Bromination using NBS in analogy to the method shown in example 11d yields **35.**

### Example 19: Synthesis of building block 39

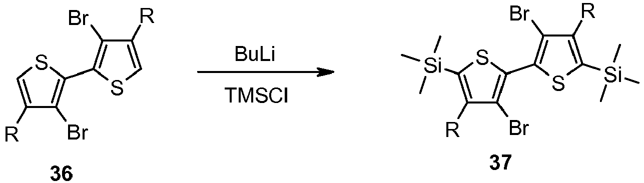

(R = H)
a) To a freshly prepared LDA solution (82 ml butyllithium [2.7 m in heptane], 22.6 g diisopropyl amine and 300 ml dry THF) at -78 °C under a nitrogen atmosphere, a solution of 32.4 g 3,3'-dibromo-2,2'-dithiophene **36** in 150 ml of dry THF is slowly added. The solution is slowly warmed to -20 °C, stirred for 15 minutes and then re-cooled to -78 °C. 27.2 g trimethyl silylchloride is added at once and the solution is slowly allowed to warm to 0 °C. After stirring for 1 hour at 0 °C the reaction mixture is quenched by adding 100 ml water. The phases are separated and the organic phase is washed twice with brine and dried over sodium sulphate. The residue is suspended in methanol and the formed solid is recovered by filtration and dried under vacuum. Affords 43 g (92 %) of the title compound **37** as an off-white powder.
   ¹H-NMR: δ (ppm) 0.00 (s, 18 H), 6.81 (s, 2 H); ¹³C-NMR: δ (ppm) 0.00 (TMS), 113.14 (C3), 134.11, 137.15, 143.05 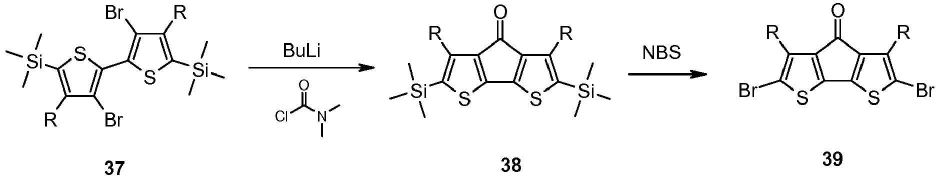 (R = H)
b) 46.8 g 3,3'-dibromo-5,5'-di-trimethylsilyl-2,2'-dithiophene **37** is dissolved in 500 ml of dry THF under a nitrogen atmosphere and cooled to -60 °C. 78 ml butyl lithium (2.7 M in heptane) is added at once. The temperature rises to approximately - 40 °C. The dry ice bath is removed and the reaction mixture is slowly warmed to - 30 °C. At this point 11.5 ml dimethyl carbamoylchloride in 20 ml dry THF is added at once. The temperature rises to approximately -20 °C and the reaction mixture is stirred at that temperature for 15 minutes and then slowly warmed to 0 °C. The reaction mixture is quenched by adding 100 ml water. The phases are separated and the organic phase is washed twice with brine and dried over sodium sulphate. Evaporation of the solvent affords 33.1 g of a red residue, which contains approximately 90 % product **38** (NMR; corresponds to 88.5% yield). Purification can be achieved either by flash chromatography or suspension in methanol.
   ¹H-NMR: δ (ppm) 7.05 (s, 2H); ¹³C-NMR: δ (ppm) 125.41 (C4), 141.08 (C2), 147.42 (C3), 152.21 (C5),180.51 (C=O)
c) The organic phase from reaction step b) can be directly used for the bromination step by adding 37.4 g N-bromo succinimide are added to the organic phase at once at 0 °C. The reaction mixture is stirred for 30 minutes at 0 °C and 1 hour at room temperature. After evaporation to dryness the residue is washed twice with 200 ml water each, which is decanted, and then boiled for 1 hour in 200 ml methanol. After cooling to room temperature the product is collected by filtration. Affords 30.1 g (85.2 %) of the title compound **39** as dark-violet flakes. ¹H-NMR: δ (ppm) 6.99 (s, 2H); ¹³C-NMR: δ (ppm) 114.17 (C5), 124.62 (C4), 139.74 (C2), 148.80 (C3), 180.51 (C=O)

### Example 20: Synthesis of building block 40

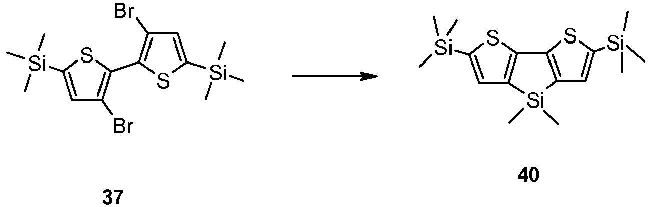

A solution of 9.37 g 3,3'-dibromo-5,5'-di-trimethylsilyl-2,2'-dithiophene **(37)** in 150 ml dry THF is cooled to - 40 °C. 16 ml butyl lithium (2.7 M in heptane) are added at once and the resulting solution is stirred for 15 minutes at -20 °C. 2.58 g dimethyl dichloro silane are added at once and the reaction mass is stirred for 30 minutes at 0 °C and 1 hour at room temperature. The reaction mixture is quenched by adding 50 ml 1 N HCI. The phases are separated and the organic phase is washed twice with brine and dried over sodium sulphate. Evaporation of the solvent affords 6.95 g (95 % of th.) of the title compound **40** as colourless liquid, which is almost pure as determined by NMR. ¹H-NMR: δ (ppm) 0.00 (s, 18H), 0.08 (s, 6H), 6.83 (s, 2 H)

### Example 21: Synthesis of building blocks 45 and 46

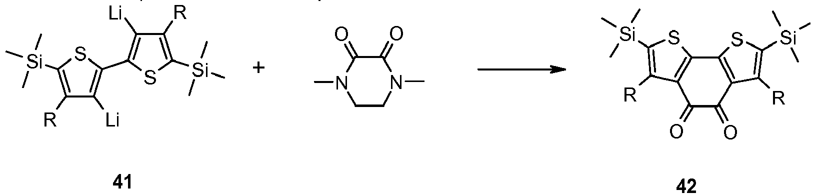

(R = H)
a) A solution of 9.37 g 3,3'-dibromo-5,5'-di-trimethylsilyl-2,2'-dithiophene **(41)** in 150 ml dry THF is cooled to - 40 °C. 16 ml butyl lithium (2.7 M in heptane) are added at once and the resulting solution is stirred for 15 minutes at -20 °C. 3.20 g of 1,4-Dimethyl-piperazine-2,3-dione are added in one portion and the reaction mixture is allowed to warm to room temperature and stirred for an additional hour at this temperature. The reaction mixture is quenched by adding 50 ml 1 N HCI. The phases are separated and the organic phase is washed twice with brine and dried over sodium sulphate. Evaporation of the solvent affords a red residue, which is suspended in hexane. The obtained slurry is stirred for 1 hour and then filtered. The filter cake is washed with hexane and dried under vacuum. Affords 3.4 g (46 % of th.) of the title compound **42** as a dark red powder. ¹H-NMR: δ (ppm) 0.00 (s, 18H), 7.23 (s, 2H); ¹³C-NMR: δ (ppm) 0.00, 134.53, 136.08, 142.68, 148.47, 175.31 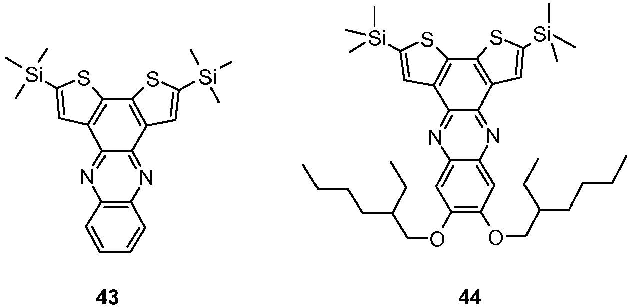
b) By reacting the above product **42** with o-diaminobenzene, the following compound **43** is obtained; using 1,2-diamino-4,5-di(2-ethylhexyloxy)-benzene instead of o-diaminobenzene yields **44.** General procedure: 10 mmol **42**and 10 mmol of the aromatic ortho-diamine are dissolved in 50 ml of ethanol and refluxed for 2 hours. After cooling to 0 °C the yellow precipitate is filtered and washed with cold ethanol and dried in a vacuum oven affording the corresponding quinoxaline **43** or **44.**
   NMR-spectrum of **43:** ¹H-NMR: δ (ppm) 0.20 (s, 18H), 7.47 (dd, 2H), 7.94 (dd, 2H), 8.17 (s, 2H); ¹³C-NMR: δ (ppm) 0.00, 129.08, 131.48, 135.64, 139.82, 140.01, 140.45, 141.26

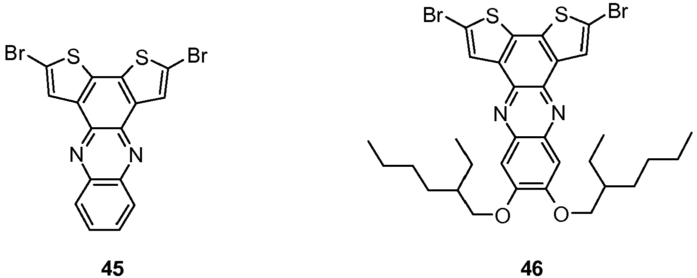

To a solution of **43** or **44** in 100 ml THF, 2 equivalents of N-bromo-succinimide are added in one portion and the reaction mixture is heated to 40 °C and stirred at this temperature for 16 hours. The solvent is then evaporated and residue is washed several times with water and then recrystallized from ethanol. The corresponding quinoxaline **45** or **46** in 60-80 % yield.
NMR-spectrum of **46**: ¹H-NMR: δ (ppm) 0.98 (t, 6H), 1.06 (t, 6H), 1.42 (m, 8H), 1.62 (m, 8H), 1.96 (m, 2H), 4.13 (d, 4H), 7.19 (s, 2H), 7.97 (s, 2H)
¹³C-NMR: δ (ppm) 23.15, 24.09, 24.12, 29.18, 30.73, 30.74, 39.34, 71.58, 105.65, 112.51, 126.93, 133.24, 134.48, 135.53, 139.87, 154.10

### Example 22: Synthesis of building block 49

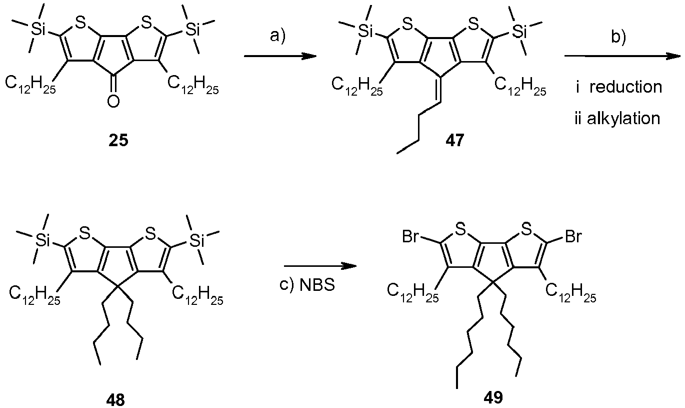

a) A solution of 0.5 g **25** in 5 ml THF is treated at - 20 °C with 1.1 eq. butyl lithium and then slowly warmed to 0°C. The reaction is quenched by the addition of 1.1 eq. trifluoro acetic anhydride and stirred for an additional hour at room temperature.
   10 ml tert.butylmethylether are added the the reaction mixture is washed with sodium bicarbonate and brine. The organic phase is separated and dried over sodium sulphate and evaporated to dryness. The residue is dissolved in 5 ml DMSO and 0.1 ml trifluoroacetic acid and stirred for 5 hours at 70 °C, cooled down and poured onto a saturated sodium bicarbonate solution. The aqueous slurry is extracted twice with tert.butyl-methylether, the combined organic phases are washed with brine, dried over sodium sulphate and evaporated to dryness. Afford 0.35 g **47** as a greyish-white solid.
b) A solution of the product from above in toluene is treated with 3 eq. Red-AI (1 M in THF) and stirred at 80 °C for 2 hours. After cooling down the reaction mixture is subsequently washed with diluted HCI and brine. The organic phase is dried over sodium sulphate and evaporated to dryness.
   The residue from above is dissolved in DMSO and, after the addition of 1.5 eq. butyl bromide, 5 eq. KOH and a catalytical amount of KI, stirred for 16 hours at room temperature. The reaction mass is poured onto diluted HCI and the aqueous slurry is extracted twice with hexane. The combined organic phases are washed with brine, dried over sodium sulphate and evaporated to dryness. The residue is further purified by flash chromatography affording 0.29 g **48** as a white solid.
c) Bromination according to the method described in the last step of example 11d yields **49.**
   ¹H-NMR: δ (ppm) 0.81 (2x t, 12H), 0.9 (m, 4H), 1.1 - 1.3 (m, 46H), 1.48 (m, 4H), 1.78 (m, 4H), 2.63 (dd, 4H)

### Example 23: Synthesis of building block 50

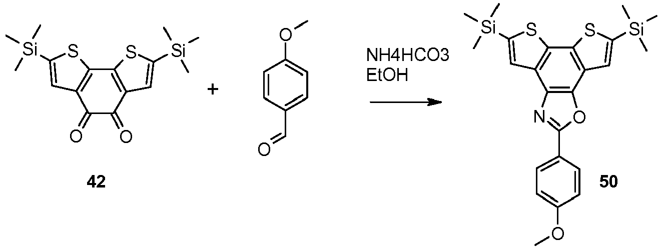

To 2.00 g (5.5 mmol) of **42** in 10 ml ethanol (abs) 1 ml (8.23 mmol) anisaldehyd and 2.17 g (27.42 mmol) ammoniumhydrocarbonate is added . The reaction mixture is heated at reflux under nitrogen overnight, cooled to 25 °C, the product is filtered off and washed with ethanol (yield:1.66g (63%)).

### Example 24: Synthesis of building blocks 51 and 52

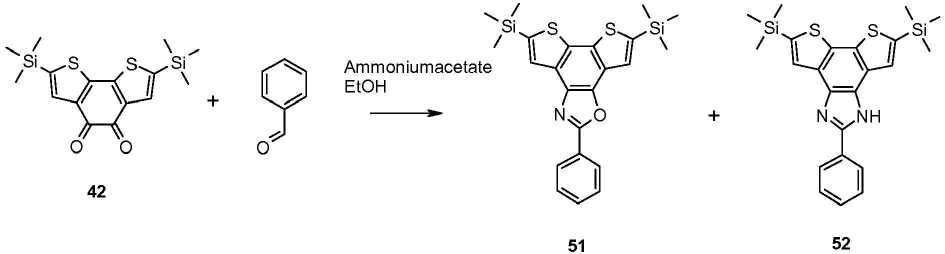

To 0.25 g (0.7 mmol) of **42** in 6 ml ethanol (abs) 0.11 g (1.0 mmol) benzaldehyde and 0.26 g (3.43 mol) ammonium acetate is added . The reaction mixture is heated at reflux under nitrogen overnight, cooled to 25 °C, the products are filtered off and separated by column chromatography using a flash master (eluent heptane: ethyl acetate 5:1) (yield **51:** 0.05g (17%); yield **52:** 0.24g (83%)).

### Example 25: Synthesis of building block 53

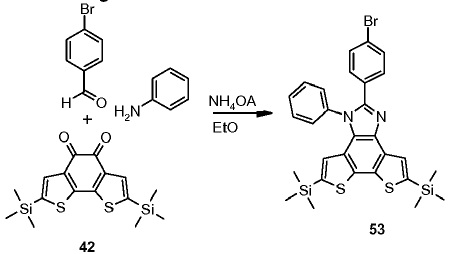

To 4.00 g (11.0 mmol) **42** in 80 ml acetic acid 2.23 g (12.1 mmol) 4-bromobenzaldehyde, 1.17g (12.6 mmol) aniline and 3.38 g (43.9 mmol) ammonium acetate are added. The reaction mixture is stirred at 130 °C under nitrogen for 45min., cooled to 25 °C, and the product is filtered off and washed with AcOH / MeOH. (yield: 4.5 g (67.8%)).

### Reference Example 26: Synthesis of Polymer 55

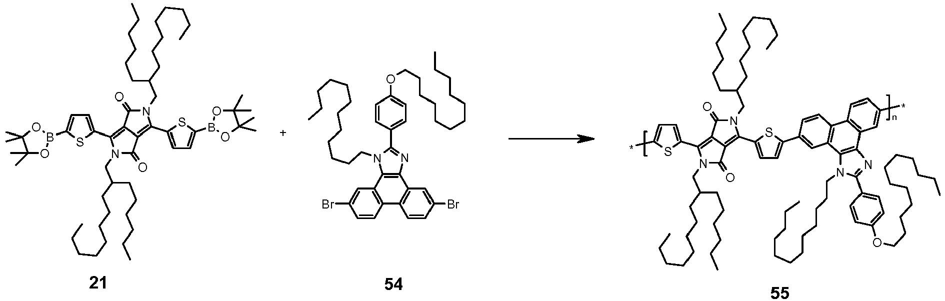

Compound **54** is synthesised according to example 9 of WO06/097419. According to the procedure for the synthesis of polymer **2,** 0.62 g of **21,** 0.50 g of **54** are reacted to give polymer **55.** The purification is achieved by soxhlet extraction using pentane and cyclohexane and the polymer is then extracted with THF to give 0.82g of **55** as a dark powder.

Several polymer can be synthesized using the above described building blocks using Suzuki polymerization conditions (cf. Reference Example 1). Therefore, all described building blocks containing a trimethyl-silyl protecting group such as **33, 40, 42, 50, 51, 52** and **53** can be transformed to the corresponding dibromide using similar conditions of example 11d. These corresponding dibromides and the already described dibromide **26, 27, 28, 30, 32, 35, 39, 45, 46** and **49** can used as monomers in combination of a DPP-bisboronic ester such as **21** to form polymers claimed by this invention. All these dibromides can be converted into bis boronic esters using known methods. These corresponding bis-boronic esters can then be used as momomers in combination of a DPP-dibromides such as **1, 3, 8** and **12** to form polymers claimed by this invention.

### Reference Example 26: Synthesis of Polymer 55

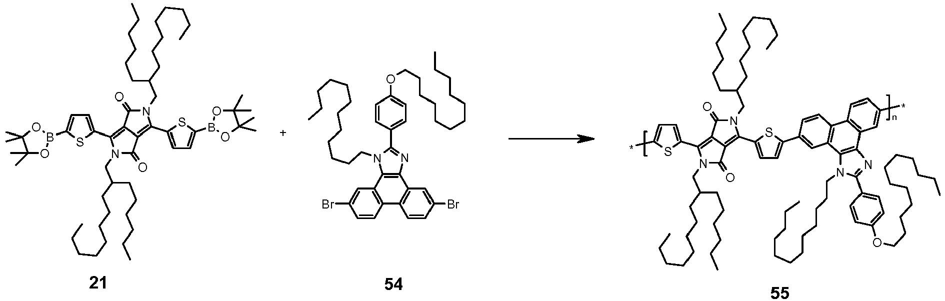

Compound **54** is synthesised according to example 9 of WO06/097419. According to the procedure for the synthesis of polymer **16**, 0.62 g of **21,** 0.50 g of **54** are reacted to give polymer **55.** The purification is achieved by soxhlet extraction using pentane and cyclohexane and the polymer is then extracted with THF to give 0.82g of **55** as a dark powder. Mw 130'000, Polydispersity 5.5.

### Reference Example 27: Synthesis of Polymer 58

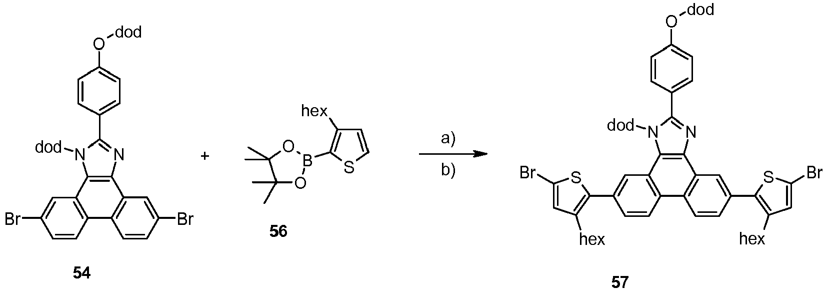

a) In a three neck-flask 3.95 g of potassium phosphate (K₃PO₄) dissolved in 15 ml of water (previously degassed with argon) is added to a degassed solution of 5.00 g of **54,** 5.49 g of **56** 0.17 mg of tri-tert-butylphosphonium tetrafluoroborate ((t-Bu)₃P ^{∗} HBF₄) and 86 mg of tris(dibenzylideneacetone) dipalladium (0) (Pd₂(dba)₃) in 50 ml of tetrahydrofuran. The reaction mixture is heated to reflux overnight. The reaction mixture is cooled to room temperature. The water layer is extracted three times with dichloroethane and the combined organic layers are washed with water, dried and the solvent evaporated under reduce pressure. The crude product is filtered over silicagel with cyclohexane. 5.6g of a brownish oil are obtained. 4g of this oil are dissolved in 40 ml chloroform and cooled to 0°C with an ice bad. 1.38g of N-bromosuccinimde are added and the reaction mixture is allowed to warm to room temperature overnight. The reaction mixture is filtered, the filtrate is concentrated under reduced pressure. The filter cake is than dissolved with water/ chloroform (1:1) .The layers are separated, the water layer is than extracted once with chloroform and the combined organic layers are concentrated under reduce pressure. Further Purification by silica gel filtration with dichloromethane / hexane(1:2) results in 3.2g of the desired product. 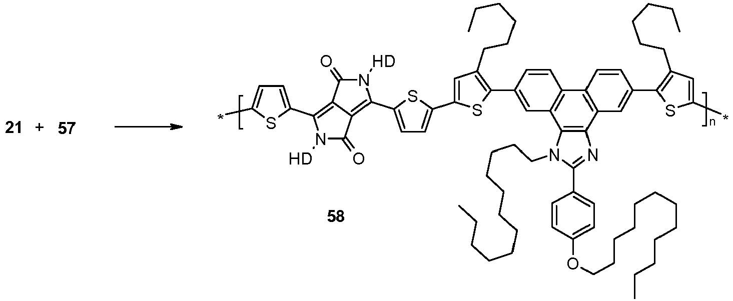
b) According to the procedure for the synthesis of polymer **16** 1.0 g of **21** and 1.14 g of **57** are reacted to give polymer **58.** The purification is achieved by soxhlet extraction using pentane and cyclohexane. The polymer is then extracted with THF to give 1.23g of 58 as a dark powder. Mw 64'000, Polydispersity 2.5.

### Example 28: Synthesis of Polymer 61

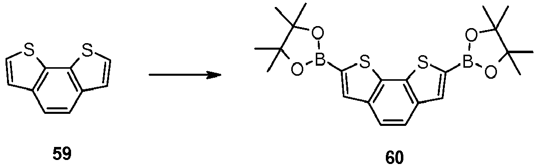

a) 8.5 ml butyl lithium (2.7 M in heptane) are added to a cooled (- 20 °C) solution of 2.00 g **59** in 20 ml of dry THF. The resulting solution is stirred for 1 hour at room temperature and cooled to - 40 °C. 5.2 g 2-isopropoxy-4,4,5,5-tetramethyl-1,3,2-dioxoborolane are added in one portion, the solution is slowly warmed to 0 °C and stirring is continued for 30 minutes. The reaction is quenched by adding diluted HCI and the product is extracted twice with TBME. The combined organic extracts are dried and evaporated to give crude **60,** which is purified by repetitive crystallisations from hexane. 2.3 g of compound **60** are obtained as white powder. 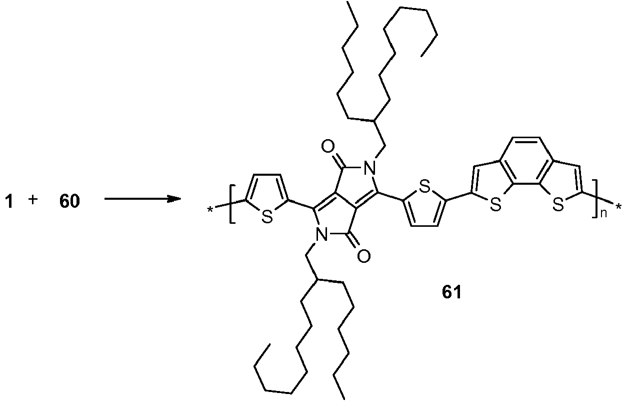
b) According to the procedure for the synthesis of polymer **16** 1.0 g of **1** and 0.49 g of **60** are reacted to give polymer **58.** The purification is achieved by soxhlet extraction using hexane, cyclohexane, THF and chloroform to give 1.7g of **61** as a dark powder (0.8 g in THF and 0.9 g in chloroform fraction).

### Example 29: Synthesis of Polymer 65

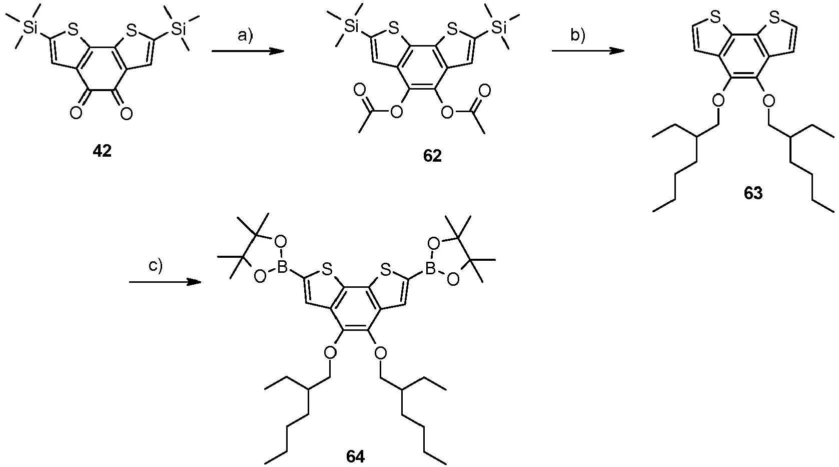

a) 3.71 g zinc powder, 5.4 ml acetic anhydride and 11 ml triethylamine are added to a solution of 2.0 g **42** in 50 ml dichloromethane. The reaction mixture is stirred at room temperature overnight and then subsequently washed with dil. HCI, dil. Sodium bicarbonate and water. Evaporation of the solvent affords **62** as a greenish oil, which is used in the next step without further purification.
b) 5.9 g Cesiumcarbonate and 5.3 ml ethyl-hexylbromide are added to a solution of **62** in acetonitril. The reaction mixture is refluxed overnight and then evaporated to dryness. The residue is suspended in TBME and subsequently washed with diluted HCI, water and brine and dried over sodium sulfate. Evaporation of the solvent and purification affords **63** as a yellow liquid.
c) **63** is converted to **64** in the same manner as described for monomer **60** 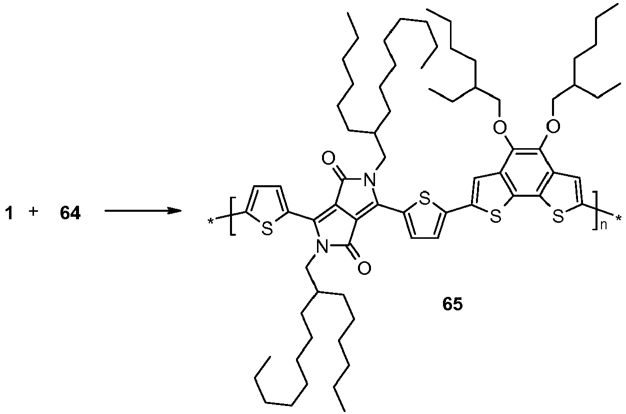
d) According to the procedure for the synthesis of polymer **16** 1.0 g of 1 and 0.74 g of **64** are reacted to give polymer **65.** The purification is achieved by soxhlet extraction, whereby **65** is obtained as a dark powder

### Example 30: Synthesis of Polymer 66

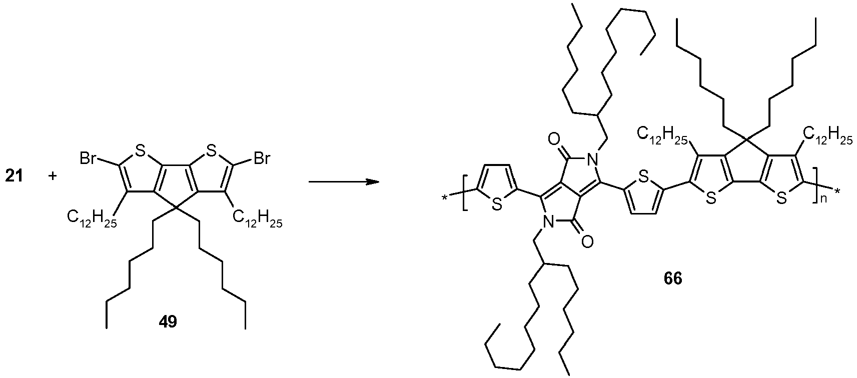

Polymer **66** is prepared according to the procedure of polymer **16**

### Reference Example 31: Synthesis of Polymer 68

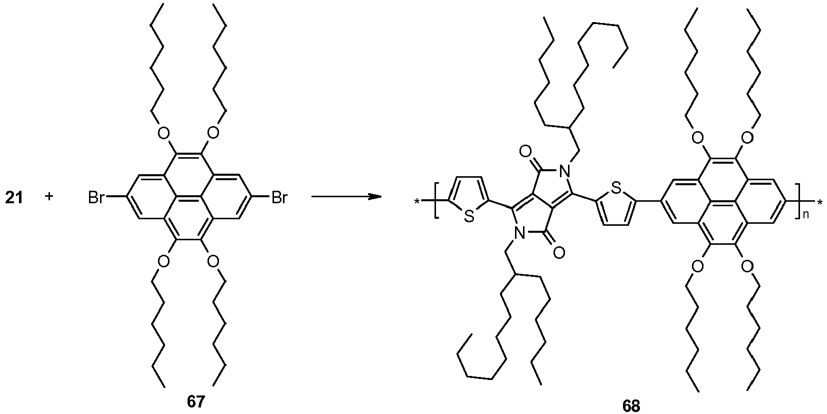

Compound **67** is prepared according to WO2010/006852. Polymer **68** is obtained according the procedure of polymer **16.**

### Reference Example 32: Synthesis of Polymer 70

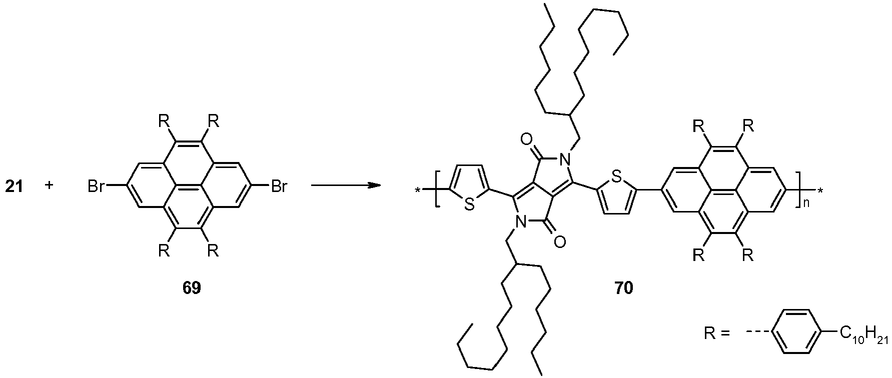

Compound **6**9 is prepared according to WO2010/006852. Polymer **70** is obtained according the procedure of polymer **16.**

## Claims

1. A polymer, comprising (repeating) unit(s) of the formula 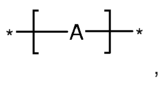 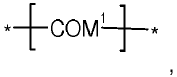 and optionally 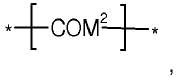 wherein A is a repeating unit of the formula 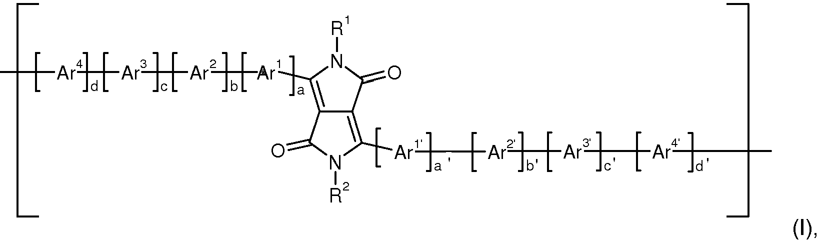 wherein a is 1, 2, or 3, a' is 0, 1, 2, or 3; b is 0, 1, 2, or 3; b' is 0, 1, 2, or 3; c is 0, 1, 2, or 3; c' is 0, 1, 2, or 3; d is 0, 1, 2, or 3; d' is 0, 1, 2, or 3; with the proviso that b' is not 0, if a' is 0; R¹ and R² may be the same or different and are selected from hydrogen, a C₁-C₁₀₀alkyl group, -COOR¹⁰³, a C₁-C₁₀₀alkyl group which is substituted by one or more halogen atoms, hydroxyl groups, nitro groups, -CN, or C₆-C₁₃aryl groups and/or interrupted by -O-, -COO-, - OCO-, or -S-; a C₇-C₁₀₀arylalkyl group, a carbamoyl group,C₅-C₁₂cycloalkyl, which can be substituted one to three times with C₁-C₈alkyl and/or C₁-C₃alkoxy, a C₆-C₂₄aryl group, in particular phenyl or 1- or 2-naphthyl which can be substituted one to three times with C₁-C₈alkyl, C₁-C₈thioalkoxy, and/or C₁-C₃alkoxy, or pentafluorophenyl,
R¹⁰³ is C₁-C₅₀alkyl, especially C₄-C₂₅alkyl;
Ar¹ and Ar^{1'} are independently of each other 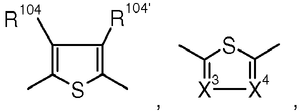 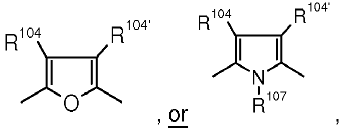 Ar², Ar^{2'}, Ar³, Ar^{3'}, Ar⁴ and Ar^{4'} have the meaning of Ar¹, or are independently of each other 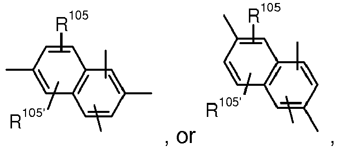 wherein
one of X³ and X⁴ is N and the other is CR⁹⁹,
R⁹⁹, R¹⁰⁴ and R^{104'} are independently of each other hydrogen, halogen, especially F, or a C₁-C₂₅alkyl group, especially a C₄-C₂₅alkyl, which may optionally be interrupted by one or more oxygen or sulphur atoms, C₇-C₂₅arylalkyl, or a C₁-C₂₅alkoxy group,
R¹⁰⁵ and R^{105'} independently of each other hydrogen, halogen, C₁-C₂₅alkyl, which may optionally be interrupted by one or more oxygen or sulphur atoms; C₇-C₂₅arylalkyl, or C₁-C₁₈alkoxy,
R¹⁰⁷ is H; C₆-C₁₈aryl; C₆-C₁₃aryl which is substituted by C₁-C₁₈alkyl, or C₁-C₁₈alkoxy; C₁-C₁₈alkyl; or C₁-C₁₈alkyl which is interrupted by -O-; and -COM¹- is a repeating unit of formula 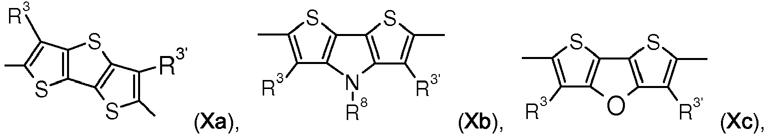 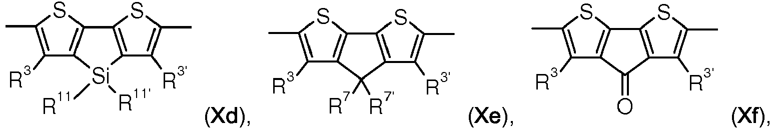 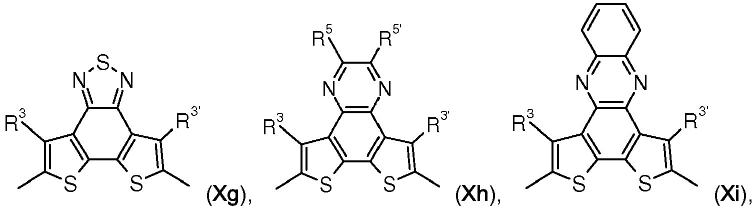 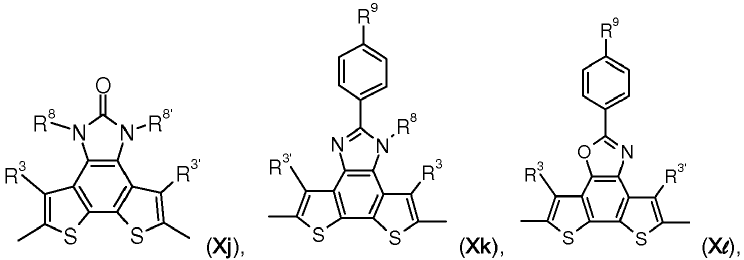 or 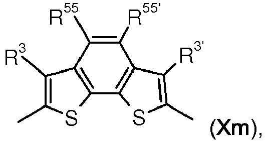 R⁹ is C₁-C₂₅alkyl, which may optionally be interrupted by one or more oxygen or sulphur atoms, C₁-C₂₅perfluoroalkyl, C₁-C₂₅alkoxy, or CN;
-COM²- is a second repeating unit -COM¹- , which is different from the first repeating unit - COM¹-, a second repeating unit -A-, which is different from the first repeating unit -A-, or a repeating unit of formula 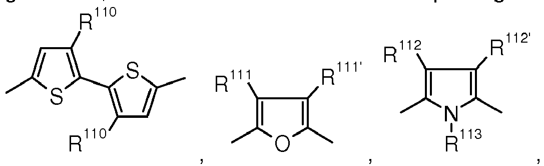 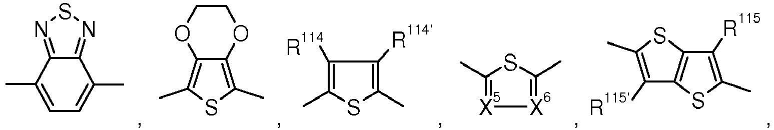 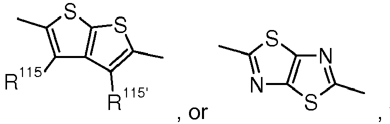 wherein one of X⁵ and X⁶ is N and the other is CR114,
R¹¹⁰ is a C₁-C₂₅alkyl group, especially a C₄-C₂₅alkyl, which may optionally be interrupted by one or more oxygen or sulphur atoms, C₇-C₂₅arylalkyl, or a C₁-C₂₅alkoxy group
R¹¹¹, R^{111'}, R¹¹² and R^{112'} are independently of each other hydrogen, halogen, especially F, or a C₁-C₂₅alkyl group, especially a C₄-C₂₅alkyl, which may optionally be interrupted by one or more oxygen or sulphur atoms, C₇-C₂₅arylalkyl, or a C₁-C₂₅alkoxy group,
R¹¹³ is C₆-C₁₈aryl; C₆-C₁₃aryl which is substituted by C₁-C₁₃alkyl, or C₁-C₁₈alkoxy; C₁-C₁₈alkyl; or C₁-C₁₃alkyl which is interrupted by -O-;
R¹¹⁴, R^{114'}, R¹¹⁵ and R^{115'} are independently of each other H, or a C₁-C₂₅alkyl group, especially a C₆-C₂₅alkyl, which may optionally be interrupted by one or more oxygen atoms;
R³ and R^{3'} are independently of each other hydrogen, halogen, C₁-C₂₅alkyl, which may optionally be interrupted by one or more oxygen or sulphur atoms; C₇-C₂₅arylalkyl, or C₁-C25alkoxy;
R⁵ and R^{5'} are independently of each other hydrogen, halogen, C₁-C₂₅alkyl, which may optionally be interrupted by one or more oxygen or sulphur atoms; C₆-C₂₄aryl, which may optionally be substituted one to three times with C₁-C₈alkyl and/or C₁-C₃alkoxy; C₇-C₂₅arylalkyl, CN, or C₁-C₂₅alkoxy; or
R⁵ and R^{5'} together form a ring,
R⁵⁵ and R^{55'} are independently of each other H, F, C₁-C₁₈alkyl, C₁-C₁₈alkyl which is interrupted by O, C₁-C₁₈alkoxy, C₁-C₁₃alkoxy which is interrupted by O, C₁-C₁₈perfluoroalkyl, C₆-C₂₄aryl, which may optionally be substituted one to three times with C₁-C₈alkyl and/or C₁-C₃alkoxy, C₂-C₂₀heteroaryl, which may optionally be substituted one to three times with C₁-C₈alkyl and/or C₁-C₃alkoxy;
R⁷ and R^{7'} are C₁-C₂₅alkyl,
R⁸ and R^{8'} are independently of each other hydrogen, C₆-C₁₈aryl; C₆-C₁₃aryl which is substituted by C₁-C₁₃alkyl, or C₁-C₁₃alkoxy; C₁-C₂₅alkyl, especially C₄-C₂₅alkyl, which may optionally be interrupted by one or more oxygen or sulphur atoms; or C₇-C₂₅arylalkyl,
R¹¹ and R^{11'} are independently of each other C₁-C₃₅alkyl group, C₇-C₂₅arylalkyl, or a phenyl group, which optionally can be substituted one to three times with C₁-C₈alkyl and/or C₁-C₈alkoxy, with the proviso that the following polymer 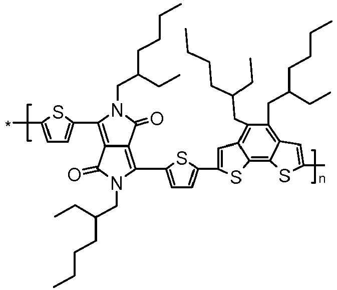 (Mₙ = 22.7 K; polydispersity = 2.1) is excluded.

2. The polymer according to claim 1, wherein -COM¹- is a repeating unit of formula 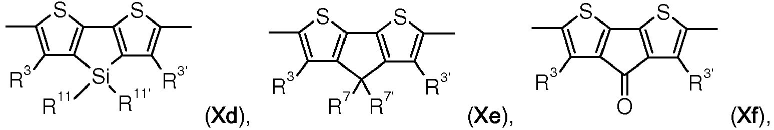 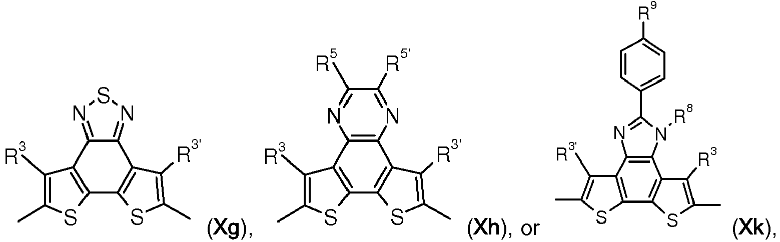 wherein R³, R^{3'}, R⁵, R^{5'}, R⁷, R^{7'}, R⁸, R¹¹ and R^{11'} are as defined in claim 1 and R^{9 is} C₁-C₂₅alkyl, which may optionally be interrupted by one or more oxygen or sulphur atoms, C₁-C₂₅perfluoroalkyl, C₁-C₂₅alkoxy, or CN.

3. The polymer according to claim 1, wherein -COM¹- is a repeating unit of formula 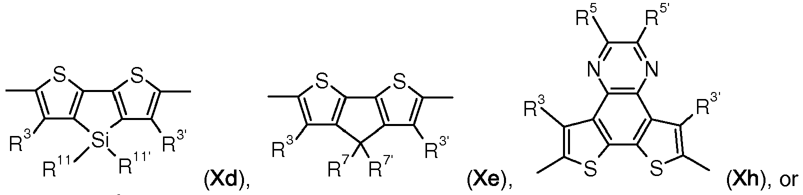 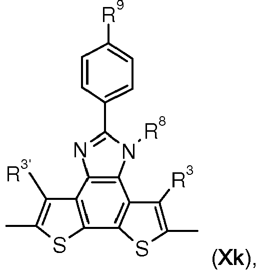 wherein R³, R^{3'}, R5, R^{5'}, R7, R^{7'}, R8, R¹¹ and R^{11'} are as defined in claim 1 and R⁹ is C₁-C₂₅alkyl, which may optionally be interrupted by one or more oxygen or sulphur atoms, C₁-C₂₅perfluoroalkyl, C₁-C₂₅alkoxy, or CN.

4. The polymer according to any of claims 1 to 3, wherein A is a group of formula 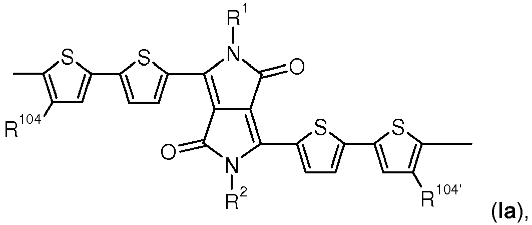 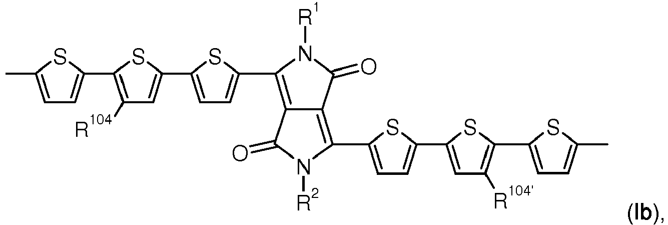 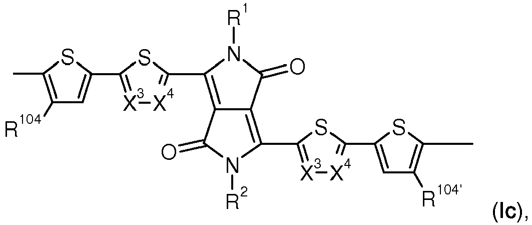 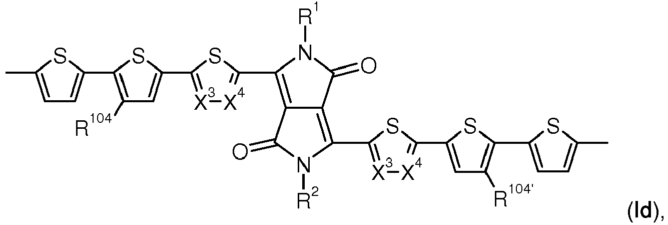 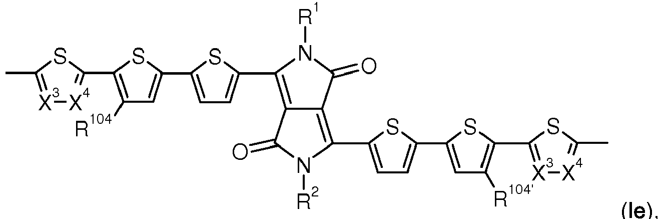 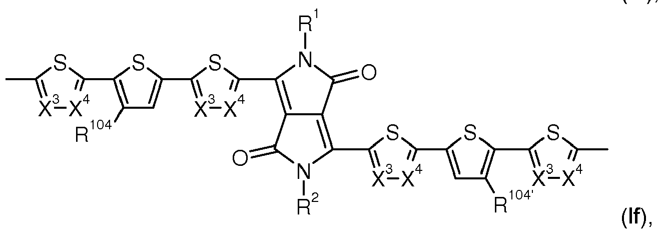 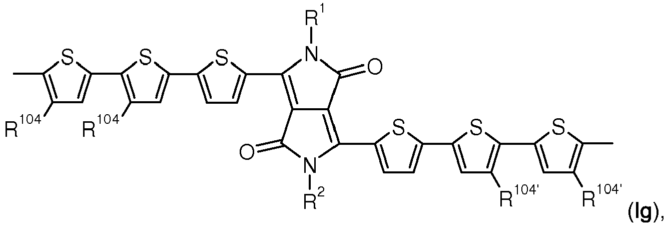 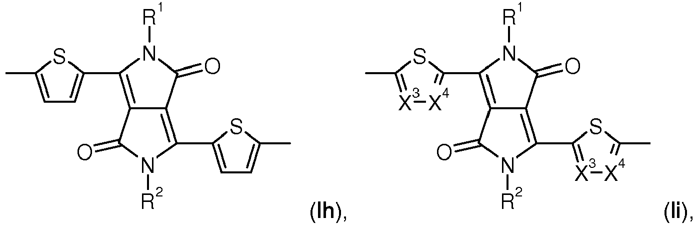 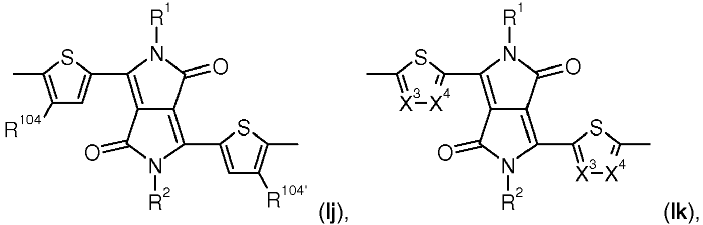 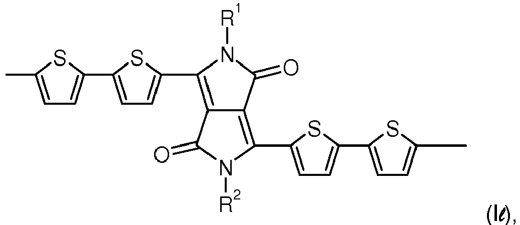 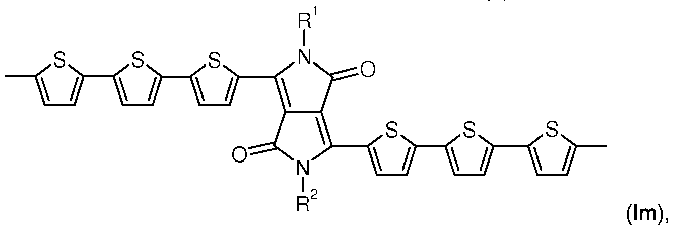 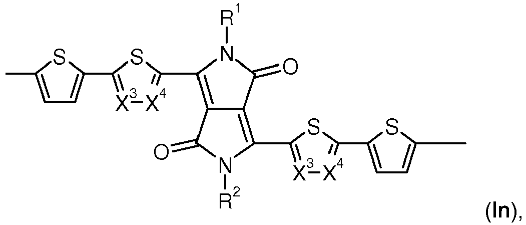 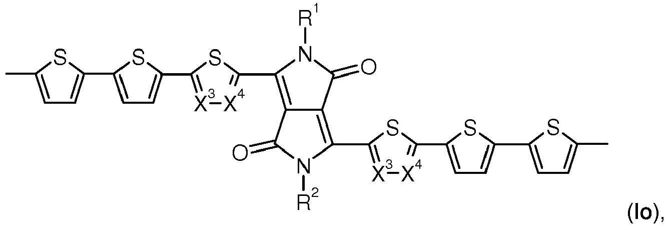 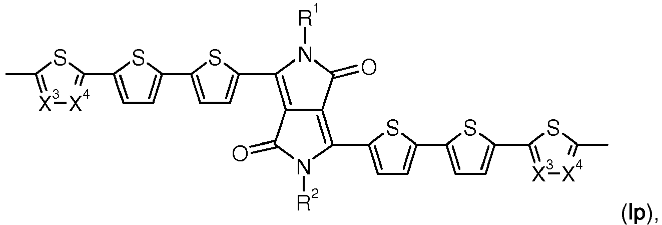 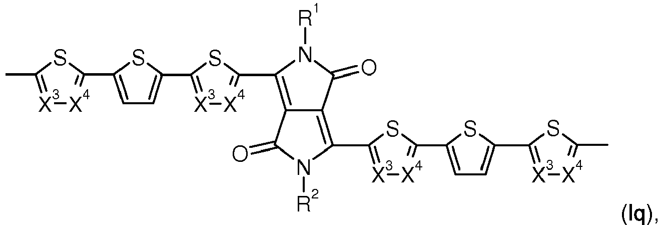 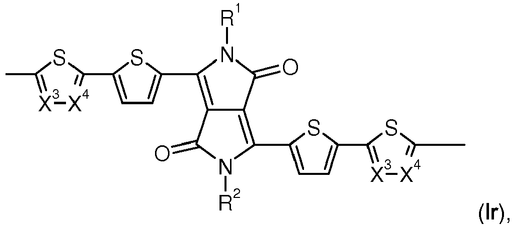 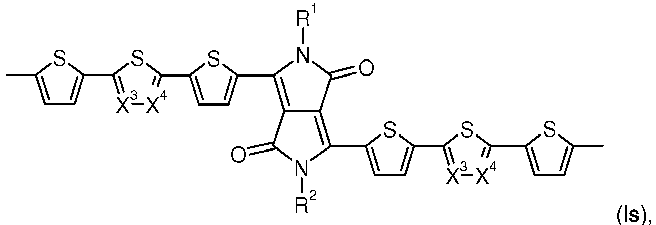 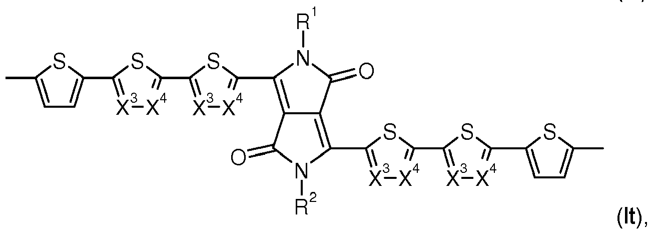 or 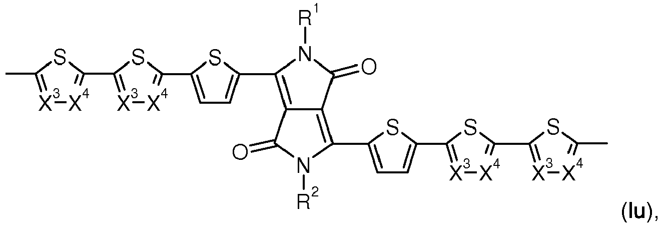 wherein X³, X⁴, R¹ and R² are as defined in claim 1, and
R¹⁰⁴ and R^{104'} are independently of each other hydrogen, or a C₁-C₂₅alkyl group, especially a C₄-C₂₅alkyl, which may optionally be interrupted by one or more oxygen or sulphur atoms, C₇-C₂₅arylalkyl, or a C₁-C₂₅alkoxy group.

5. The polymer according to any of claims 1 to 4, wherein R¹ and R² independently from each other stand for C₁-C₁₀₀alkyl, C₅-C₁₂cycloalkyl, which can be substituted one to three times with C₁-C₈alkyl and/or C₁-C₃alkoxy, phenyl or 1- or 2-naphthyl which can be substituted one to three times with C₁-C₈alkyl and/or C₁-C₃alkoxy, or -CR¹⁰¹R¹⁰²-(CH₂)ᵤ-A³, wherein R¹⁰¹ and R¹⁰² stand for hydrogen, or C₁-C₄alkyl, A³ stands for phenyl or 1- or 2-naphthyl, which can be substituted one to three times with C₁-C₈alkyl and/or C₁-C₃alkoxy, and u stands for 0, 1, 2, or 3.

6. The polymer according to any of claims 1 to 5, which is a copolymer of the formula *⁅A-⁆* and 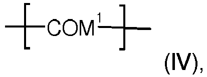 *⁅A⁆* or, 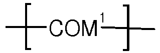 and 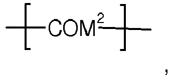 wherein
A is a group of formula **Ia** to lu as defined in claim 4.
COM¹ is a group of formula **Xa** to **Xm** as defined in claim 2, or a group of formula **Xla** to **Xlm** as defined in claim 3,
COM²- is a second repeating unit -COM¹-, which is different from the first repeating unit - COM¹-.

7. The polymer according to claim 6, which is a polymer of the formula 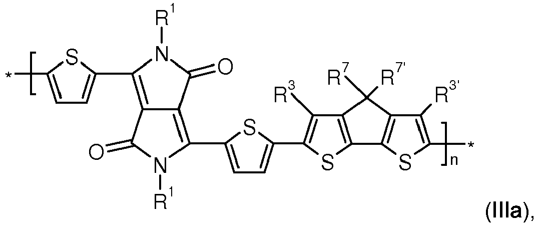 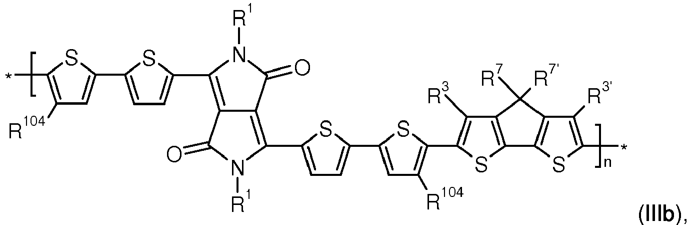 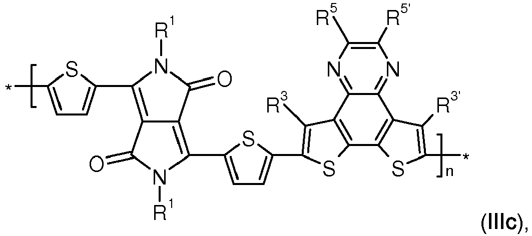 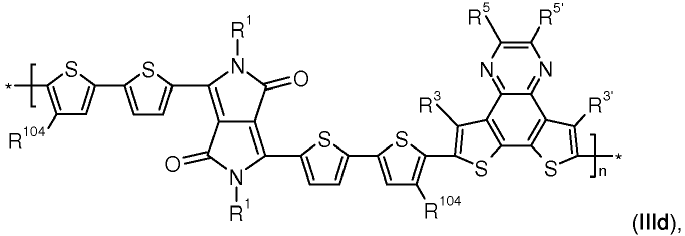 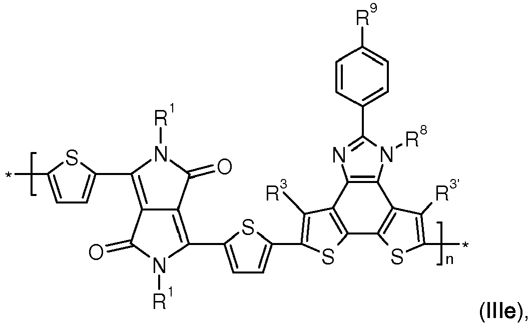 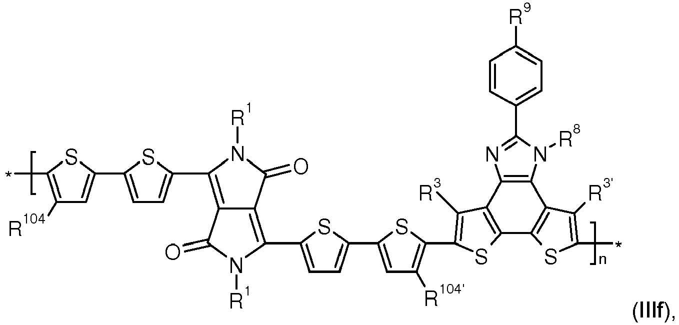 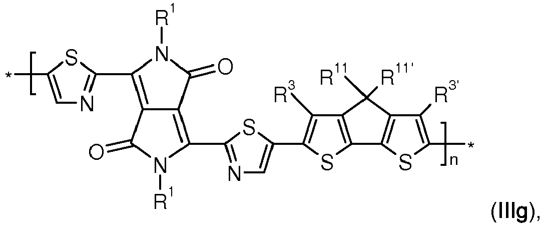 or 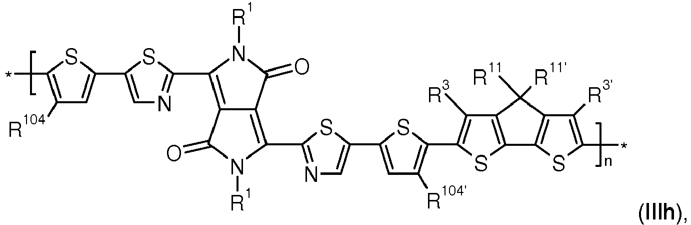 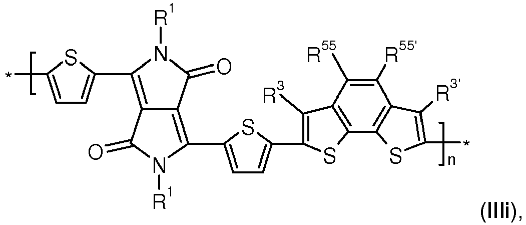 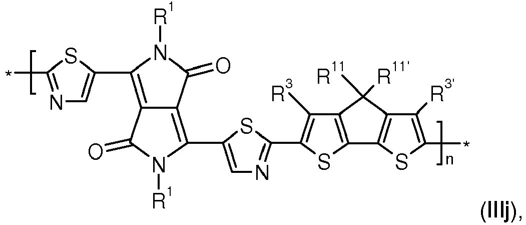 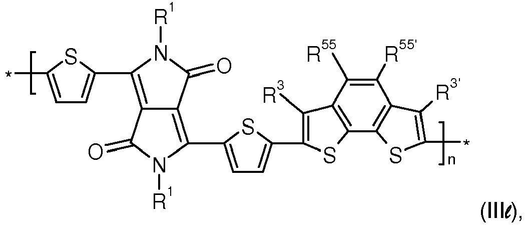 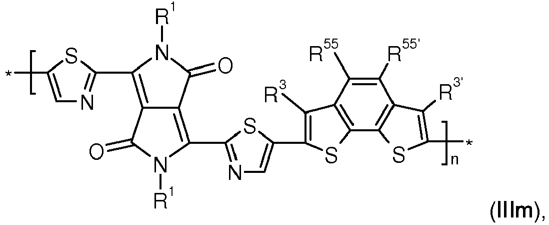 or 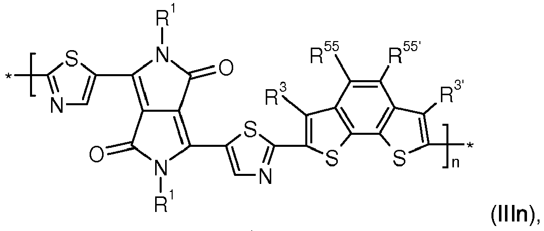 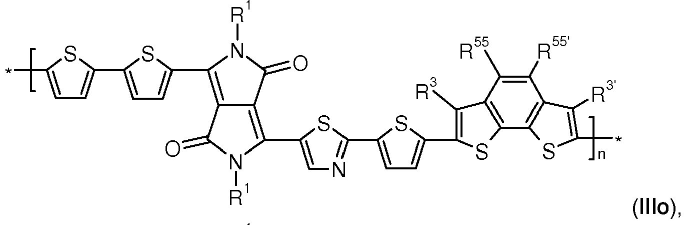 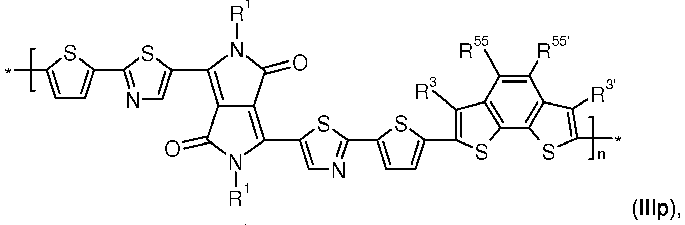 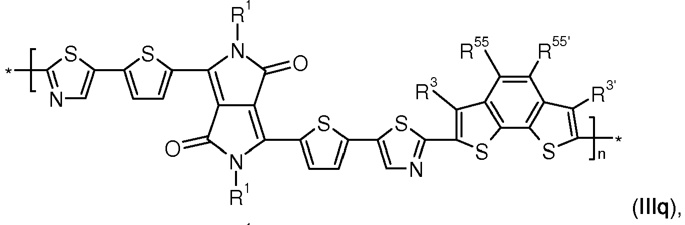 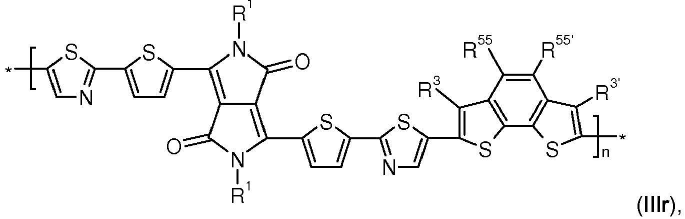 wherein v is 0.995 to 0.005, w is 0.005 to 0.995,
n is 4 to 1000, especially 4 to 200, very especially 5 to 100,
m is 4 to 1000, especially 4 to 200, very especially 5 to 100,
R¹ is a C₁-C₃₅alkyl group, especially a C₃-C₃₅alkyl group,
R³ and R^{3'} are H, or a C₁-C₂₅alkyl group,
R⁵ and R^{5'} are a C₁-C₂₅alkyl group, or a C₁-C₂₅alkoxy group,
R⁵⁵ and R^{55'} are H,
R⁵⁶ and R^{56'} are H, a C₁-C₂₅alkyl group, or a C₁-C₂₅alkoxy group,
R⁷, R^{7'}, R¹¹ and R^{11'} are a C₁-C₃₅alkyl group,
R⁸ is a C₁-C₂₅alkyl group,
R⁹ is a C₁-C₂₅alkyl group, or a C₁-C₂₅alkoxy group,
R¹⁰⁴ is H, or a C₁-C₂₅alkyl group,
R¹⁰⁴ is H, or a C₁-C₂₅alkyl group,
R^{104'} is H, or a C₁-C₂₅alkyl group,
R¹¹⁰ is a C₁-C₂₅alkyl group, and
R¹⁰⁸ and R¹⁰⁶ is H; or R¹⁰⁸ is CN and R¹⁰⁶ is H; or R¹⁰⁶ is CN and R¹⁰⁸ is H.

8. An organic semiconductor material, layer or component, comprising a polymer according to any of claims 1 to 7.

9. A semiconductor device, comprising a polymer according to any of claims 1 to 7, and/or an organic semiconductor material, layer or component according to claim 8.

10. The semiconductor device according to claim 9, which is an organic photovoltaic (PV) device (solar cell), a photodiode, or an organic field effect transistor.

11. Process for the preparation of an organic semiconductor device, which process comprises applying a solution and/or dispersion of a polymer according to any of claims 1 to 7 in an organic solvent to a suitable substrate and removing the solvent.

12. Use of the polymer according to any of claims 1 to 7, and/or the organic semiconductor material, layer or component according to claim 8 in PV devices, photodiodes, or organic field effect transistors.

13. A process for the preparation of a polymer of formula 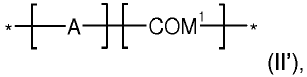 wherein A and -COM¹- are as defined in claim 1, comprising reacting a dihalogenide of formula X¹⁰-A-X¹⁰ with an equimolar amount of a diboronic acid or diboronate corresponding to formula 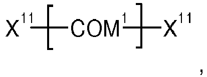 or reacting a dihalogenide of formula 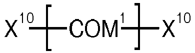 with an equimolar amount of a diboronic acid or diboronate corresponding to formula X¹¹-A-X¹¹, wherein X¹⁰ is halogen, especially Br, and X¹¹ is independently in each occurrence -B(OH)₂, -B(OY¹)₂, 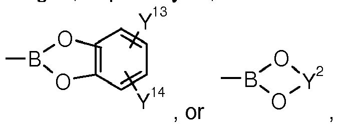 wherein Y¹ is independently in each occurrence a C₁-C₁₀alkyl group and Y² is independently in each occurrence a C₂-C₁₀alkylene group, such as -CY³Y⁴-CY⁵Y⁶-, or -CY⁷Y⁸-CY⁹Y¹⁰- CY¹¹Y¹²-, wherein Y³, Y⁴, Y⁵, Y⁶, Y⁷, Y⁸, Y⁹, Y¹⁰, Y¹¹ and Y¹² are independently of each other hydrogen, or a C₁-C₁₀alkyl group,
especially -C(CH₃)₂C(CH₃)₂-, -C(CH₃)₂CH₂C(CH₃)₂-, or -CH₂C(CH₃)₂CH₂-, and Y¹³ and Y¹⁴ are independently of each other hydrogen, or a C₁-C₁₀alkyl group, in a solvent and in the presence of a catalyst; or
reacting a dihalogenide of formula X¹⁰-A-X¹⁰ with an equimolar amount of an organo tin compound corresponding to formula 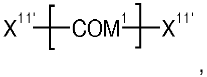 or reacting a dihalogenide of formula 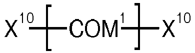 with an equimolar amount of an organo tin compound corresponding to formula X^{11'}-A-X^{11'}, wherein
X^{11'} is independently in each occurrence -SnR²⁰⁷R²⁰⁸R²⁰⁹, wherein R²⁰⁷, R²⁰⁸ and R²⁰⁹ are identical or different and are H or C₁-C₆alkyl, or two of the groups R²⁰⁷, R²⁰⁸ and R²⁰⁹ form a ring and these groups are optionally branched.

## Patentansprüche

1. Polymer, umfassend (Wiederholungs)einheit(en) der *-[-A-)-*, Formel 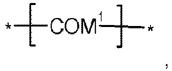 und gegebenenfalls 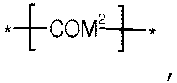 wobei A eine Wiederholungseinheit der Formel 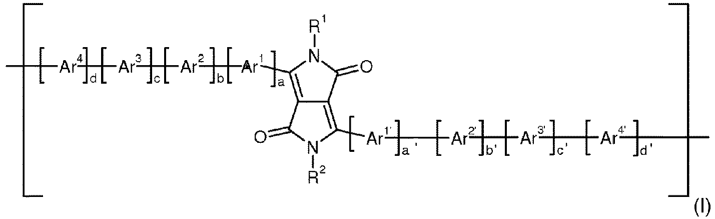 ist,
wobei a 1, 2 oder 3 ist, a' 0, 1, 2 oder 3 ist; b 0, 1, 2 oder 3 ist; b' 0, 1, 2 oder 3 ist; c 0, 1, 2 oder 3 ist; c' 0, 1, 2 oder 3 ist; d 0, 1, 2 oder 3 ist; d' 0, 1, 2 oder 3 ist; mit der Maßgabe, dass b' nicht 0 ist, wenn a' 0 ist;
R¹ und R² gleich oder verschieden sein können und ausgewählt sind aus Wasserstoff, einer C₁-C₁₀₀Alkylgruppe, -COOR¹⁰³, einer C₁-C₁₀₀Alkylgruppe, die mit einem oder mehreren Halogenatomen, Hydroxygruppen, Nitrogruppen, -CN oder C₆-C₁₈Arylgruppen substituiert ist und/oder von -O-, -COO-, -OCO- oder -S- unterbrochen ist; einer C₇-C₁₀₀Arylalkylgruppe, einer Carbamoylgruppe, C₅-C₁₂Cycloalkyl, das ein- bis dreifach mit C₁-C₈Alkyl und/oder C₁-C₈Alkoxy substituiert sein kann, einer C₆-C₂₄Arylgruppe, insbesondere Phenyl oder 1- oder 2-Naphthyl, das ein- bis dreifach mit C₁-C₈Alkyl, C₁-C₈Thioalkoxy und/oder C₁-C₈Alkoxy substituiert sein kann, oder Pentafluorphenyl;
R¹⁰³ C₁-C₅₀Alkyl, insbesondere C₄-C₂₅Alkyl, ist;
Ar¹ und Ar^{1'} unabhängig voneinander 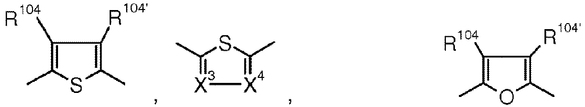 oder 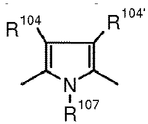 sind;
Ar², Ar^{2'}, Ar³, Ar^{3'}, Ar⁴ und Ar^{4'} die Bedeutung von Ar¹ haben oder unabhängig voneinander 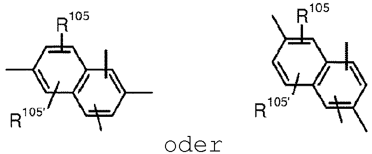 sind, wobei eines von X³ und X⁴ N ist und das andere CR⁹⁹ ist,
R⁹⁹, R¹⁰⁴ und R^{104'} unabhängig voneinander Wasserstoff, Halogen, insbesondere F, oder eine C - C₂₅Alkylgruppe, insbesondere ein C₄-C₂₅Alkyl, das gegebenenfalls von einem oder mehreren Sauerstoff- oder Schwefelatomen unterbrochen sein kann, C₇-C₂₅Arylalkyl oder eine C₁-C₂₅Alkoxygruppe sind;
R¹⁰⁵ und R^{105'} unabhängig voneinander Wasserstoff, Halogen, C₁-C₂₅Alkyl, das gegebenenfalls von einem oder mehreren Sauerstoff- oder Schwefelatomen unterbrochen sein kann, C₇-C₂₅Arylalkyl oder C₁-C₁₈Alkoxy sind;
R¹⁰⁷ H; C₆-C₁₈^{Aryl}; C₆-C₁₈Aryl, das mit C₁-C₁₈Alkyl, oder C₁-C₁₈Alkoxy substituiert ist; C₁-C₁₈-Alkyl; oder C₁-C₁₈Alkyl, das von -O- unterbrochen ist; ist; und -COM¹- eine Wiederholungseinheit der Formel 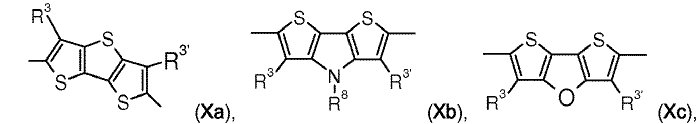 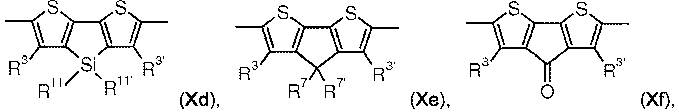 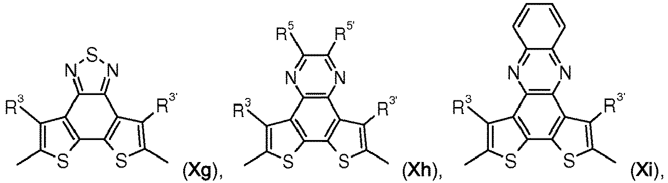 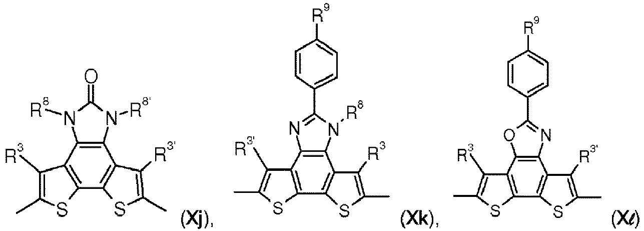 oder 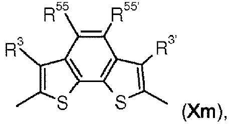 ist,
R⁹ C₁-C₂₅Alkyl, das gegebenenfalls von einem oder mehreren Sauerstoff- oder Schwefelatomen unterbrochen sein kann, C₁-C₂₅Perfluoralkyl, C₁-C₂₅Alkoxy oder CN ist;
-COM²- eine zweite Wiederholungseinheit -COM¹-, die von der ersten Wiederholungseinheit -COM¹- verschieden ist, eine zweite Wiederholungseinheit -A-, die von der ersten Wiederholungseinheit -A-verschieden ist, oder eine Wiederholungseinheit der Formel 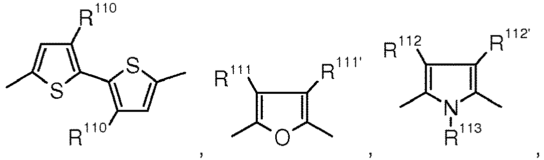 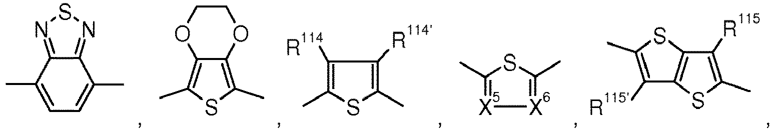 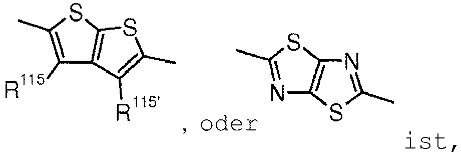 wobei eines von X⁵ und X⁶ N ist und das andere CR¹¹⁴ ist,
R¹¹⁰ eine C₁-C₂₅Alkylgruppe, insbesondere ein C₄-C₂₅Alkyl, das gegebenenfalls von einem oder mehreren Sauerstoff- oder Schwefelatomen unterbrochen sein kann, C₇-C₂ₛArylalkyl oder eine C₁-C₂₅Alkoxygruppe ist;
R¹¹¹, R^{111'}, R¹¹² und R^{112'} unabhängig voneinander Wasserstoff, Halogen, insbesondere F, oder eine C₁-C₂₅Alkylgruppe, insbesondere ein C₄-C₂₅Alkyl, das gegebenenfalls von einem oder mehreren Sauerstoff- oder Schwefelatomen unterbrochen sein kann, C₇-C₂₅Arylalkyl oder eine C₁-C₂₅Alkoxygruppe sind;
R¹¹³ C₆-C₁₈Aryl; C₆-C₁₈Aryl, das mit C₁-C₁₈Alkyl oder C₁-C₁₈Alkoxy substituiert ist; C₁-C₁₈Alkyl oder C₁-C₁₈Alkyl, das von -O- unterbrochen ist, ist;
R¹¹⁴, R^{114'}, R¹¹⁵ und R^{115'} unabhängig voneinander H oder eine C₁-C₂₅Alkylgruppe, insbesondere ein C₆-C₂₅Alkyl, das gegebenenfalls von einem oder mehreren Sauerstoffatomen unterbrochen sein kann, sind;
R³ und R^{3'} unabhängig voneinander Wasserstoff, Halogen, Cₗ-C₂₅Alkyl, das gegebenenfalls von einem oder mehreren Sauerstoff- oder Schwefelatomen unterbrochen sein kann; C₇-C₂₅Arylalkyl oder C₁-C₂₅Alkoxy sind;
R⁵ und R^{5'} unabhängig voneinander Wasserstoff, Halogen, C₁-C₂₅Alkyl, das gegebenenfalls von einem oder mehreren Sauerstoff- oder Schwefelatomen unterbrochen sein kann; C₆-C₂₄Aryl, das gegebenenfalls ein- bis dreifach mit C₁-C₈Alkyl und/oder C₁-C₈Alkoxy substituiert sein kann; C₇-C₂₅Arylalkyl, CN, oder C₁-C₂₅Alkoxy sind; oder
R⁵ und R^{5'} zusammen einen Ring bilden,
R⁵⁵ und R^{55'} unabhängig voneinander H, F, C₁-C₁₈Alkyl, C₁-C₁₈Alkyl, das von O unterbrochen ist, C₁-C₁₈Alkoxy, C₁-C₁₈Alkoxy, das von O unterbrochen ist, C₁-C₁₈Perfluoralkyl, C₆-C₂₄Aryl, das gegebenenfalls ein- bis dreifach mit C₁-C₈Alkyl und/oder C₁-C₈Alkoxy substituiert sein kann, C₂-C₂₀Heteroaryl, das gegebenenfalls ein- bis dreifach mit C₁-C₈Alkyl und/oder C₁-C₈Alkoxy substituiert sein kann, sind;
R⁷ und R^{7'} C₁-C₂₅Alkyl sind;
R⁸ und R^{8'} unabhängig voneinander Wasserstoff, C₆-C₁₈Aryl; C₆-C₁₈Aryl, das mit C₁-C₁₈Alkyl oder C₁-C₁₈Alkoxy substituiert ist; Cₗ-C₂₅Alkyl, insbesondere C₄-C₂₅Alkyl, das gegebenenfalls von einem oder mehreren Sauerstoff- oder Schwefelatomen unterbrochen sein kann; oder C₇-C₂₅Arylalkyl sind;
R¹¹ und R^{11'} unabhängig voneinander eine C₁-C₃₅Alkylgruppe, C₇-C₂₅Arylalkyl oder eine Phenylgruppe, die gegebenenfalls ein- bis dreifach mit C₁-C₈Alkyl und/oder C₁-C₈Alkoxy substituiert sein kann, sind, mit der Maßgabe, dass das folgende Polymer 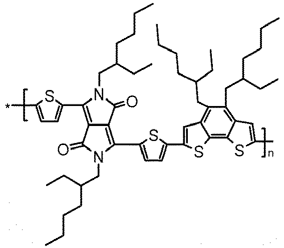 (Mₙ = 22.700; Polydispersität = 2,1) ausgeschlossen ist.

2. Polymer gemäß Anspruch 1, wobei -COM¹- eine Wiederholungseinheit der Formel 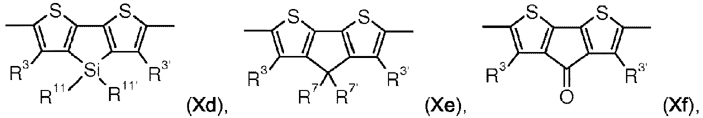 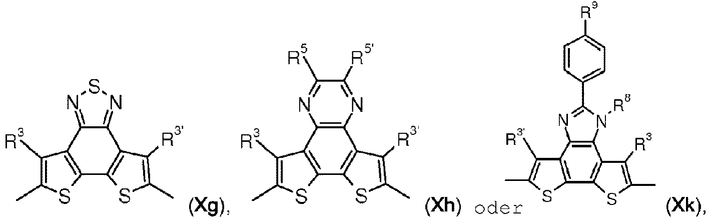 ist,
wobei R³, R^{3'}, R⁵, R^{5'}, R⁷, R^{7'}, R⁸, R¹¹ und R^{11'} wie in Anspruch 1 definiert sind und R⁹ C₁-C₂₅Alkyl, das gegebenenfalls von einem oder mehreren Sauerstoff- oder Schwefelatomen unterbrochen sein kann, C₁-C₂₅Perfluoralkyl, C₁-C₂₅Alkoxy oder CN ist.

3. Polymer gemäß Anspruch 1, wobei -COM¹- eine Wiederholungseinheit der Formel 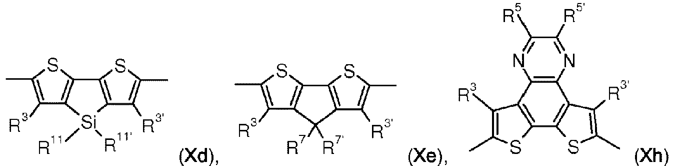 oder 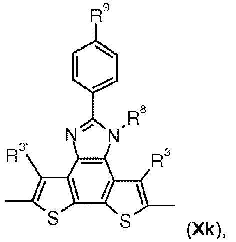 ist,
wobei R³, R^{3'}, R⁵, R^{5'}, R⁷, R^{7'}, R⁸, R¹¹ und R^{11'} wie in Anspruch 1 definiert sind und R⁹ C₁-C₂₅Alkyl, das gegebenenfalls von einem oder mehreren Sauerstoff- oder Schwefelatomen unterbrochen sein kann, C₁-C₂₅Perfluoralkyl, C₁-C₂₅Alkoxy oder CN ist.

4. Polymer gemäß einem der Ansprüche 1 bis 3, wobei A eine Gruppe der Formel 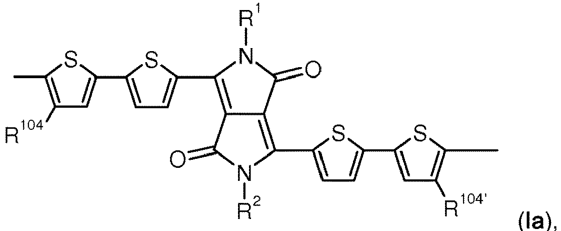 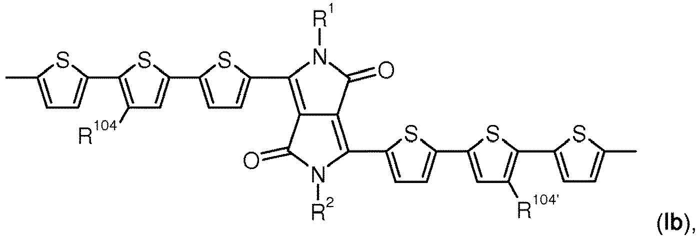 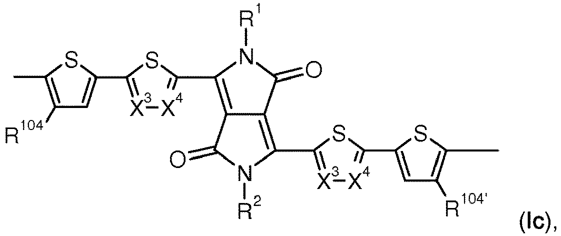 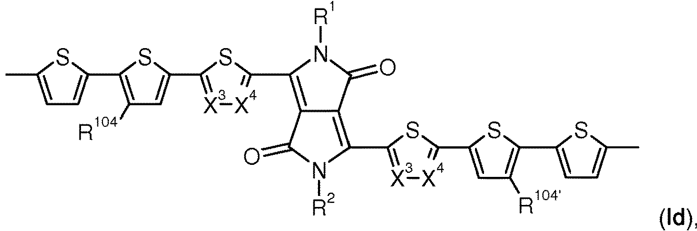 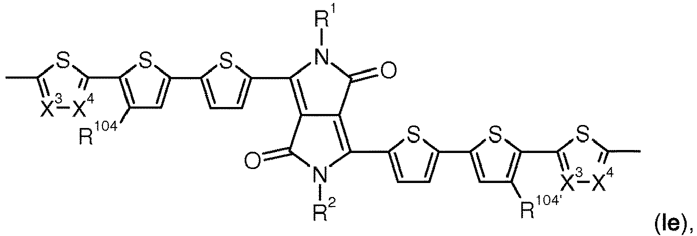 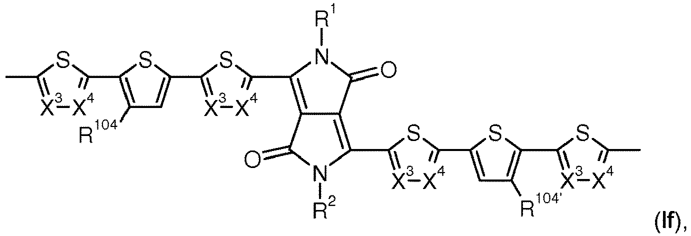 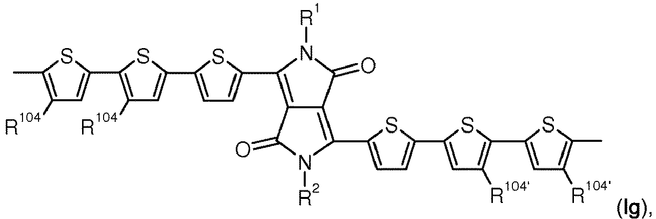 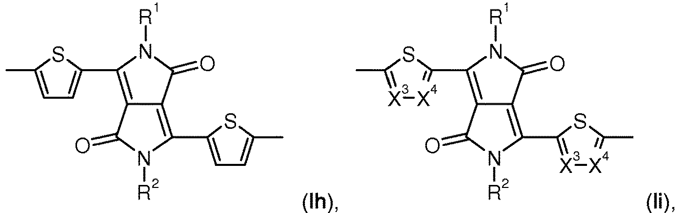 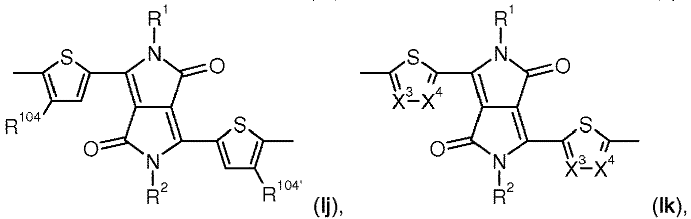 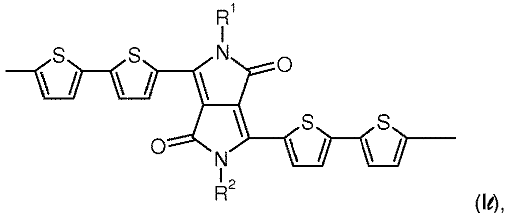 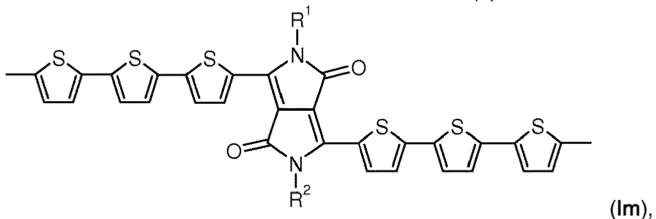 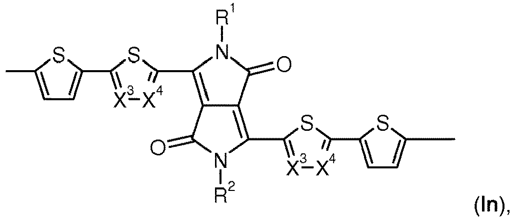 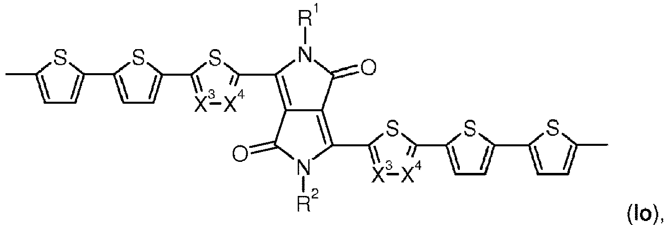 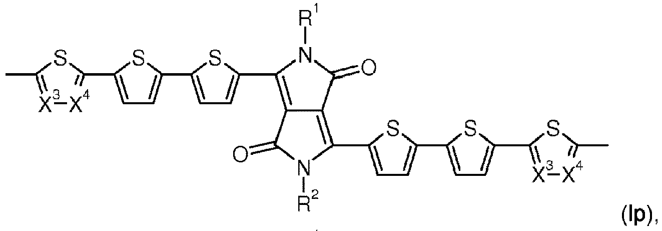 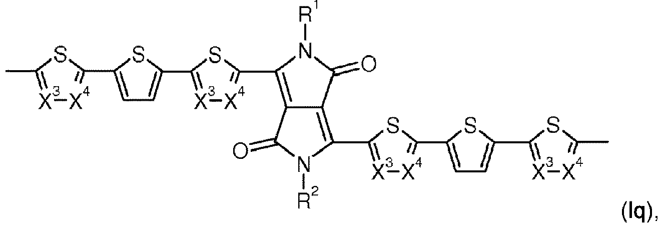 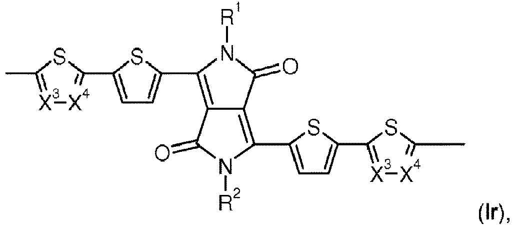 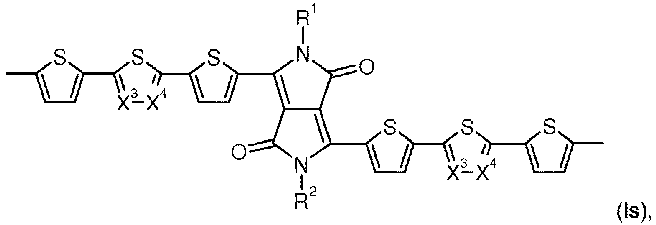 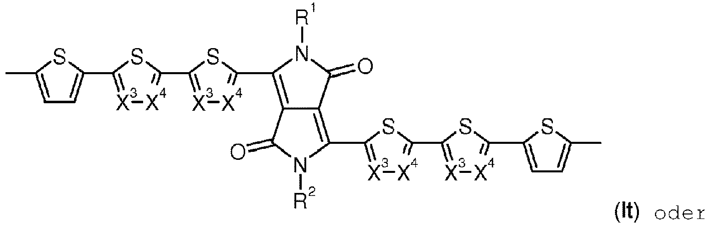 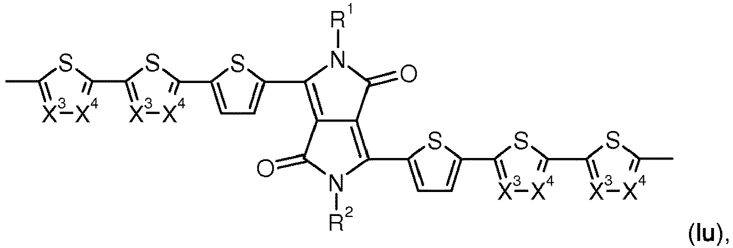 ist,
wobei R¹⁰⁴ und R^{104'} unabhängig voneinander Wasserstoff oder eine C₁-C₂₅Alkylgruppe, insbesondere ein C₄-C₂₅Alkyl, das gegebenenfalls von einem oder mehreren Sauerstoff- oder Schwefelatomen unterbrochen sein kann, C₇-C₂₅Arylalkyl oder eine C₁-C₂₅Alkoxygruppe sind.

5. Polymer gemäß einem der Ansprüche 1 bis 4, wobei R¹ und R² unabhängig voneinander für C₁-C₁₀₀Alkyl, C₅-C₁₂Cycloalkyl, das ein- bis dreifach mit C₁-C₈Alkyl und/oder C₁-C₈Alkoxy substituiert sein kann, Phenyl oder 1- oder 2-Naphthyl, das ein- bis dreifach mit C₁-C₈Alkyl und/oder C₁-C₈Alkoxy substituiert sein kann, oder -CR¹⁰¹R¹⁰²-(CH₂)ᵤ-A³ steht, wobei R¹⁰¹ und R¹⁰² für Wasserstoff oder C₁-C₄Alkyl stehen, A³ für Phenyl oder 1- oder 2-Naphthyl, das ein- bis dreifach mit C₁-C₈Alkyl und/oder C₁-C₈Alkoxy substituiert sein kann, steht und u für 0, 1, 2 oder 3 steht.

6. Polymer nach einem der Ansprüche 1 bis 5, bei dem es sich um ein Copolymer der Formel *-[-A-]-* und 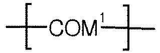 (IV) oder *-[-A-]-*, 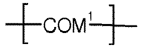 und -[-COM²-]- handelt, wobei
A eine Gruppe der Formel **Ia** bis **Iu** gemäß Anspruch 4 ist,
COM¹ eine Gruppe der Formel **Xa** bis **Xm** gemäß Anspruch 2 oder eine Gruppe der Formel **XIa** bis **XIm** gemäß Anspruch 3 ist,
COM²- eine zweite Wiederholungseinheit -COM¹- ist, die von der ersten Wiederholungseinheit -COM¹-verschieden ist.

7. Polymer gemäß Anspruch 6, bei dem es sich um ein Polymer der Formel 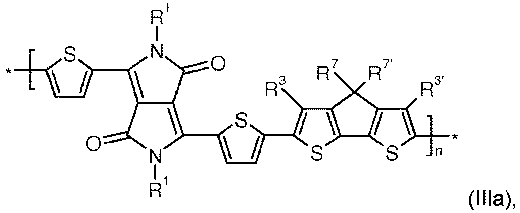 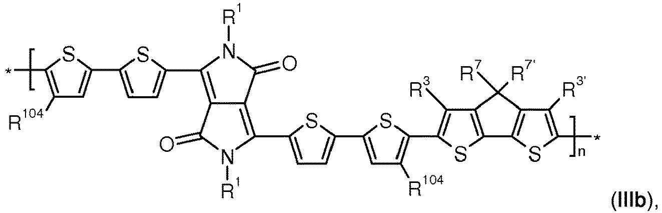 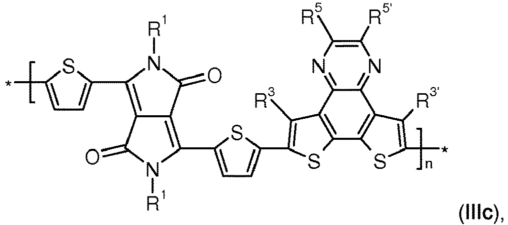 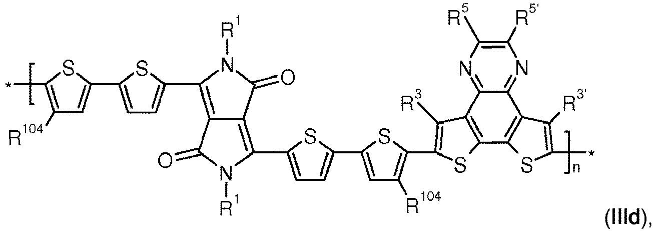 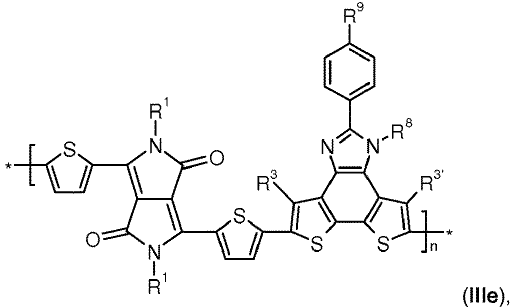 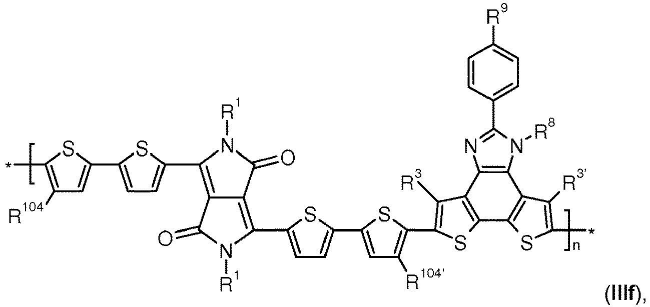 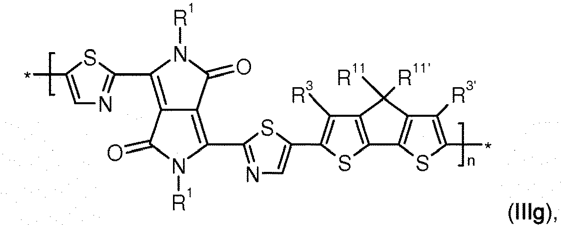 or 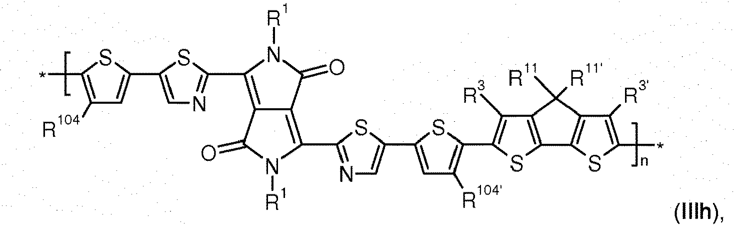 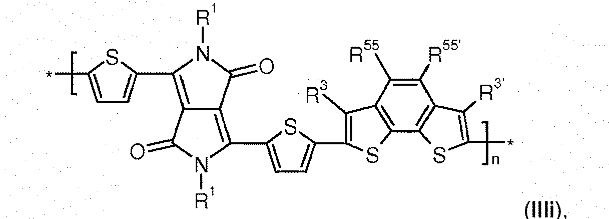 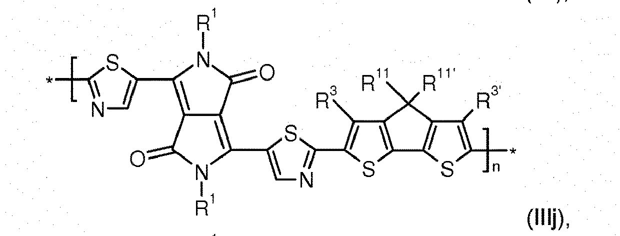 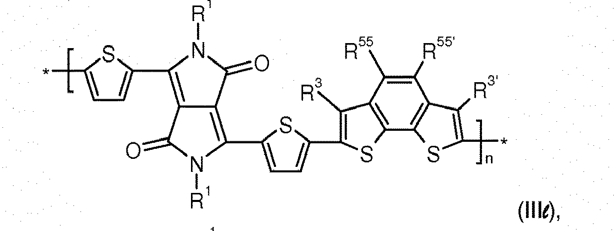 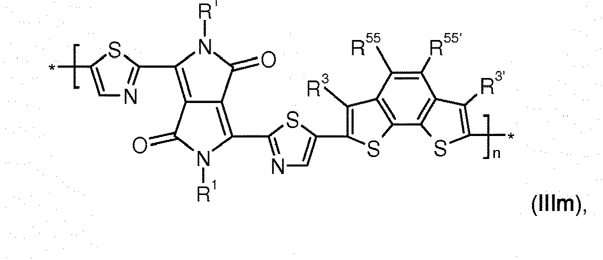 oder 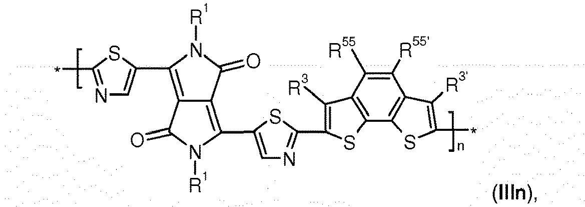 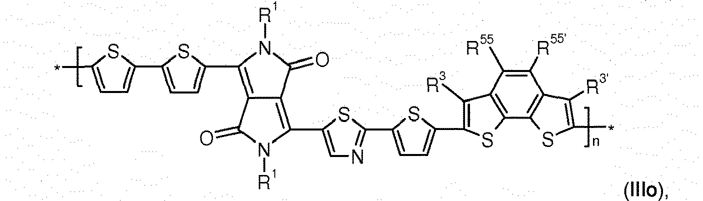 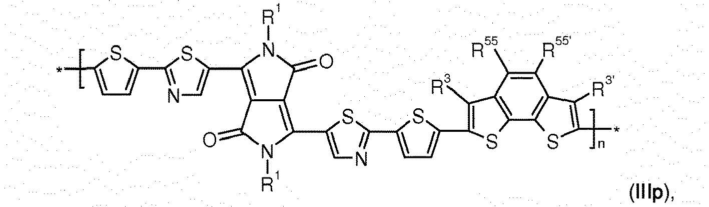 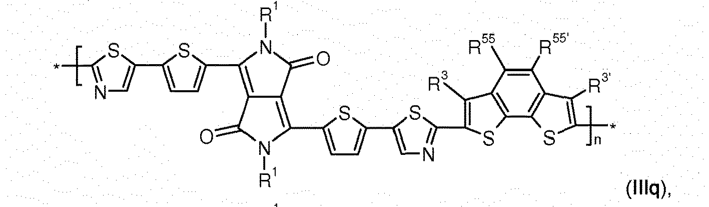 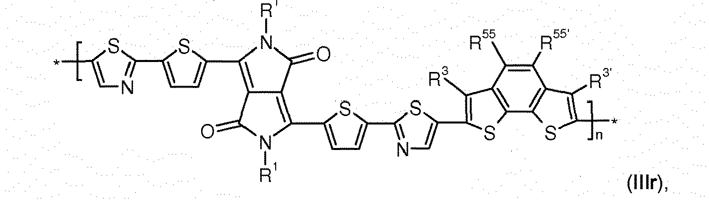 handelt,
wobei v 0,995 bis 0,005 ist, w 0,005 bis 0,995 ist,
n 4 bis 1000, insbesondere 4 bis 200, ganz besonders 5 bis 100, ist,
m 4 bis 1000, insbesondere 4 bis 200, ganz besonders 5 bis 100, ist,
R¹ eine C₁-C₃₅Alkylgruppe, insbesondere eine C₈-C₃₅Alkylgruppe, ist,
R³ und R^{3'} H oder eine C₁-C₂₅Alkylgruppe sind,
R⁵ und R^{5'} eine C₁-C₂₅Alkylgruppe oder eine C₁-C₂₅Alkoxygruppe sind,
R⁵⁵ und R^{55'} H sind,
R⁵⁶ und R^{56'} H, eine C₁-C₂₅Alkylgruppe oder eine C₁-C₂₅Alkoxygruppe sind,
R⁷, R^{7'}, R¹¹ und R^{11'} eine C₁-C₃₅Alkylgruppe sind,
R⁸ eine C₁-C₂₅Alkylgruppe ^{ist,}
R⁹ eine C₁-C₂₅Alkylgruppe oder eine C₁-C₂₅Alkoxygruppe ist,
R¹⁰⁴ H oder eine C₁-C₂₅Alkylgruppe ist,
R¹⁰⁴ H oder eine C₁-C₂₅Alkylgruppe ist,
R^{104'} H oder eine C₁-C₂₅Alkylgruppe ist,
R¹¹⁰ eine C₁-C₂₅Alkylgruppe ist und
R¹⁰⁸ und R¹⁰⁶ H sind; oder R¹⁰⁸ CN ist und R¹⁰⁶ H ist; oder R¹⁰⁶ CN ist und R¹⁰⁸ H ist.

8. Organische(s) Halbleitermaterial, Schicht oder Komponente, umfassend ein Polymer gemäß einem der Ansprüche 1 bis 7.

9. Halbleitervorrichtung, umfassend ein Polymer gemäß einem der Ansprüche 1 bis 7, und/oder ein(e) organische(s) Halbleitermaterial, Schicht oder Komponente gemäß Anspruch 8.

10. Halbleitervorrichtung gemäß Anspruch 9, die eine organische Photovoltaikvorrichtung (PV) (Solarzelle), eine Photodiode oder ein organischer Feldeffekttransistor ist.

11. Verfahren zum Herstellen einer organischen Halbleitervorrichtung, welches Verfahren das Aufbringen einer Lösung und/oder Dispersion eines Polymers gemäß einem der Ansprüche 1 bis 7 in einem organischen Lösungsmittel auf ein geeignetes Substrat und Entfernen des Lösungsmittels umfasst.

12. Verwendung des Polymers gemäß einem der Ansprüche 1 bis 7, und/oder des/der organischen Halbleitermaterials, Schicht oder Komponente gemäß Anspruch 8 in PV-Vorrichtungen, Photodioden oder organischen Feldeffekttransistoren.

13. Verfahren zum Herstellen eines Polymers der Formel 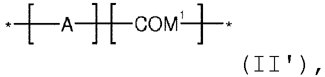 wobei A und -COM¹- wie in Anspruch 1 definiert sind, umfassend Umsetzen eines Dihalogenids der Formel X¹⁰-A-X¹⁰ mit einer äquimolaren Menge einer Diboronsäure oder eines Diboronats gemäß der Formel 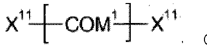 oder Umsetzen eines Dihalogenids der Formel 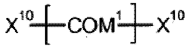 mit einer äquimolaren Menge einer Diboronsäure oder eines Diboronats gemäß der Formel X¹¹-A-X¹¹, wobei X¹⁰ Halogen ist, insbesondere Br, und X¹¹ bei jedem Auftreten unabhängig -B(OH)₂, -B(OY¹)₂, 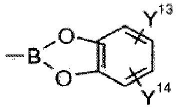 oder 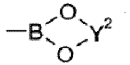 ist, wobei Y¹ bei jedem Auftreten unabhängig eine C₁-C₁₀Alkylgruppe ist und Y² bei jedem Auftreten unabhängig eine C₂-C₁₀Alkylengruppe ^{ist,} wie z. B. -CY³Y⁴-CY⁵Y⁶- oder -CY⁷Y⁸-CY⁹Y¹⁰-CY¹¹Y¹²-, wobei Y³, Y⁴, Y⁵, Y⁶, Y⁷, Y⁸, Y⁹, Y¹⁰, Y¹¹ und Y¹² unabhängig voneinander Wasserstoff oder eine C₁-C₁₀Alkylgruppe sind, insbesondere -C(CH₃)₂C(CH₃)₂-, -C(CH₃)₂CH₂C(CH₃)₂- oder -CH₂C(CH₃)₂CH₂-, und Y¹³ und Y¹⁴ unabhängig voneinander Wasserstoff oder eine C₁-C₁₀Alkylgruppe sind, in einem Lösungsmittel und in Gegenwart eines Katalysators; oder
Umsetzen eines Dihalogenids der Formel X¹⁰-A-X¹⁰ mit einer äquimolaren Menge einer Organozinnverbindung gemäß der Formel 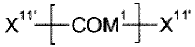 oder Umsetzen eines Dihalogenids der Formel 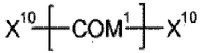 mit einer äquimolaren Menge einer Organozinnverbindung gemäß der Formel X^{11'}-A-X^{11'}, wobei X^{11'} bei jedem Auftreten unabhängig -SnR²⁰⁷R²⁰⁸R²⁰⁹ ist, wobei R²⁰⁷, R²⁰⁸ und R²⁰⁹ gleich oder verschieden sind und H oder C₁-C₆Alkyl sind oder zwei der Gruppen R²⁰⁷, R²⁰⁸ und R²⁰⁹ einen Ring bilden und diese Gruppen gegebenenfalls verzweigt sind.

## Revendications

1. Polymère, comprenant une ou plusieurs unités (répétitive(s)) de formule *-[-A-]-*, 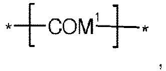 et éventuellement 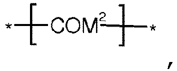 où A est une unité répétitive de formule 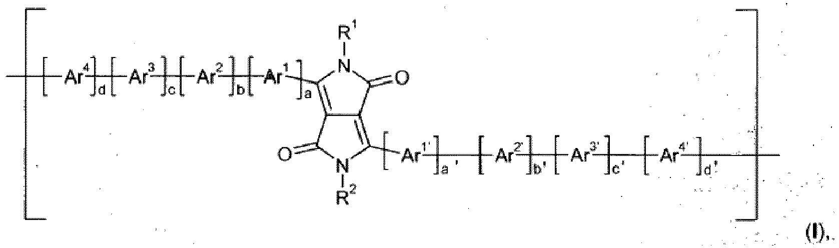 où a est 1, 2 ou 3, a' est 0, 1, 2 ou 3 ; b est 0, 1, 2 ou 3 ; b' est 0, 1, 2, ou 3 ; c est 0, 1, 2 ou 3 ; c' est 0, 1, 2 ou 3 ; d est 0, 1, 2 ou 3 ; d' est 0, 1, 2 ou 3 ; à condition que b' ne soit pas 0 si a' est 0 ;
R¹ et R² peuvent être identiques ou différents et sont choisis parmi l'hydrogène, un groupe C₁₋₁₀₀-alkyle, - COOR¹⁰³, un groupe C₁₋₁₀₀-alkyle substitué par un ou plusieurs atomes d'halogène, des groupes hydroxyle, nitro, -CN ou C₆₋₁₈ aryle, et/ou interrompu par -O-, - COO-, -OCO- ou -S-; un groupe C₇₋₁₀₀-arylalkyle, un groupe carbamoyle, C₅₋₁₂-cycloalkyle, qui peut être substitué une à trois fois par un groupe C₁₋₈-alkyle et/ou C₁₋₈-alcoxy, un groupe C₆₋₂₄-aryle, en particulier phényle ou 1- ou 2-naphtyle qui peut être substitué une à trois fois par C₁₋₈-alkyle, C₁₋₈-thioalcoxy et/ou C₁₋₈-alcoxy, ou pentafluorophényle,
R¹⁰³ est C₁₋₅₀-alkyle, en particulier C₄₋₂₅-alkyle;
Ar¹ et Ar^{1'} sont, indépendamment l'un de l'autre, 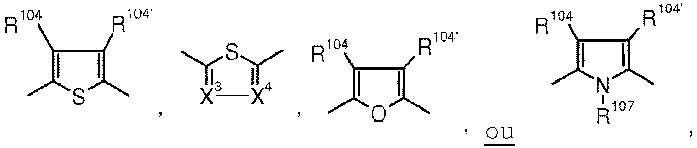 Ar², Ar^{2'}, Ar³, Ar^{3'}, Ar⁴ et Ar^{4'} désignent Ar¹, ou sont, indépendamment les uns des autres, 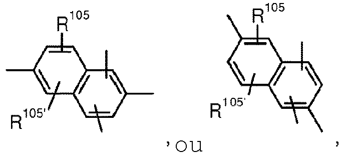 où un parmi X³ et X⁴ est N et l'autre est CR⁹⁹,
R⁹⁹, R¹⁰⁴ et R^{104'} sont, indépendamment les uns des autres, hydrogène, halogène, en particulier F, ou un groupe C₁₋₂₅-alkyle, en particulier C₄₋₂₅-alkyle, qui peut être facultativement interrompu par un ou plusieurs atomes d'oxygène ou de soufre, C₇₋₂₅-arylalkyle, ou un groupe C₁₋₂₅-alcoxy,
R¹⁰⁵ et R^{105'}, indépendamment l'un de l'autre, hydrogène, halogène, C₁₋₂₅-alkyle, qui peut être facultativement interrompu par un ou plusieurs atomes d'oxygène ou de soufre, C₇₋₂₅-arylalkyle ou C₁₋₁₈-alcoxy,
R¹⁰⁷ est H, C₆₋₁₈-aryle; C₆₋₁₈-aryle substitué par C₁₋₁₈-alkyle, ou C₁₋₁₈-alcoxy; C₁₋₁₈-alkyle; ou C₁₋₁₈-alkyle interrompu par -O- ; et -COM¹- est une unité répétitive de formule 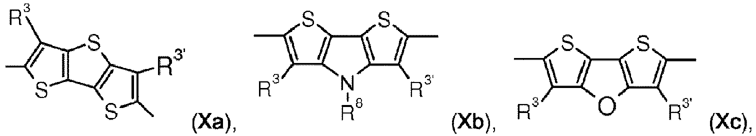 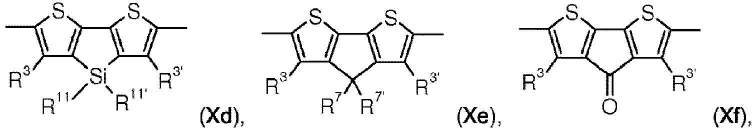 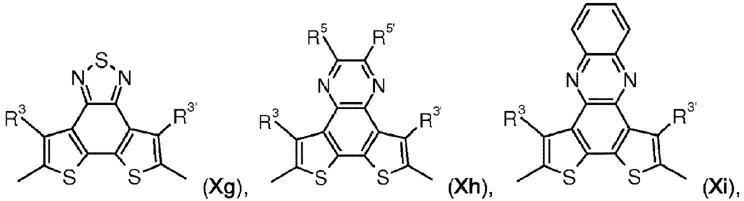 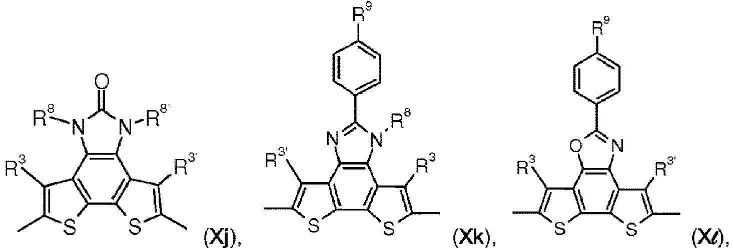 ou 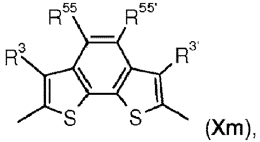 R⁹ est C₁₋₂₅-alkyle, qui peut être facultativement interrompu par un ou plusieurs atomes d'oxygène ou de soufre, C₁₋₂₅-perfluoroalkyle, C₁₋₂₅-alcoxy ou CN ;
-COM²- est une seconde unité répétitive -COM¹-différente de la première unité répétitive -COM¹-, une seconde unité répétitive -A- différente de la première unité répétitive -A-, ou une unité répétitive de formule 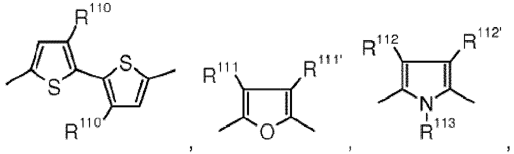 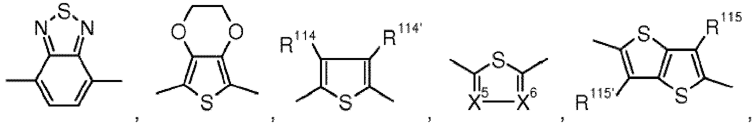 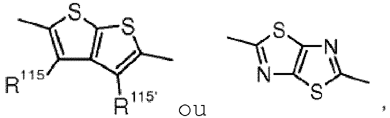 où un parmi X⁵ et X⁶ est N et l'autre est CR¹¹⁴,
R¹¹⁰ est un groupe C₁₋₂₅-alkyle, en particulier C₄₋₂₅-alkyle, qui peut être facultativement interrompu par un ou plusieurs atomes d'oxygène ou de soufre, C₇₋₂₅-arylalkyle, ou un groupe C₁₋₂₅-alcoxy,
R¹¹¹, R^{111'}, R¹¹² et R^{112'} sont, indépendamment les uns des autres, hydrogène, halogène, en particulier F ou un groupe C₁₋₂₅-alkyle, en particulier C₄₋₂₅-alkyle qui peut être interrompu par un ou plusieurs atomes de soufre, C₇₋₂₅-arylalkyle ou un groupe C₁₋₂₅-alcoxy,
R¹¹³ est C₆₋₁₈-aryle, C₆₋₁₈-aryle substitué par C₁₋₁₈-alkyle ou C₁₋₁₈-alcoxy ; C₁₋₁₈-alkyle ou C₁₋₁₈-alkyle interrompu par -O- ;
R¹¹⁴, R^{114'}, R¹¹⁵ et R^{115'} sont, indépendamment les uns des autres, H ou un groupe C₁₋₂₅-alkyle, en particulier C₆₋₂₅-alkyle, qui peut être facultativement interrompu par un ou plusieurs atomes d'oxygène ;
R³ et R^{3'} sont, indépendamment l'un de l'autre, hydrogène, halogène, C₁₋₂₅-alkyle, qui peut être facultativement interrompu par un ou plusieurs atomes d'oxygène ou de soufre ; C₇₋₂₅-arylalkyle ou C₁₋₂₅-alcoxy ;
R⁵ et R^{5'} sont, indépendamment l'un de l'autre, hydrogène, halogène, C₁₋₂₅-alkyle, qui peut être facultativement interrompu par un ou plusieurs atomes d'oxygène ou de soufre ; C₆₋₂₄-aryle, qui peut être facultativement substitué une à trois fois par C₁₋₈-alkyle et/ou C₁₋₈-alkoxy ; C₇₋₂₅-arylalkyle, CN, ou C₁₋₂₅-alcoxy ; ou
R⁵ et R^{5'} forment ensemble un cycle,
R⁵⁵ et R^{55'} sont, indépendamment l'un de l'autre, H, F, C₁₋₁₈-alkyle, C₁₋₁₈-alkyle interrompu par O, C₁₋₁₈-alcoxy, C₁₋₁₈-alcoxy interrompu par O, C₁₋₁₈-perfluoroalkyle, C₆₋₂₄-aryle, qui peut être facultativement substitué une à trois fois par C₁₋₈-alkyle et/ou C₁₋₈-alcoxy, C₂₋₂₀-hétéroaryle, qui peut être facultativement substitué une à trois fois par C₁₋₈-alkyle et/ou C₁₋₈-alcoxy ;
R⁷ et R^{7'} sont C₁₋₂₅-alkyle,
R⁸ et R^{8'} sont, indépendamment l'un de l'autre, hydrogène, C₆₋₁₈-aryle ; C₆₋₁₈-aryle substitué par C₁₋₁₈-alkyle ou C₁₋₁₈-alcoxy ; C₁₋₂₅-alkyle, en particulier C₄₋₂₅-alkyle, qui peut être facultativement interrompu par un ou plusieurs atomes d'oxygène ou de soufre ; ou C₇₋₂₅-arylalkyle,
R¹¹ et R^{11'} sont, indépendamment l'un de l'autre, un groupe C₁₋₃₅-alkyle, C₇₋₂₅-arylalkyle, ou un groupe phényle qui peut être facultativement substitué une à trois fois par C₁₋₈-alkyle et/ou C₁₋₈-alcoxy, à condition que le polymère suivant 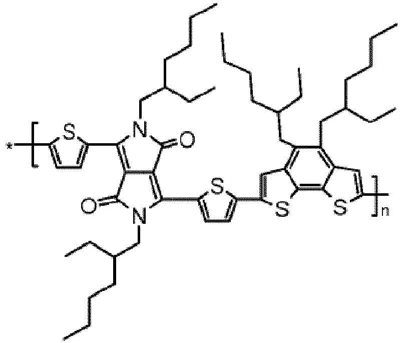 (Mₙ = 22,7 K ; polydispersité = 2,1) soit exclus.

2. Polymère selon la revendication 1, dans lequel-COM¹- est une unité répétitive de formule 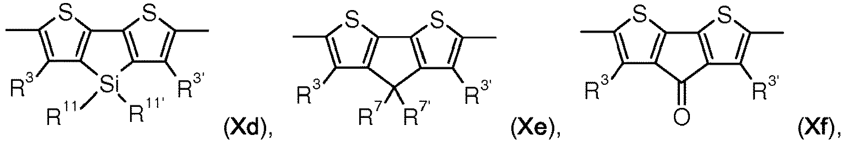 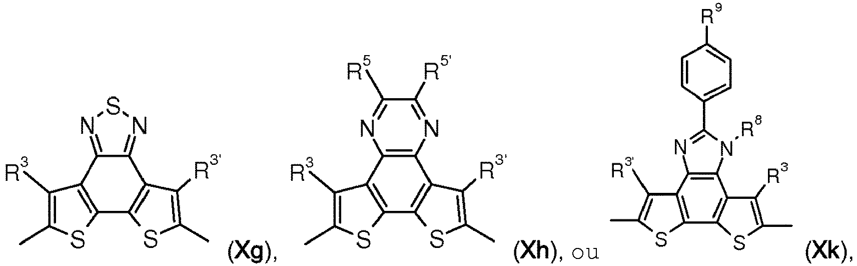 où R³, R^{3'}, R⁵, R^{5'}, R⁷, R^{7'}, R⁸, R¹¹ et R^{11'} sont comme définis dans la revendication 1 et R⁹ est C₁₋₂₅-alkyle, qui peut être facultativement interrompu par un ou plusieurs atomes d'oxygène ou de soufre, C₁₋₂₅-perfluoroalkyle, C₁₋₂₅-alcoxy ou CN.

3. Polymère selon la revendication 1, dans lequel-COM¹- est une unité répétitive de formule 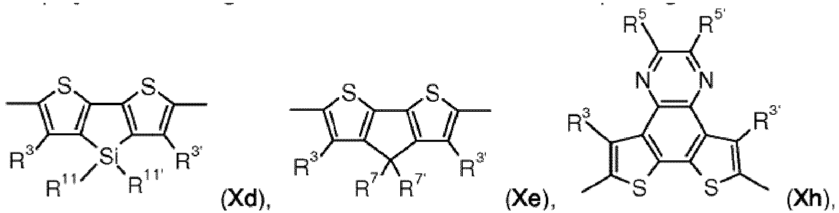 ou 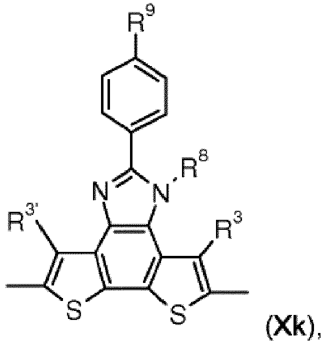 où R³, R^{3'}, R⁵, R^{5'}, R⁷, R^{7'}, R⁸, R¹¹ et R^{11'} sont comme définis dans la revendication 1 et R⁹ est C₁₋₂₅-alkyle, qui peut être facultativement interrompu par un ou plusieurs atomes d'oxygène ou de soufre, C₁₋₂₅-perfluoroalkyle, C₁₋₂₅-alcoxy ou CN.

4. Polymère selon l'une quelconque des revendications 1 à 3, dans lequel A est un groupe de formule 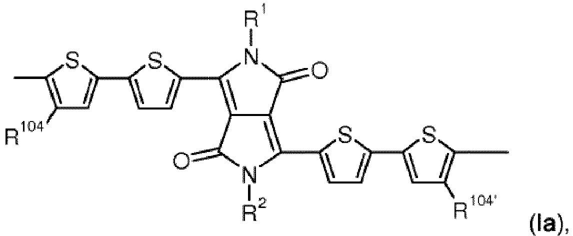 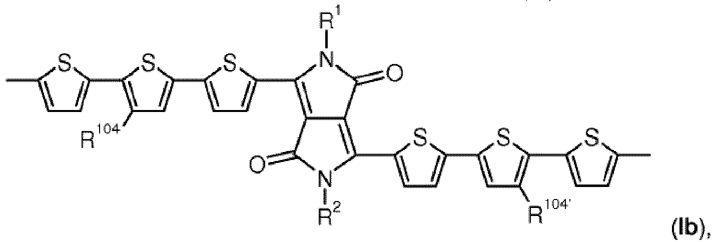 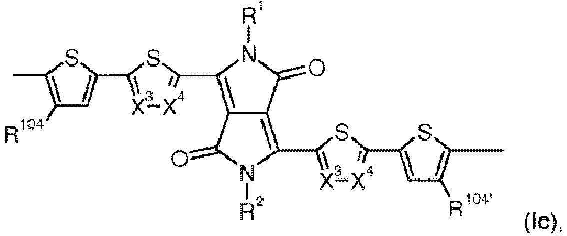 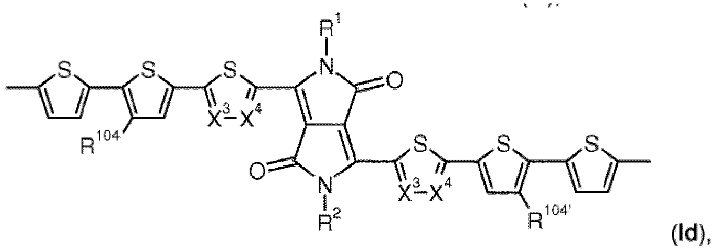 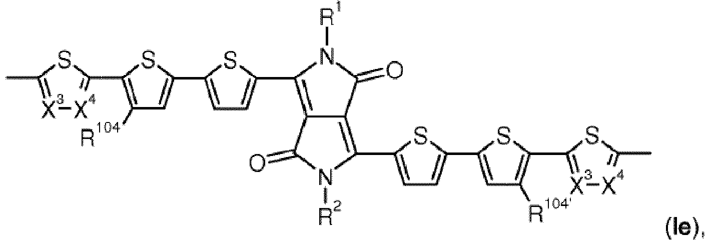 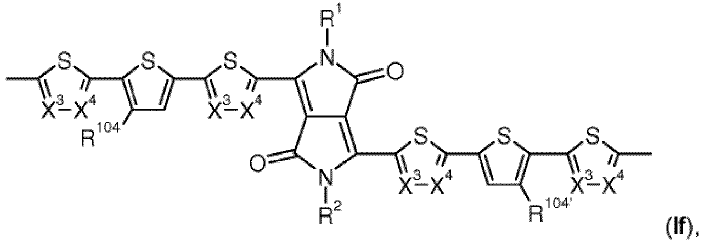 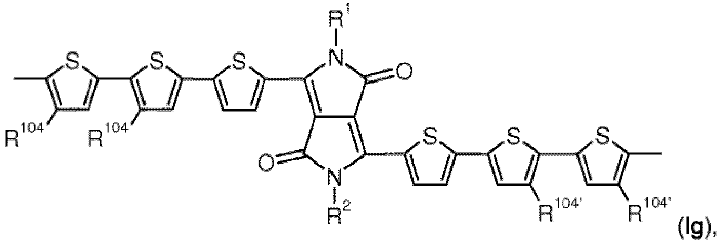 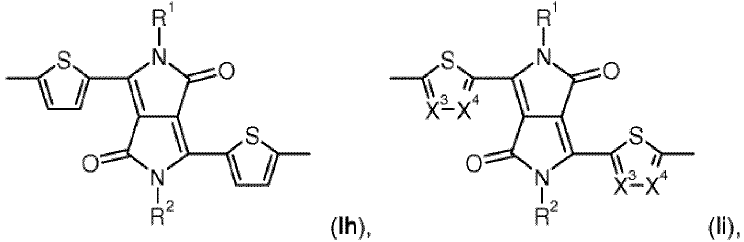 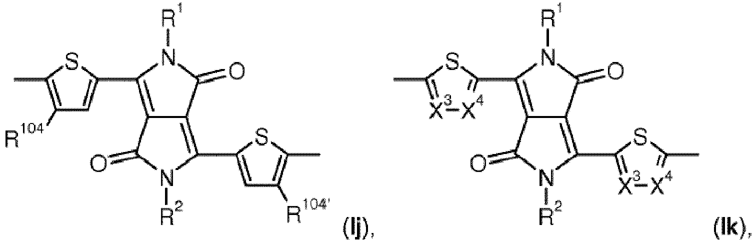 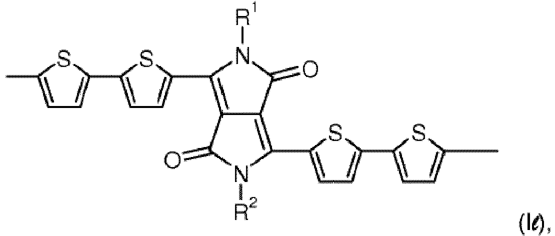 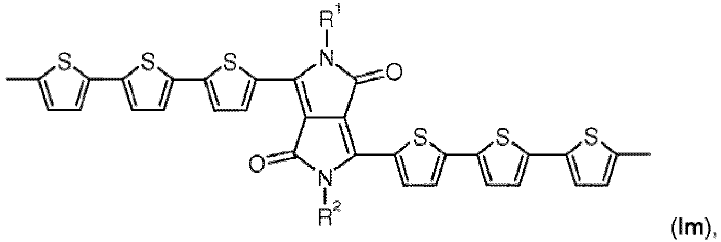 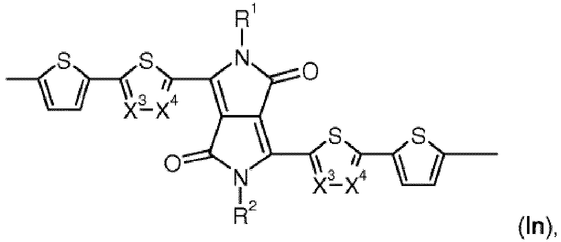 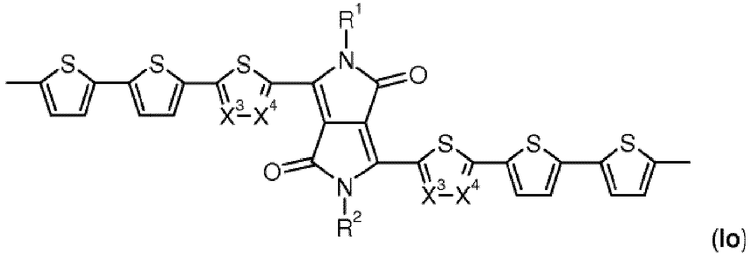 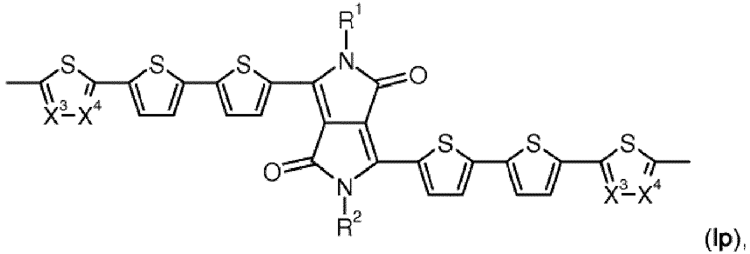 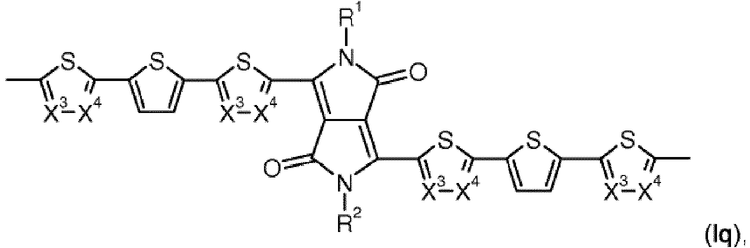 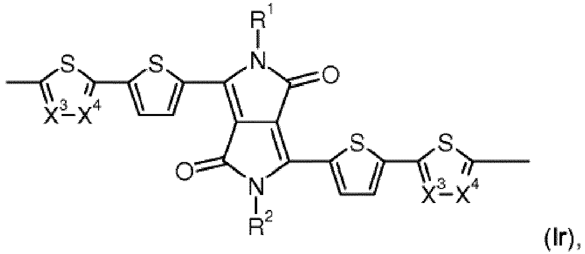 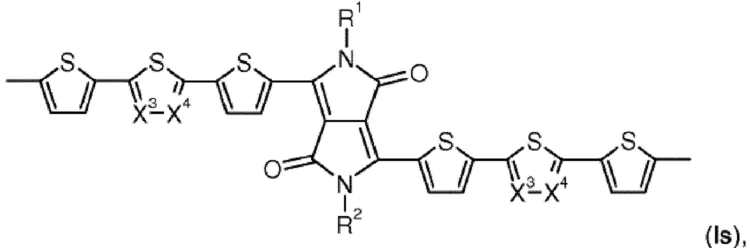 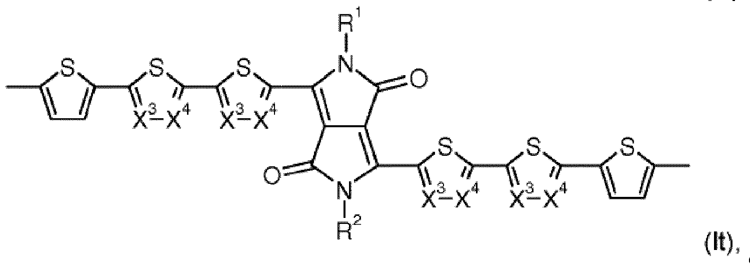 ou 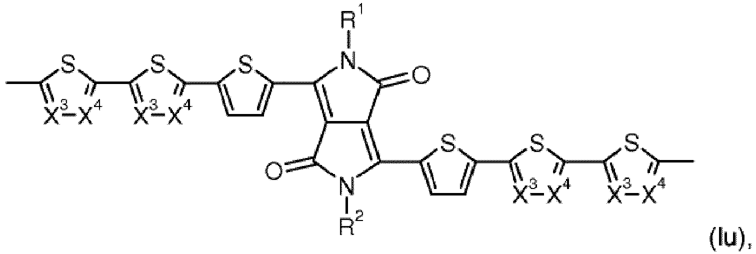 où X³, X⁴, R¹ et R² sont comme définis dans la revendication 1, et
R¹⁰⁴ et R^{104'} sont, indépendamment l'un de l'autre, hydrogène ou un groupe C₁₋₂₅-alkyle, en particulier C₄₋₂₅-alkyle, qui peut être facultativement interrompu par un ou plusieurs atomes d'oxygène ou de soufre, C₇₋₂₅-arylalkyle, ou un groupe C₁₋₂₅-alcoxy.

5. Polymère selon l'une quelconque des revendications 1 à 4, dans lequel R¹ et R² représentent, indépendamment l' un de l'autre, un groupe C₁₋₁₀₀-alkyle, C₅₋₁₂-cycloalkyle, qui peut être substitué une à trois fois par C₁₋₈-alkyle et/ou C₁₋₈-alcoxy, phényle ou 1- ou 2-naphtyle qui peut être substitué une à trois fois par C₁₋₈-alkyle et/ou C₁₋₈-alcoxy, ou -CR¹⁰¹R¹⁰²-(CH₂)ᵤ-A³, où R¹⁰¹ et R¹⁰² représentent hydrogène ou C₁₋₄-alkyle, A³ représente phényle ou 1- ou 2-naphtyle qui peut être substitué une à trois fois par C₁₋₈-alkyle et/ou C₁₋₈-alcoxy, et u représente 0, 1, 2 ou 3.

6. Polymère selon la revendication 1 à 5, qui est un copolymère de formule *⁅A-⁆* et 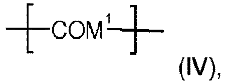 ou *⁅A⁆*, 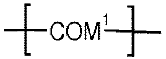 et 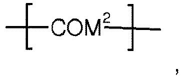 où
A est un groupe de formule Ia à Iu comme défini dans la revendication 4,
COM¹ est un groupe de formule Xa à Xm comme défini dans la revendication 2 ou un groupe de formule XIa à XIm comme défini dans la revendication 3,
COM²- est une seconde unité répétitive -COM¹- différente de la première unité répétitive -COM¹-.

7. Polymère selon la revendication 6, qui est un polymère de formule 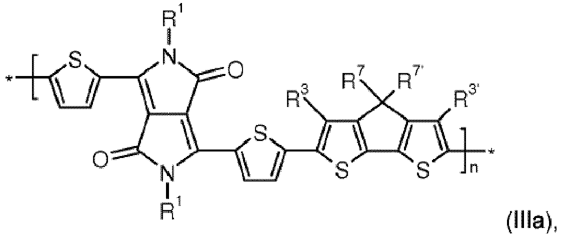 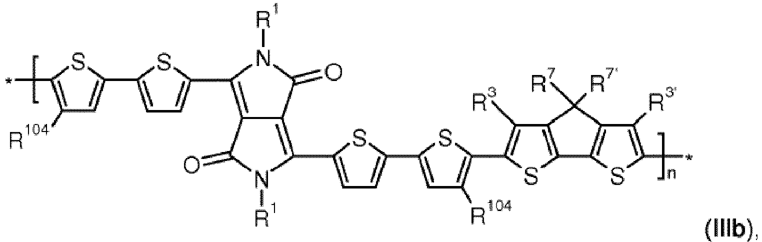 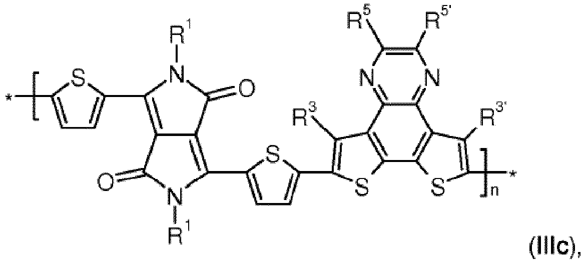 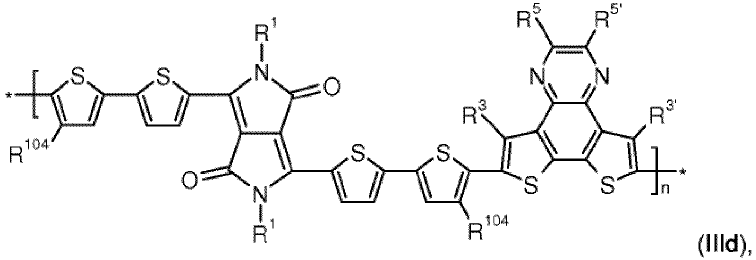 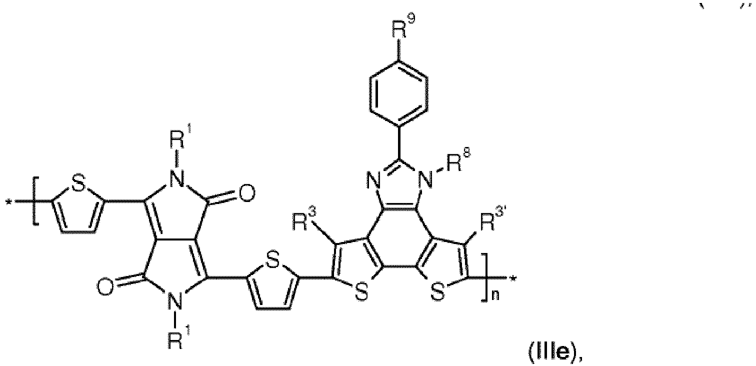 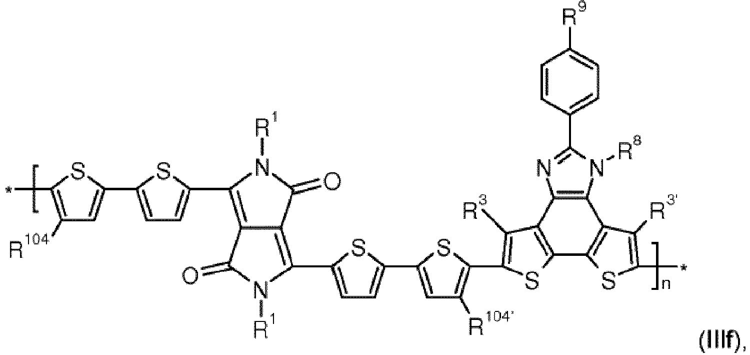 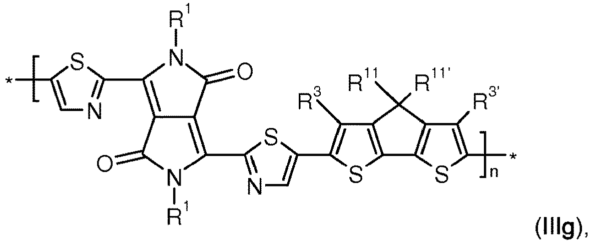 ou 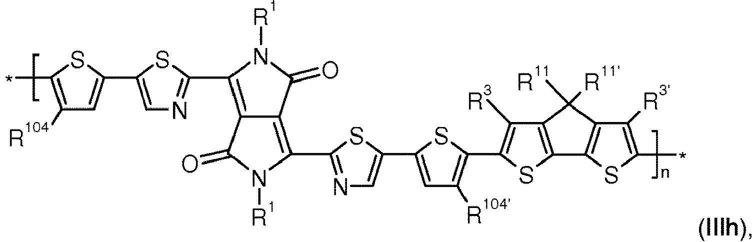 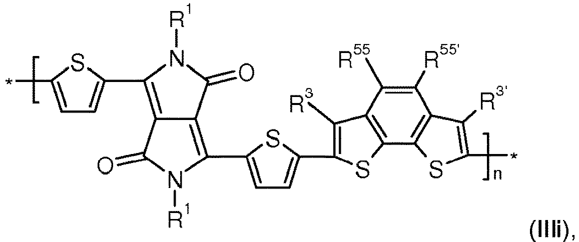 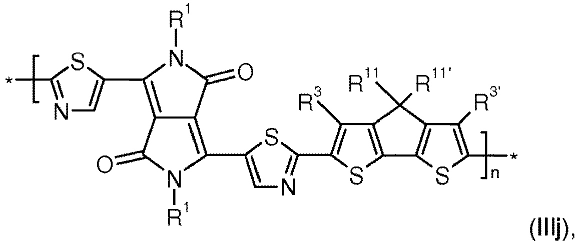 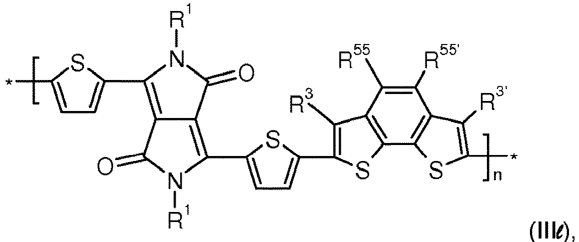 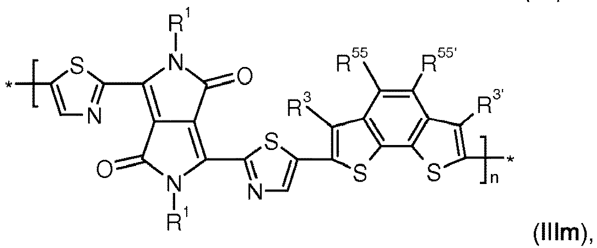 ou 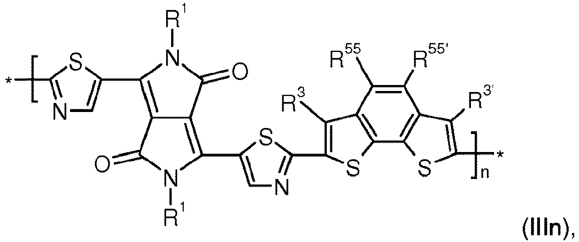 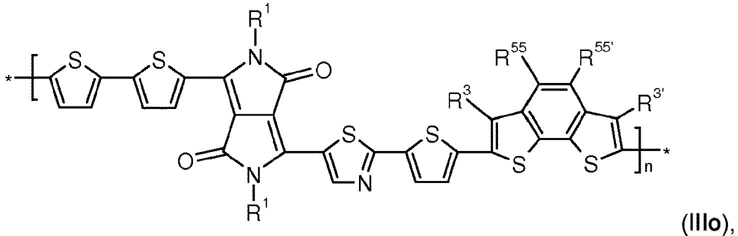 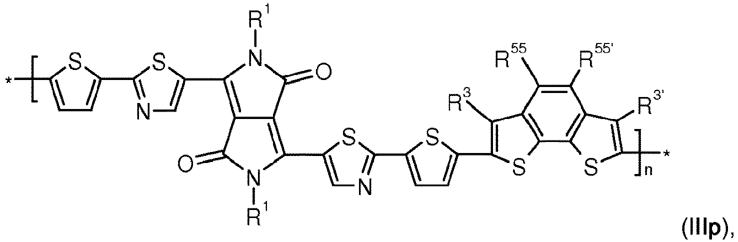 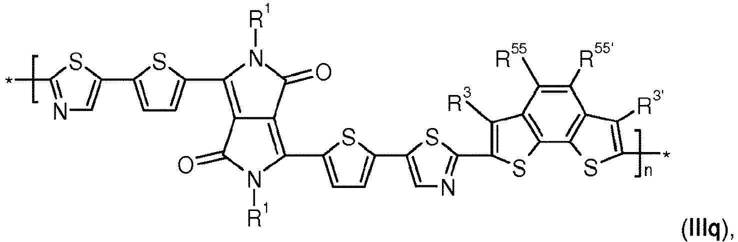 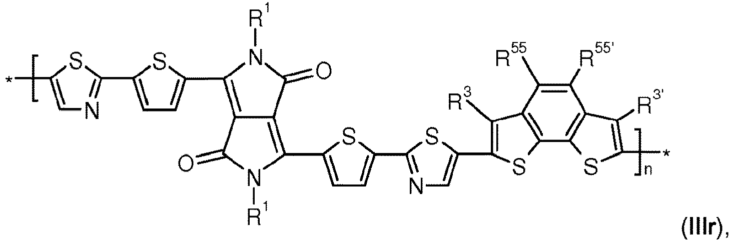 où v se situe entre 0,995 et 0,005, w se situe entre 0,005 et 0,995,
n se situe entre 4 et 1000, en particulier entre 4 et 200, tout particulièrement entre 5 et 100,
m se situe entre 4 et 1000, en particulier entre 4 et 200, tout particulièrement entre 5 et 100,
R¹ est un groupe C₁₋₃₅-alkyle, en particulier un groupe C₈₋₃₅-alkyle,
R³ et R^{3'} sont H ou un groupe C₁₋₂₅-alkyle,
R⁵ et R^{5'} sont un groupe C₁₋₂₅-alkyle ou un groupe C₁₋₂₅-alcoxy,
R⁵⁵ et R^{55'} sont H,
R⁵⁶ et R^{56'} sont H, un groupe C₁₋₂₅-alkyle ou un groupe C₁₋₂₅-alcoxy,
R⁷, R^{7'}, R¹¹ et R^{11'} sont un groupe C₁₋₃₅-alkyle,
R⁸ est un groupe C₁₋₂₅-alkyle,
R⁹ est un groupe C₁₋₂₅-alkyle ou un groupe C₁₋₂₅-alcoxy, R¹⁰⁴ est H ou un groupe C₁₋₂₅-alkyle,
R¹⁰⁴ est H ou un groupe C₁₋₂₅-alkyle
R^{104'} est H ou un groupe C₁₋₂₅-alkyle,
R¹¹⁰ est un groupe C₁₋₂₅-alkyle, et
R¹⁰⁸ et R¹⁰⁶ sont H ; ou R¹⁰⁸ est CN et R¹⁰⁶ est H ; ou R¹⁰⁶ est CN et R¹⁰⁸ est H.

8. Matériau, couche ou composant organique semiconducteur/semiconductrice comprenant un polymère selon l'une quelconque des revendications 1 à 7.

9. Dispositif semiconducteur contenant un polymère selon l'une quelconque des revendications 1 à 7, et/ou un(e) matériau, couche ou composant organique semiconducteur/semiconductrice selon la revendication 8.

10. Dispositif semiconducteur selon la revendication 9, qui est un dispositif organique photovoltaïque (PV) (cellule solaire), une photodiode ou un transistor organique à effet de champ.

11. Procédé de préparation d'un dispositif semiconducteur organique, lequel procédé comprenant l'application d'une solution et/ou dispersion d'un polymère selon l'une quelconque des revendications 1 à 7 dans un solvant organique sur un substrat adéquat, et l'élimination du solvant.

12. Utilisation du polymère selon l'une quelconque des revendications 1 à 7, et/ou du matériau, de la couche ou du composant organique semiconducteur/semiconductrice selon la revendication 8 dans des dispositifs PV, photodiodes ou transistors organiques à effet de champ.

13. Procédé de préparation d'un polymère de formule 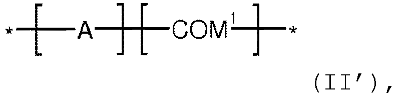 où A et -COM¹- sont comme définis dans la revendication 1, comprenant la réaction d'un dihalogénure de formule X¹⁰-A-X¹⁰ avec une quantité équimolaire d'un acide diboronique ou d'un diboronate correspondant à la formule 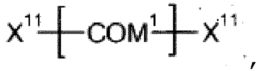 ou la réaction d'un dihalogénure de formule 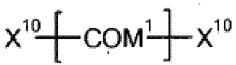 avec une quantité équimolaire d'un acide diboronique ou d'un diboronate correspondant à la formule X¹¹-A-X¹¹, où X¹⁰ est halogène, en particulier Br, et X¹¹ est indépendamment, à chaque occurrence,-B(OH)₂, -B(OY¹)₂, 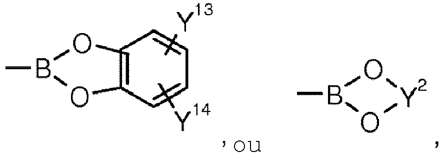 Y¹ étant indépendamment à chaque occurrence un groupe C₁₋₁₀-alkyle, et Y² étant indépendamment à chaque occurrence un groupe C₂₋₁₀₋alkylène, comme -CY³Y⁴-CY⁵Y⁶-, ou -CY⁷Y⁸-CY⁹Y¹⁰-CY¹¹Y¹²-, où Y³, Y⁴, Y⁵, Y⁶, Y⁷, Y⁸, Y⁹, Y¹⁰, Y¹¹ et Y¹² sont, indépendamment les uns des autres, hydrogène ou un groupe C₁₋₁₀-alkyle, en particulier-C(CH₃)₂C(CH₃)₂-, -C(CH₃)₂CH₂C(CH₃)₂-, ou -CH₂C(CH₃)₂CH₂-, et Y¹³ et Y¹⁴ sont, indépendamment l'un de l'autre, hydrogène ou un groupe C₁₋₁₀-alkyle, dans un solvant et en présence d'un catalyseur ; ou
la réaction d'un dihalogénure de formule X¹⁰-A-X¹⁰ avec une quantité équimolaire d'un composé organoétain correspondant à la formule 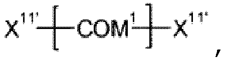 ou la réaction d'un dihalogénure de formule 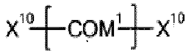 avec une quantité équimolaire d'un composé organoétain correspondant à la formule X¹¹-A-X¹¹, où X^{11'} est indépendamment à chaque occurrence -SnR²⁰⁷R²⁰⁸R²⁰⁹, où R²⁰⁷, R²⁰⁸ et R²⁰⁹ sont identiques ou différents et sont H ou C₁₋₆-alkyle, ou deux des groupes R²⁰⁷, R²⁰⁸ et R²⁰⁹ forment un cycle et ces groupes sont facultativement ramifiés.
